# EUROPEAN PATENT SPECIFICATION

(11) **EP 3 770 166 B1**
(45) Date of publication and mention of the grant of the patent: **06.10.2021**
(21) Application number: 20150303.4
(22) Date of filing: 06.01.2020
(51) Int. Cl.: C07F 15/00, H01L 51/50, H01L 51/00

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 23.07.2019 KR 20190089219
(43) Date of publication of application: 27.01.2021
(73) Proprietor: Samsung Electronics Co., Ltd., Gyeonggi-do 16677 (KR)
(72) Inventor: CHOI, Whail, 16678 Gyeonggi-do (KR); KWAK, Seungyeon, 16678 Gyeonggi-do (KR); KOO, Hyun, 16678 Gyeonggi-do (KR); CHOI, Hyeonho, 16678 Gyeonggi-do (KR); KIM, Sungjun, 16678 Gyeonggi-do (KR); HONG, Seokhwan, 16678 Gyeonggi-do (KR)
(74) Representative: Elkington and Fife LLP

(56) References cited:
- US-A1- 2005 137 400
- US-A1- 2015 325 807
- SHIH-HAN CHANG ET AL: "Emissive Osmium(II) Complexes with Tetradentate Bis(pyridylpyrazolate) Chelates", INORGANIC CHEMISTRY, vol. 52, no. 10, 20 May 2013 (2013-05-20), pages 5867-5875, XP55699148, EASTON, US ISSN: 0020-1669, DOI: 10.1021/ic302829e
- ANGULO G ET AL: "Electrochemiluminescence studies of phosphine chelated osmium(II) complexes", INORGANIC CHEMISTRY COMMUNICATIONS, ELSEVIER, AMSTERDAM, NL, vol. 12, no. 5, 1 May 2009 (2009-05-01), pages 378-381, XP026087425, ISSN: 1387-7003, DOI: 10.1016/J.INOCHE.2009.02.021 [retrieved on 2009-03-03]

## Description

### FIELD OF THE INVENTION

One or more embodiments relate to an organometallic compound and an organic light-emitting device including the same.

### BACKGROUND OF THE INTENTION

Organic light-emitting devices are self-emission devices that produce full-color images, and also have wide viewing angles, high contrast ratios, short response times, and excellent characteristics in terms of brightness, driving voltage, and response speed, compared to devices in the art.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light. US2015/325807 discloses organometallic compounds for use in an organic light-emitting device.

### SUMMARY OF THE INVENTION

One or more embodiments include a novel organometallic compound and an organic light-emitting device including the same.

Additional aspects will be set forth in part in the description which follows and, in part, will be apparent from the description, or may be learned by practice of the presented embodiments.

An aspect of the present disclosure provides an organometallic compound represented by Formula 1:

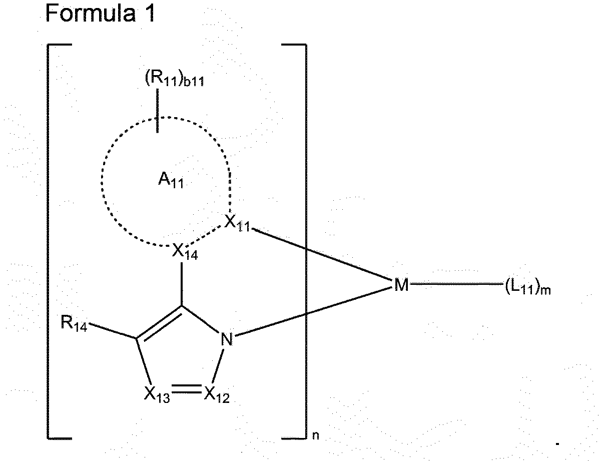

In Formula 1,
M may be a first-row transition metal, a second-row transition metal, or a third-row transition metal of the Periodic Table of Elements,
X₁₁ may be N or C, or a bond between X₁₁ and M may be a coordinate bond,
X₁₂ may be N or C(R₁₂),
X₁₃ may be N or C(R₁₃), wherein X₁₂ and X₁₃ are not N at the same time,
X₁₄ may be N or C, and a bond between X₁₁ and X₁₄ may be a single bond or a double bond,
A₁₁ may be a C₅-C₆₀ carbocyclic group or a C₁-C₆₀ heterocyclic group,
R₁₁ may be hydrogen, deuterium, -F, -Cl, -Br, -I, -SF₅, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), or -P(=S)(Q₁)(Q₂), wherein two neighboring R₁₁(s) may optionally be linked to each other to form a substituted or unsubstituted C₅-C₃₀ carbocyclic group or a substituted or unsubstituted C₁-C₃₀ heterocyclic group,
R₁₂ and R₁₃ may each independently be:
-F, -Cl, -Br, -I, a cyano group, or a nitro group; or
a C₁-C₆₀ alkyl group substituted with at least one -F, -Cl, -Br, -I, a cyano group, a nitro group, or any combination thereof,
R₁₄ may be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
b11 may be 1, 2, 3, 4, 5, 6, 7, or 8,
Q₁ to Q₃ may each independently be hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₂-C₆₀ alkylheteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one deuterium, -F, a cyano group, a C₁-C₆₀ alkyl group, a C₆-C₆₀ aryl group, or any combination thereof, or a C₆-C₆₀ aryl group substituted with at least one deuterium, -F, a cyano group, a C₁-C₆₀ alkyl group, a C₆-C₆₀ aryl group, or any combination thereof,
n may be 1, 2, or 3,
L₁₁ may be a monodentate ligand, a bidentate ligand, or a tridentate ligand, and
m may be 0, 1, 2, 3, 4, or 5.

Another aspect of the present disclosure provides an organic light-emitting device including: a first electrode; a second electrode; an organic layer between the first electrode and the second electrode and including an emission layer,
wherein the organic layer includes the organometallic compound described above.

The organometallic compound in the emission layer may act as a dopant.

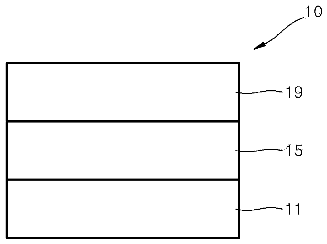

### BRIEF DESCRIPTION OF THE DRAWING

These and/or other aspects will become apparent and more readily appreciated from the following description of the embodiments, taken in conjunction with FIGURE which is a schematic cross-sectional view of an organic light-emitting device according to an embodiment; and

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that, although the terms "first," "second," "third" etc. may be used herein to describe various elements, components, regions, layers and/or sections, these elements, components, regions, layers and/or sections should not be limited by these terms These terms are only used to distinguish one element, component, region, layer or section from another element, component, region, layer or section Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures It will be understood that relative terms are intended to encompass different orientations of the device in addition to the orientation depicted in the Figures For example, if the device in one of the figures is turned over, elements described as being on the "lower" side of other elements would then be oriented on "upper" sides of the other elements The exemplary term "lower," can therefore, encompasses both an orientation of "lower" and "upper," depending on the particular orientation of the figure Similarly, if the device in one of the figures is turned over, elements described as "below" or "beneath" other elements would then be oriented "above" the other elements The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments As such, variations from the shapes of the illustrations as a result, for example, of manufacturing techniques and/or tolerances, are to be expected Thus, embodiments described herein should not be construed as limited to the particular shapes of regions as illustrated herein but are to include deviations in shapes that result, for example, from manufacturing For example, a region illustrated or described as flat may, typically, have rough and/or nonlinear features Moreover, sharp angles that are illustrated may be rounded Thus, the regions illustrated in the figures are schematic in nature and their shapes are not intended to illustrate the precise shape of a region and are not intended to limit the scope of the present claims.

An aspect of the present disclosure provides an organometallic compound represented by Formula 1 below:

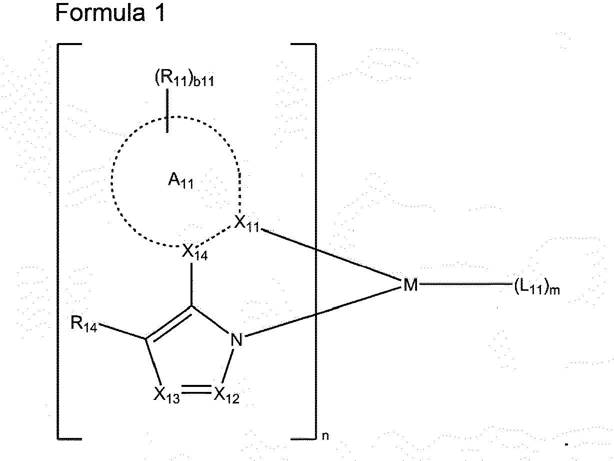

M in Formula 1 may be a first-row transition metal, a second-row transition metal, or a third-row transition metal of the Periodic Table of Elements.

In one or more embodiments, M in Formula 1 may be platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm), but embodiments of the present disclosure are not limited thereto.

In one or more embodiments, M in Formula 1 may be Pt, Pd, Cu, Ag, Au, Rh, Ir, Ru, or Os, but embodiments of the present disclosure are not limited thereto.

In one or more embodiments, M in Formula 1 may be Ru or Os, but embodiments of the present disclosure are not limited thereto.

In Formula 1, X₁₁ may be N or C, and a bond between X₁₁ and M may be a coordinate bond. Since X₁₁ provides an electron pair to M, a bond occurs between X₁₁ and M. Therefore, the organometallic compound represented by Formula 1 distinguishes from a compound in which a bond between X₁₁ and M is a covalent bond. For example, since a bond between X₁₁ and M is limited to a coordinate bond, A₁₁ is not a benzene group.

In Formula 1, X₁₂ may be N or C(R₁₂),and R₁₂ may be the same as described below.

In Formula 1, X₁₃ may be N or C(R₁₃), and R₁₃ may be the same as described below.

However, in Formula 1, a case in which X₁₂ and X₁₃ are N at the same time is excluded.

For example, in Formula 1, X₁₂ may be N, and X₁₃ may be C(R₁₃); or X₁₂ may be C(R₁₂),and X₁₃ may be N, but embodiments of the present disclosure are not limited thereto.

In one or more embodiments, in Formula 1, X₁₂ may be N, and X₁₃ may be C(R₁₃), but embodiments of the present disclosure are not limited thereto.

In Formula 1, X₁₄ may be N or C, and a bond between X₁₁ and X₁₄ may be a single bond or a double bond.

For example, In Formula 1, X₁₄ may be C, but embodiments of the present disclosure are not limited thereto.

In one or more embodiments, X₁₁ may be N, X₁₄ may be C, and a bond between X₁₁ and X₁₄ may be a single bond or a double bond, but embodiments of the present disclosure are not limited thereto.

In one or more embodiments, X₁₁ may be C, X₁₄ may be N, and a bond between X₁₁ and X₁₄ may be a single bond or a double bond, but embodiments of the present disclosure are not limited thereto.

In Formula 1, A₁₁ may be a C₅-C₆₀ carbocyclic group or a C₁-C₆₀ heterocyclic group. In one or more embodiments, A₁₁ may be a C₅-C₆₀ carbocyclic group or a C₁-C₆₀ heterocyclic group each including X₁₁ and X₁₄ as a ring source.

For example, A₁₁ in Formula 1 may be i) a 6-membered ring, ii) a condensed ring in which two 6-membered rings are condensed with each other, or iii) a condensed ring in which one 6-membered ring and one condensed 5-membered ring are condensed with each other, but embodiments of the present disclosure are not limited thereto.

The 6-membered ring may be a cyclohexane group, a cyclohexene group, a cyclohexadiene group, an admantane group, a norbornane group, a norbornene group, a benzene group, a pyridine group, a dihydropyridine group, a pyrimidine group, a pyrazine group, a pyridazine group, or a triazine group.

The 5-membered ring may be a cyclopentane group, a cyclopentene group, a cyclopentadiene group, a furan group, a thiophene group, a silole group, a pyrrole group, a pyrazole group, an imidazole group, a triazole group, a 2,3-dihydroimidazole group, a 2,3-dihydrotriazole group, an oxazole group, an isoxazole group, a thiazole group, an isothiazole group, an oxadiazole group, or a thiadiazole group.

In one or more embodiments, in Formula 1, a moiety represented by 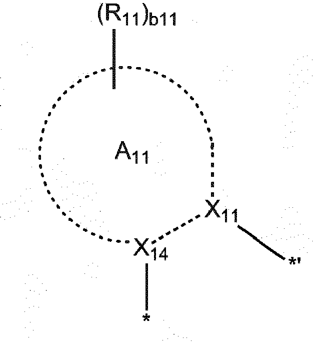 (wherein *' indicates a binding site to M, and * indicates a binding site to a carbon atom) may be represented by one of Formulae 2-1 to 2-17, but embodiments of the present disclosure are not limited thereto:

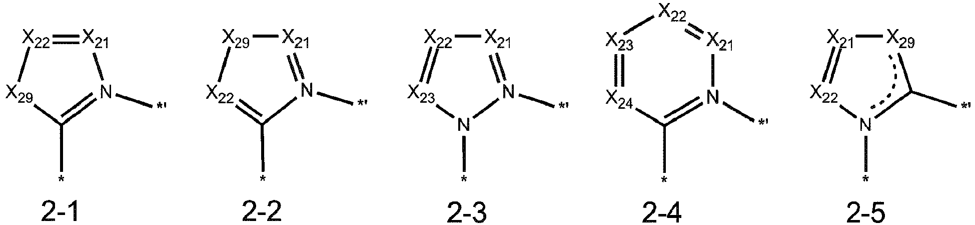

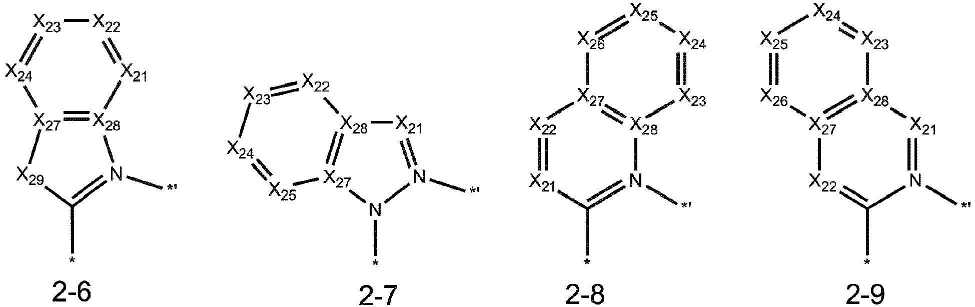

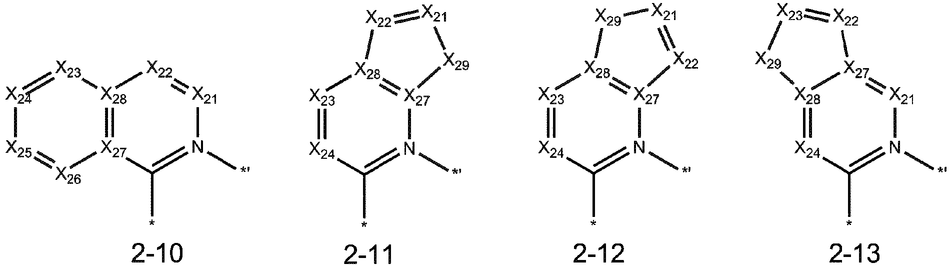

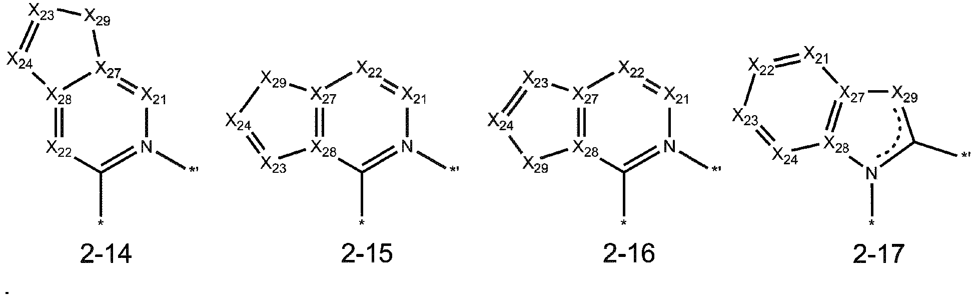

In Formulae 2-1 to 2-17,
X₂₁ may be N or C(R₂₁), X₂₂ may be N or C(R₂₂), X₂₃ may be N or C(R₂₃), X₂₄ may be N or C(R₂₄), X₂₅ may be N or C(R₂₅), and X₂₆ may be N or C(R₂₆),
X₂₇ and X₂₈ may each independently be N or C,
X₂₉ may be O, S, N(R₂₉), or C(R₂₉)(R₃₀),
R₂₁ to R₂₆, R₂₉, and R₃₀ may each independently be the same as described in connection with R₁₁,
* indicates a binding site to a carbon atom, and
*' indicates a binding site to M.

In one or more embodiments, in Formula 1, a moiety represented by 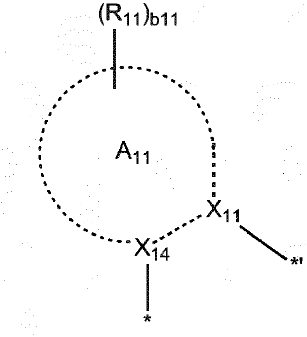 (wherein *' indicates a binding site to M, and * indicates a binding site to a carbon atom) may be represented by one of Formulae 3-1 to 3-54, but embodiments of the present disclosure are not limited thereto:

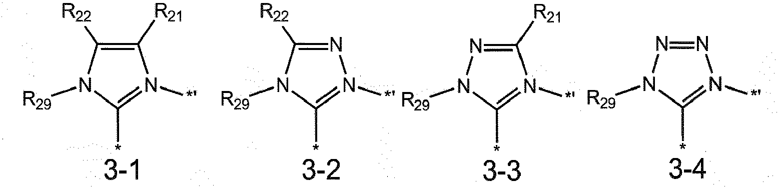

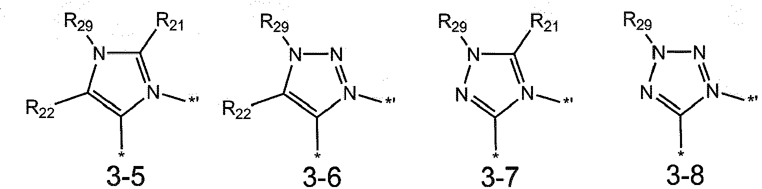

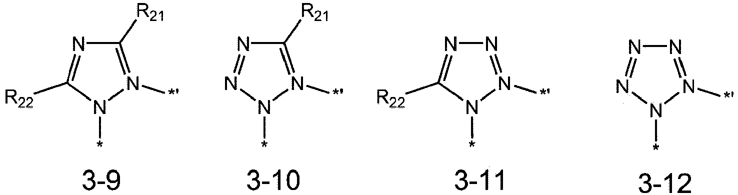

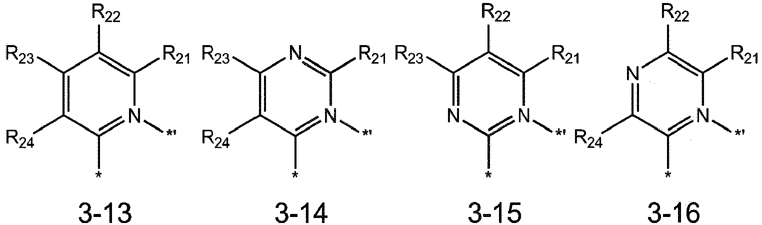

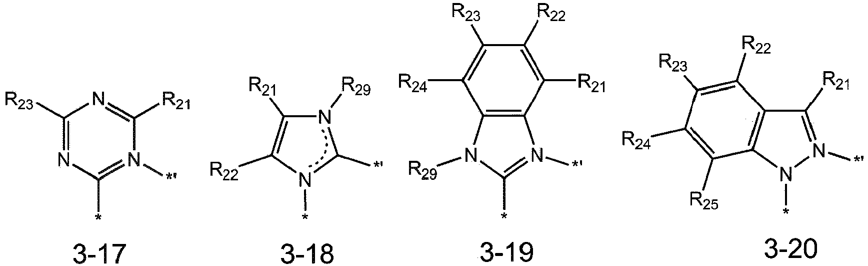

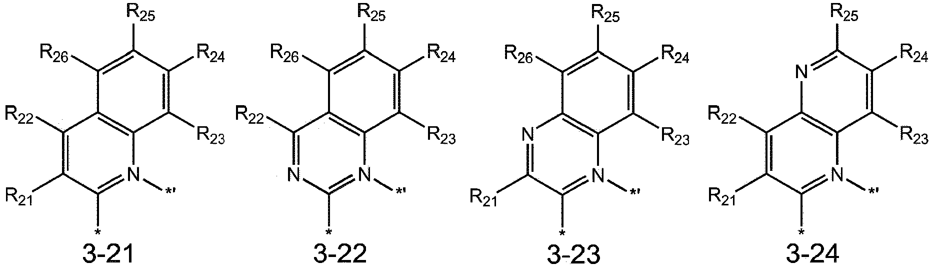

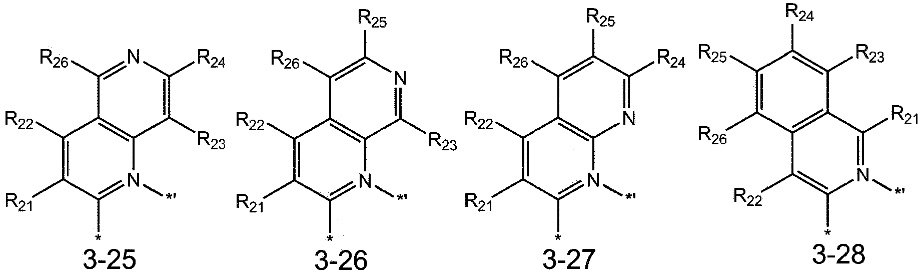

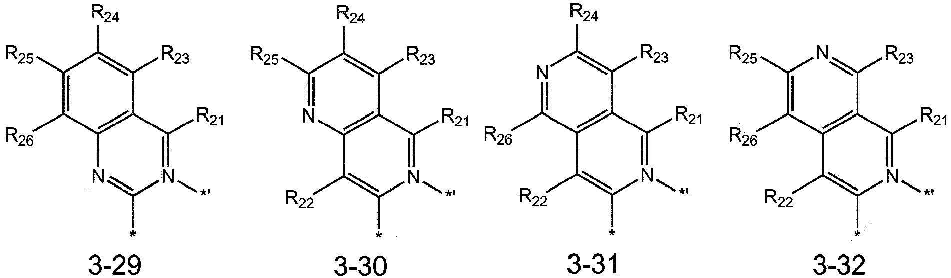

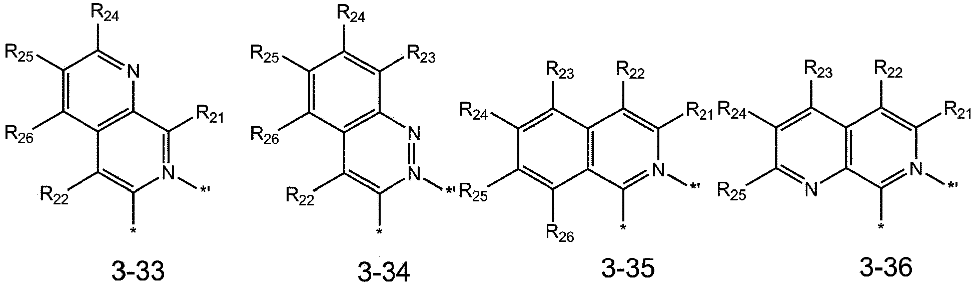

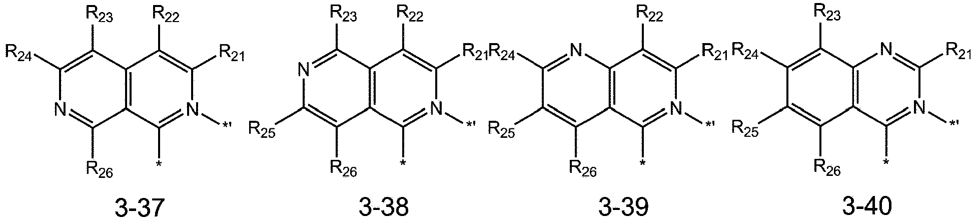

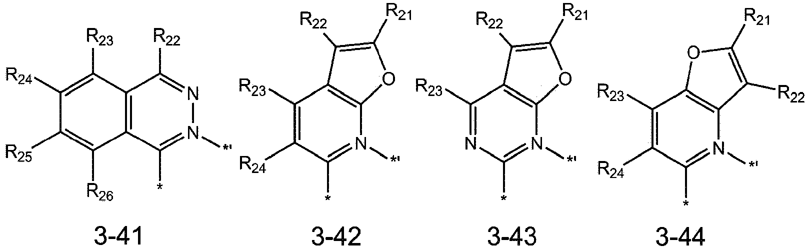

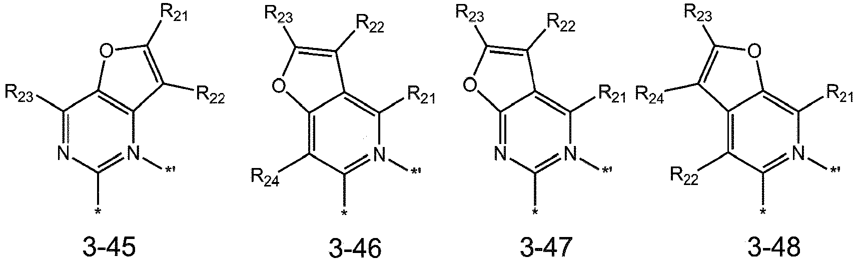

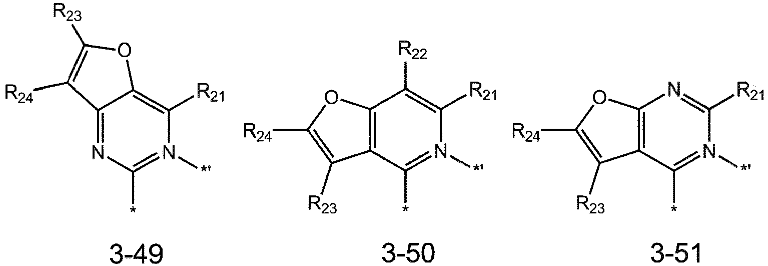

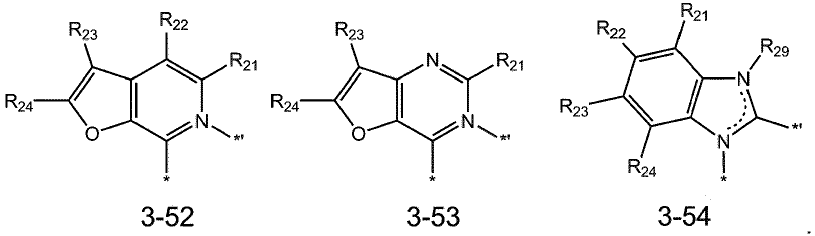

In Formulae 3-1 to 3-54,
R₂₁ to R₂₆, R₂₉, and R₃₀ may each be understood by referring to R₁₁ described below,
* indicates a binding site to a carbon atom, and
*' indicates a binding site to M.

R₁₁ in Formula 1 may be hydrogen, deuterium, -F, -Cl, -Br, -I, -SF₅, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), or -P(=S)(Q₁)(Q₂), wherein two neighboring R₁₁(s) may optionally be linked to each other to form a substituted or unsubstituted C₅-C₃₀ carbocyclic group or a substituted or unsubstituted C₁-C₃₀ heterocyclic group, and
Q₁ to Q₃ may each independently be hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₂-C₆₀ alkylheteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one deuterium, -F, a cyano group, a C₁-C₆₀ alkyl group, a C₆-C₆₀ aryl group, or any combination thereof, or a C₆-C₆₀ aryl group substituted with at least one deuterium, -F, a cyano group, a C₁-C₆₀ alkyl group, a C₆-C₆₀ aryl group, or any combination thereof.

For example, R₁₁ in Formula 1 may be:
hydrogen, deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, -SF₅, C₁-C₂₀ alkyl group, or a C₁-C₂₀ alkoxy group;
a C₁-C₂₀ alkyl group or a C₁-C₂₀ alkoxy group, each substituted with at least one deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a pyridinyl group, a pyrimidinyl group, or any combination thereof;
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with at least one deuterium, - F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, -si(Q₃₃)(Q₃₄)(Q₃₅), or any combination thereof; or
-N(Q₁)(Q₂), -Si(Q₃)(Q₄)(Q₅), -B(Q₆)(Q₇), or -P(=O)(Q₈)(Q₉), and
Q₁ to Q₉ and Q₃₃ to Q₃₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or-CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one deuterium, a C₁-C₁₀ alkyl group, a phenyl group, or any combination thereof,
but embodiments of the present disclosure are not limited thereto.

In one or more embodiments, R₁₁ in Formula 1 may be hydrogen, deuterium, -F, a cyano group, a nitro group, -SF₅, -CH₃, -CD₃, -CD₂H, -CDH₂, -CF₃, -CF₂H,-CFH₂, groups represented by Formulae 9-1 to 9-21, groups represented by Formulae 10-1 to 10-253, -N(Q₁)(Q₂), -Si(Q₃)(Q₄)(Q₅), -B(Q₆)(Q₇), or-P(=O)(Q₈)(Q₉), but embodiments of the present disclosure are not limited thereto:

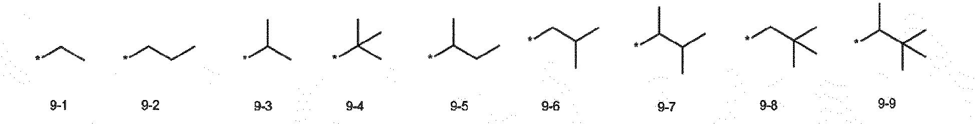

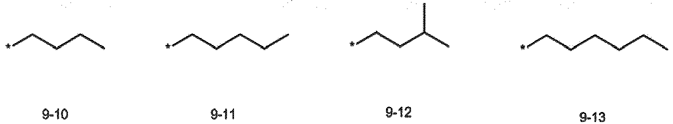

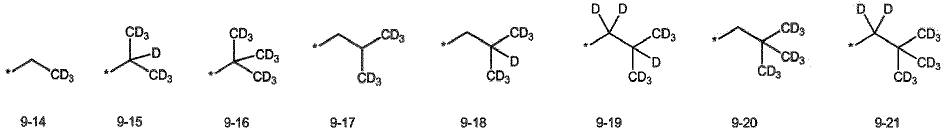

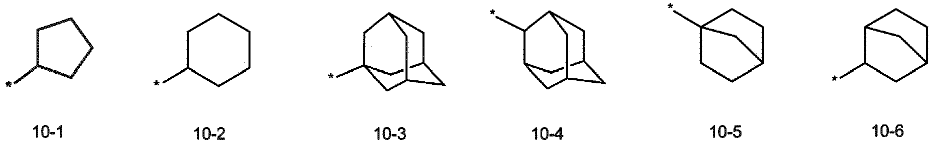

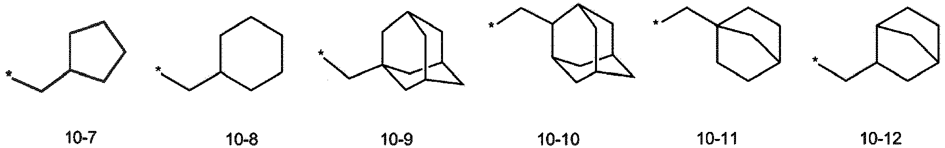

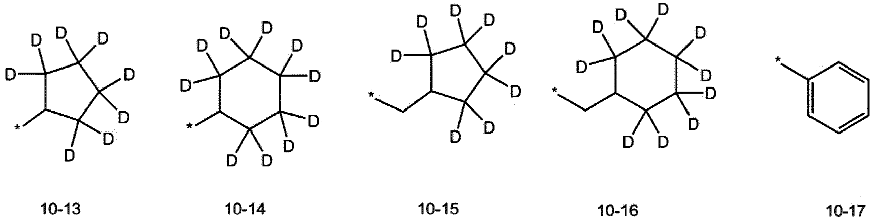

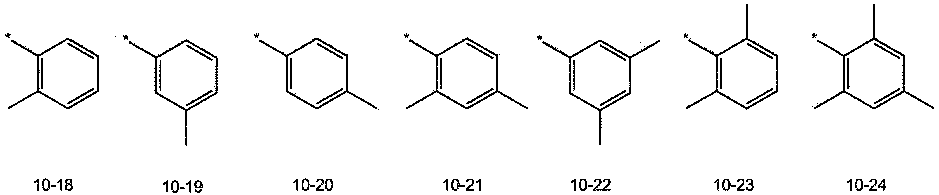

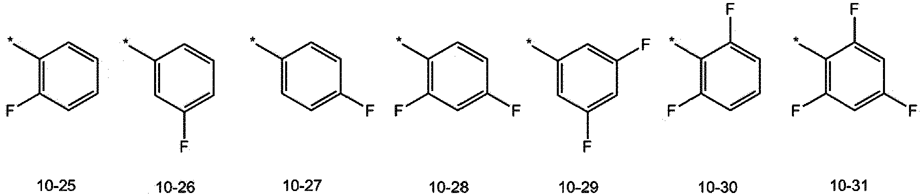

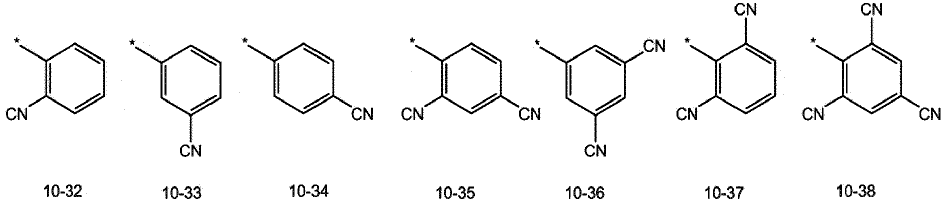

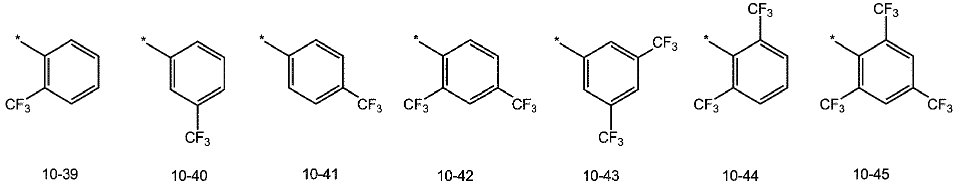

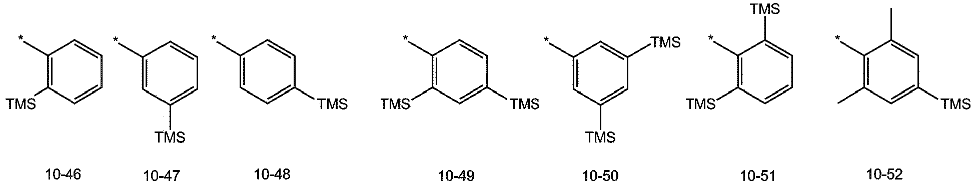

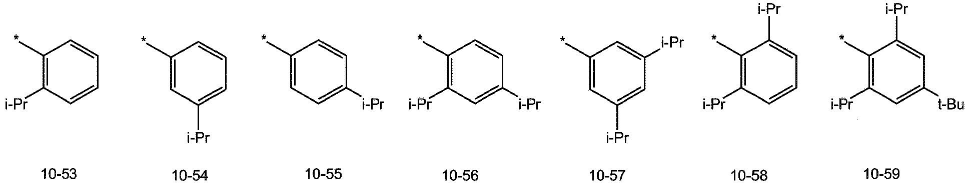

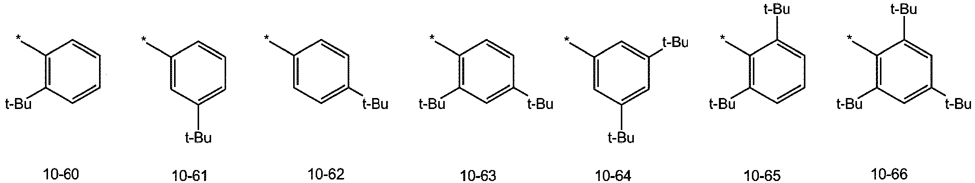

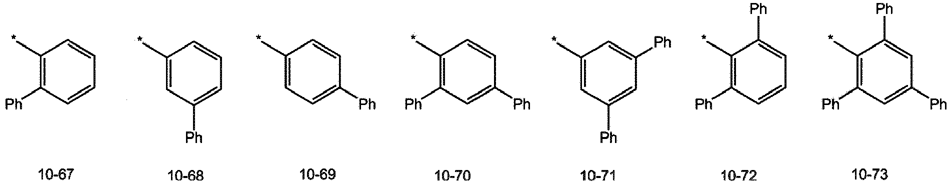

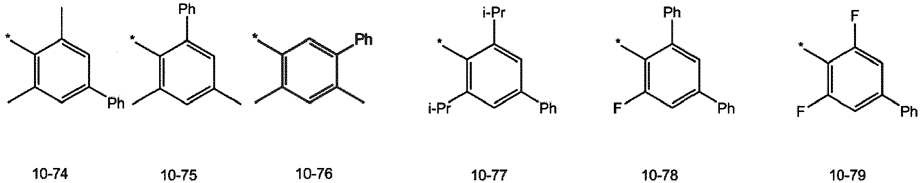

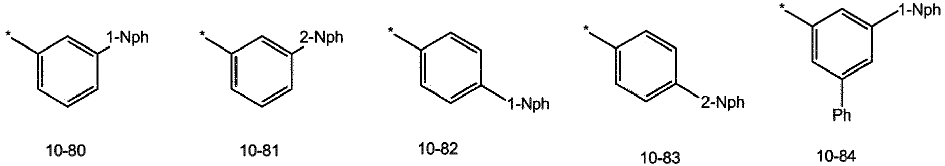

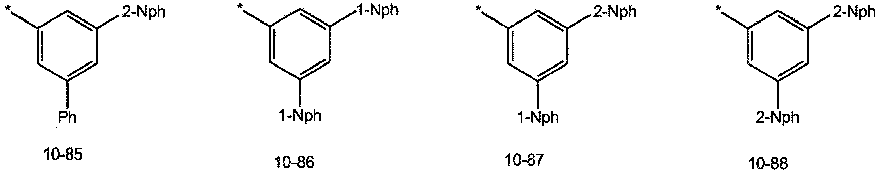

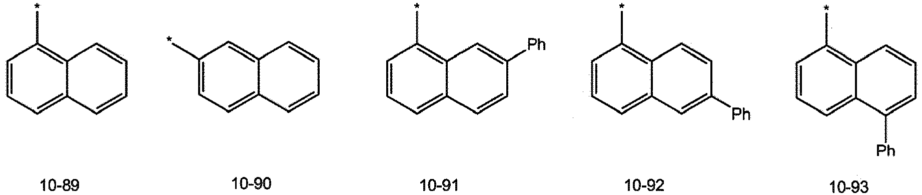

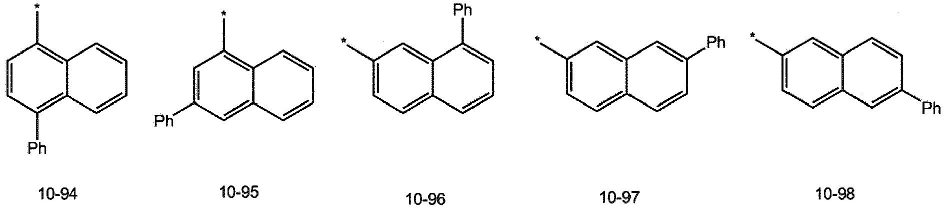

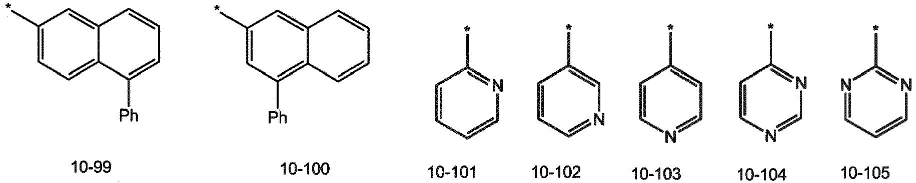

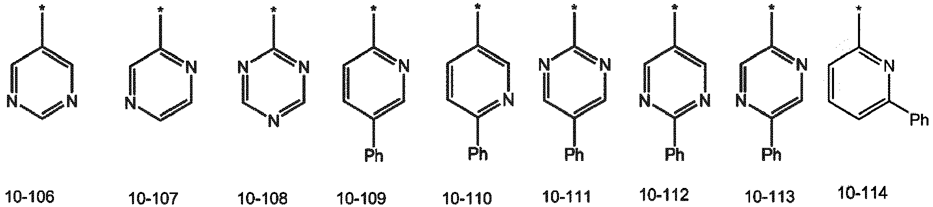

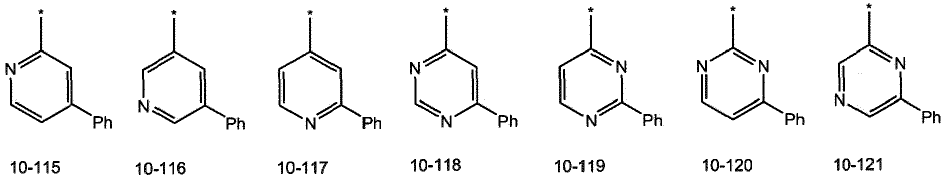

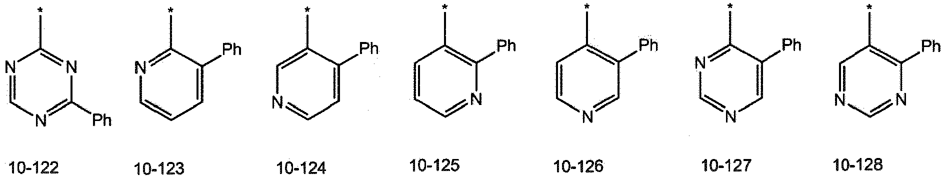

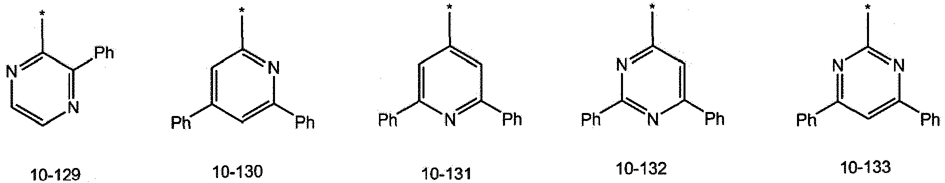

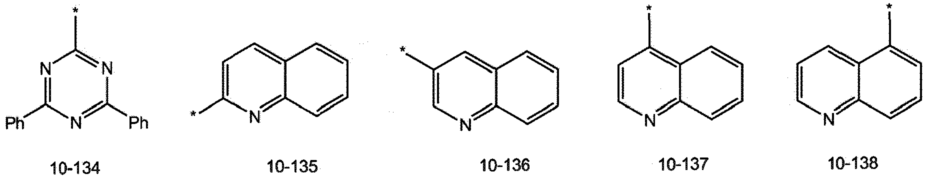

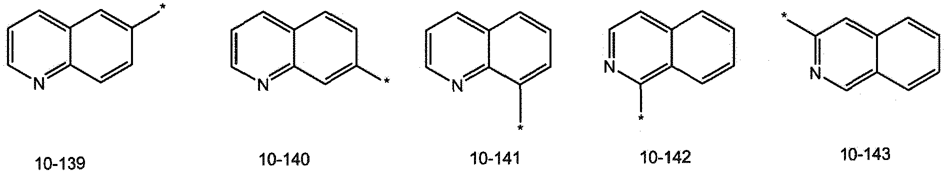

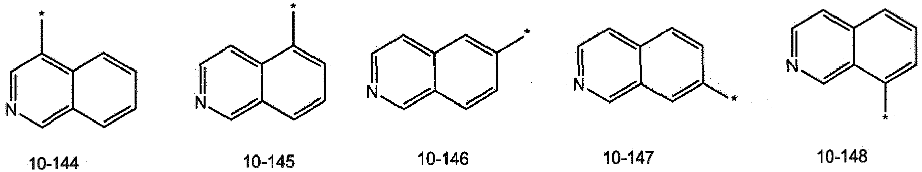

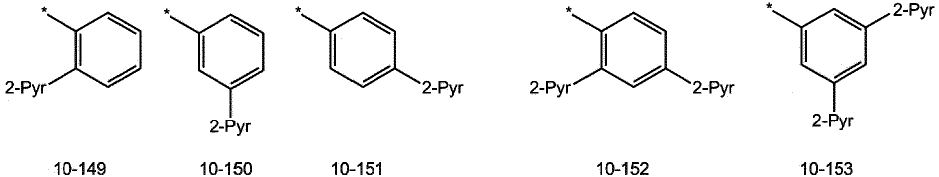

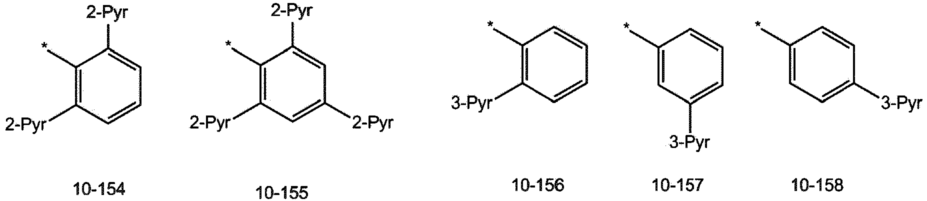

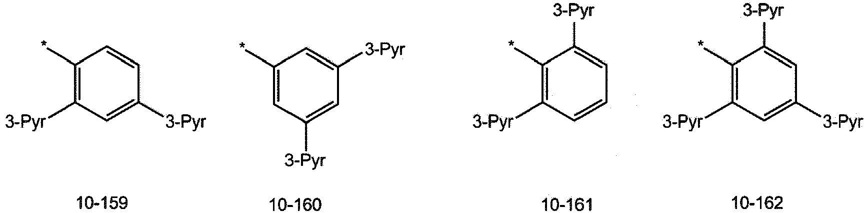

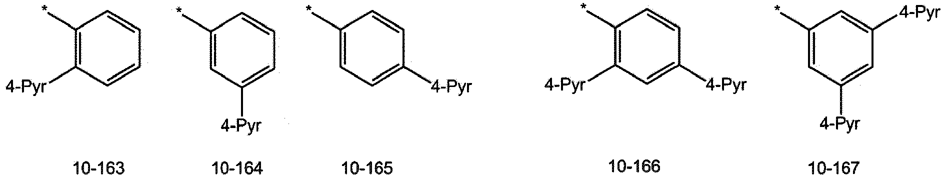

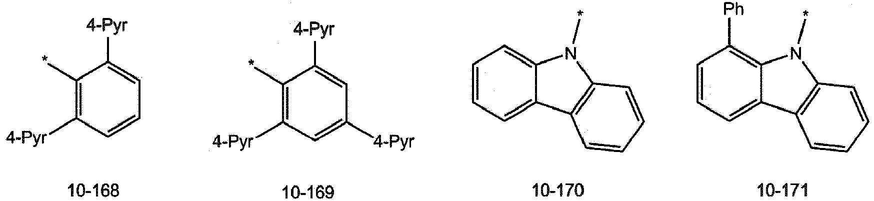

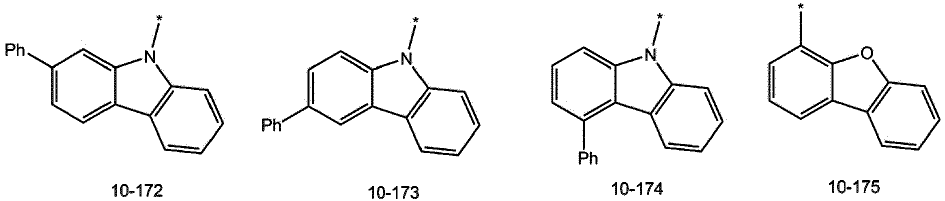

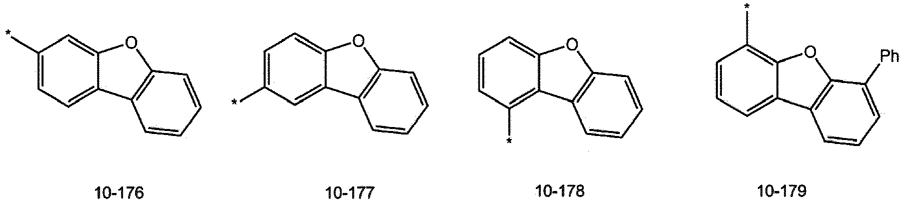

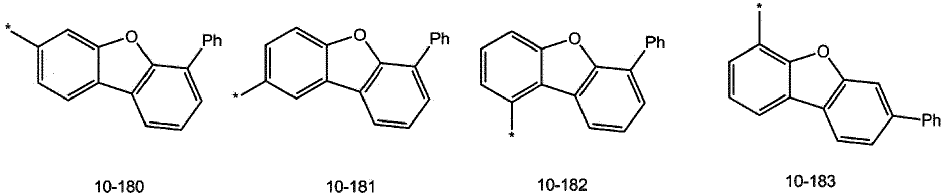

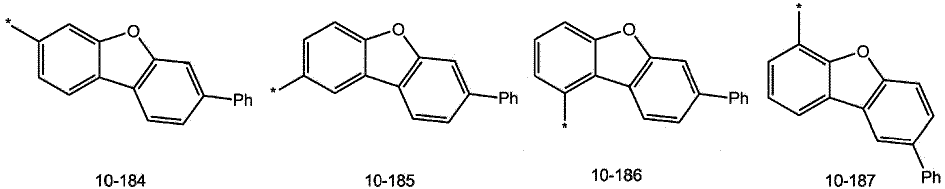

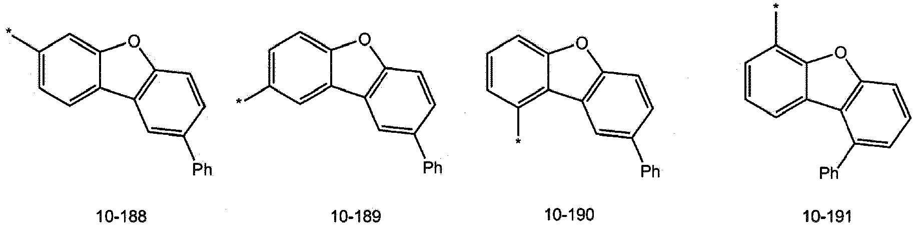

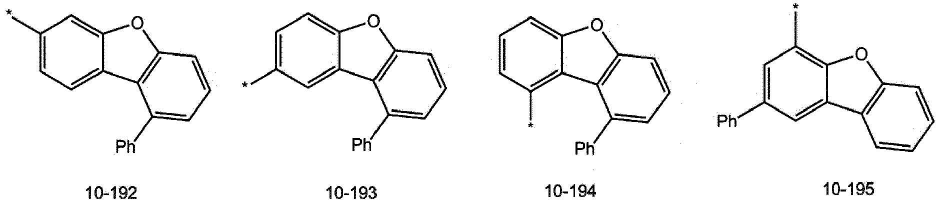

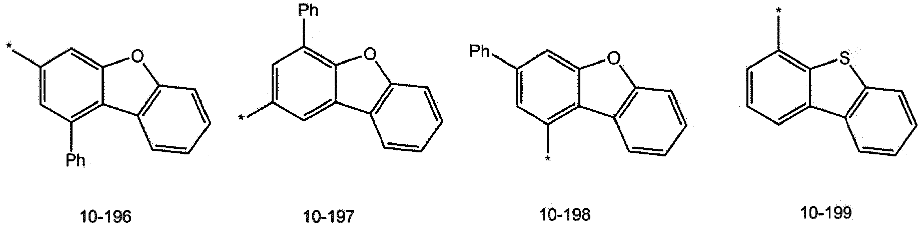

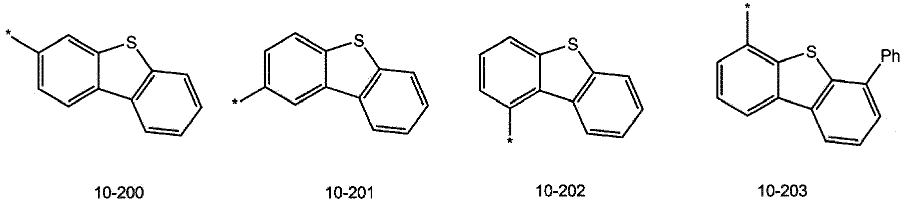

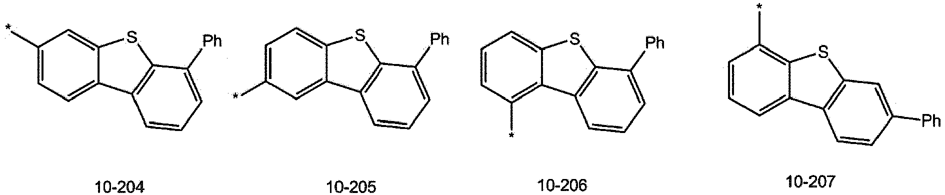

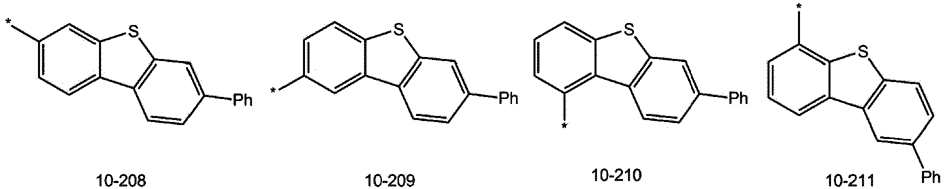

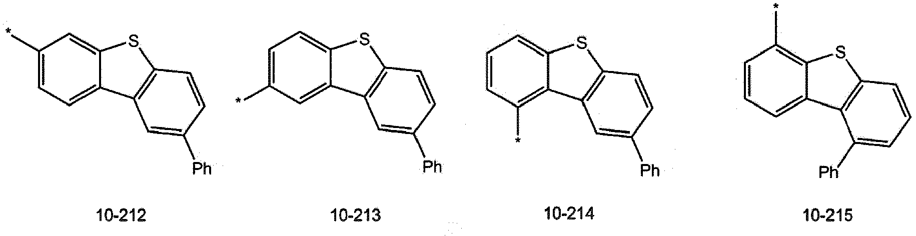

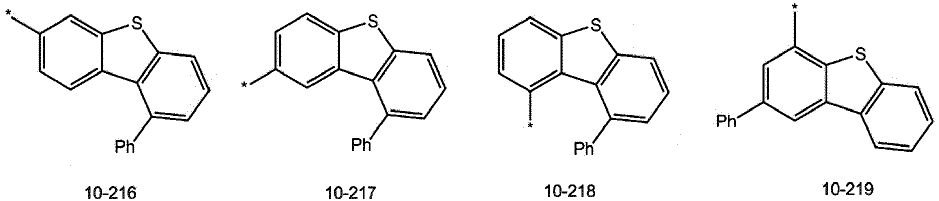

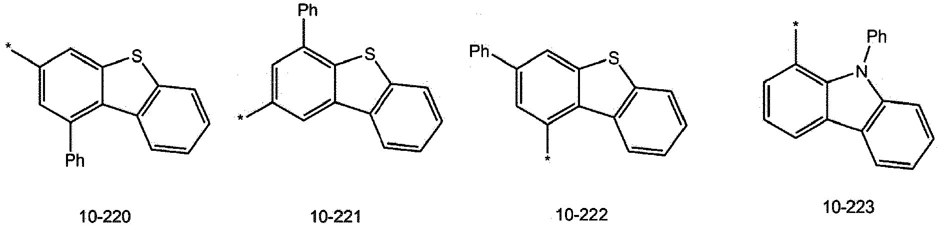

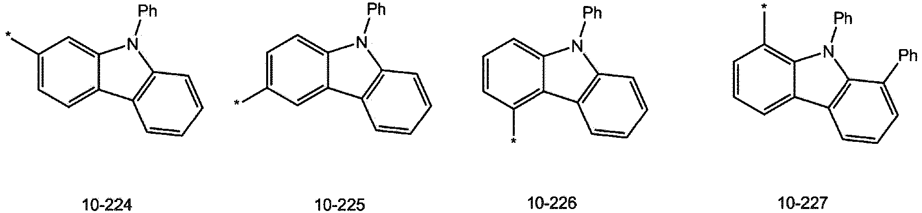

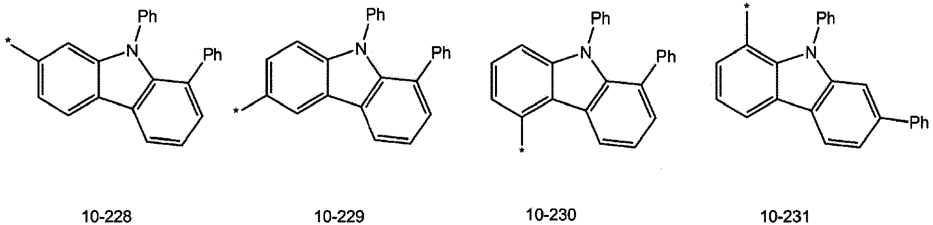

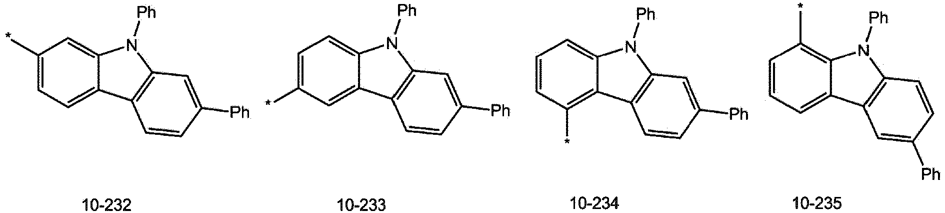

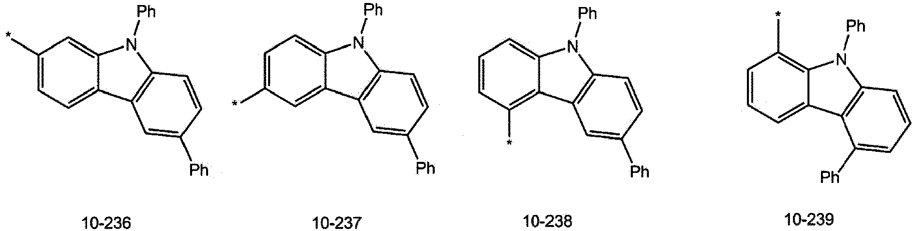

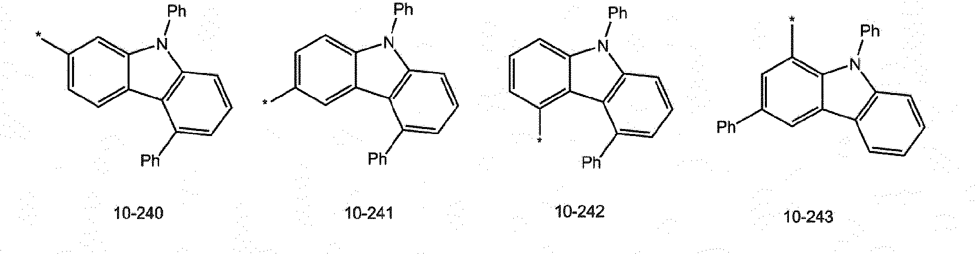

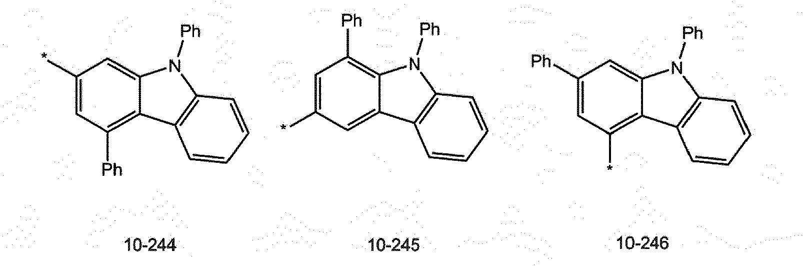

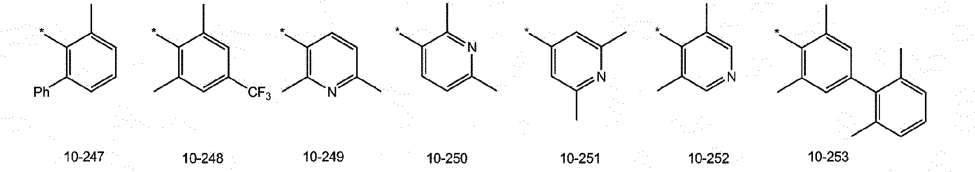

In one or more embodiments, Q₁ to Qg may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or-CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one deuterium, a C₁-C₁₀ alkyl group, a phenyl group, or any combination thereof.

In Formulae 9-1 to 9-21 and 10-1 to 10-253,
* indicates a binding site to a neighboring atom,
i-Pr indicates an isopropyl group, t-Bu indicates a t-butyl group,
Ph indicates a phenyl group,
1-Nph indicates a 1-naphthyl group, 2-Nph indicates a 2-naphthyl group,
2-Pyr indicates a 2-pyridyl group, 3-Pyr indicates a 3-pyridyl group, 4-Pyr indicates a 4-pyridyl group, and
TMS indicates a trimethylsilyl group.

R₁₂ and R₁₃ in Formula 1 may each independently be:
-F, -Cl, -Br, -I, a cyano group, or a nitro group; or
a C₁-C₆₀ alkyl group substituted with at least one -F, -Cl, -Br, -I, a cyano group, a nitro group, or any combination thereof.

For example, R₁₂ and R₁₃ in Formula 1 may each independently be:
-F, -Cl, or a cyano group; or
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with at least one -F, -Cl, a cyano group, or any combination thereof, but embodiments of the present disclosure are not limited thereto.

In one or more embodiments, R₁₂ and R₁₃ in Formula 1 may each independently be:
-F or a cyano group; or
a methyl group, an ethyl group, an n-propyl group, an isopropyl group, an n-butyl group, an isobutyl group, a sec-butyl group, or a tert-butyl group, each substituted with at least one -F, a cyano group, or a combination thereof, but embodiments of the present disclosure are not limited thereto.

In one or more embodiments, R₁₂ and R₁₃ in Formula 1 may each independently be -F, a cyano group, or -CF₃, but embodiments of the present disclosure are not limited thereto.

R₁₄ in Formula 1 may be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, but embodiments of the present disclosure are not limited thereto.

For example, R₁₄ may be:
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an oxazolyl group, a pyridinyl group, a pyrazinyl group, a pyrimidinyl group, an indolyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoxazolyl group, a triazolyl group, a tetrazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group; or
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an oxazolyl group, a pyridinyl group, a pyrazinyl group, a pyrimidinyl group, an indolyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoxazolyl group, a triazolyl group, a tetrazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with at least one deuterium, -F, -Cl, -Br, -I, -CD₃,-CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, -si(Q₃₃)(Q₃₄)(Q₃₅), or any combination thereof, and
Q₃₃ to Q₃₅ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or-CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one deuterium, a C₁-C₁₀ alkyl group, a phenyl group, or any combination thereof, but embodiments of the present disclosure are not limited thereto.

In one or more embodiments, R₁₄ in Formula 1 may be :
a phenyl group, a naphthyl group, a fluorenyl group, a phenanthrenyl group, an anthracenyl group, a benzofuranyl group, a benzothiophenyl group, a benzoxazolyl group, a dibenzofuranyl group, a dibenzothiophenyl group, or a dibenzosilolyl group; or
a phenyl group, a naphthyl group, a fluorenyl group, a phenanthrenyl group, an anthracenyl group, a benzofuranyl group, a benzothiophenyl group, a benzoxazolyl group, a dibenzofuranyl group, a dibenzothiophenyl group, or a dibenzosilolyl group, each substituted with at least one deuterium, -F, -Cl,-Br, -I, -CD₃, -CD₂H, -CDH₂, -CF₃, -CF₂H, -CFH₂, a methyl group, an ethyl group, an n-propyl group, an isopropyl group, an n-butyl group, an isobutyl group, a sec-butyl group, a tert-butyl group, a methoxy group, an ethoxy group, a propoxy group, a butoxy group, a cyclopentyl group, a cyclohexyl group, a phenyl group, a naphthyl group, -si(Q₃₃)(Q₃₄)(Q₃₅), or any combination thereof, and
Q₃₃ to Q₃₅ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or-CD₂CDH₂;
   an n-propyl group, an isopropyl group, an n-butyl group, an isobutyl group, a sec-butyl group, or a tert-butyl group; or
   an n-propyl group, an isopropyl group, an n-butyl group, an isobutyl group, a sec-butyl group, or a tert-butyl group, each substituted with deuterium, but embodiments of the present disclosure are not limited thereto.

In one embodiment, R₁₄ in Formula 1 may be Formulae 10-17 to 10-100, 10-175 to 10-222, 10-247, and 10-248, but embodiments of the present disclosure are not limited thereto:

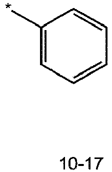

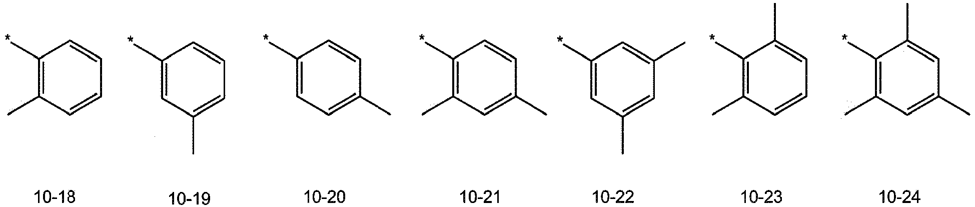

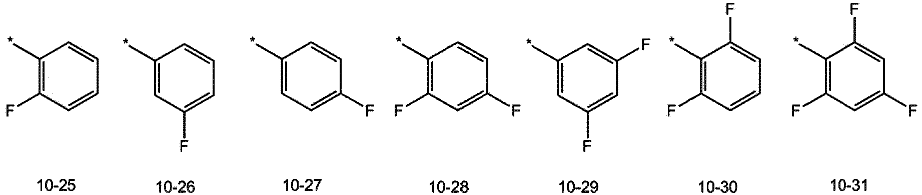

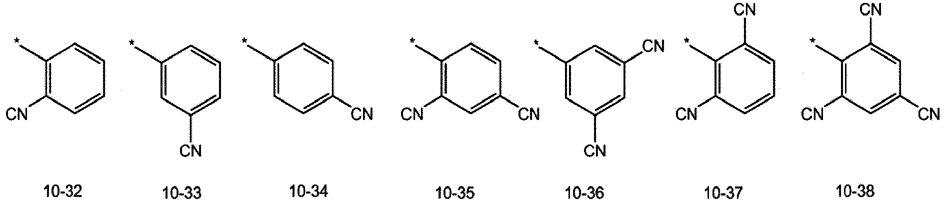

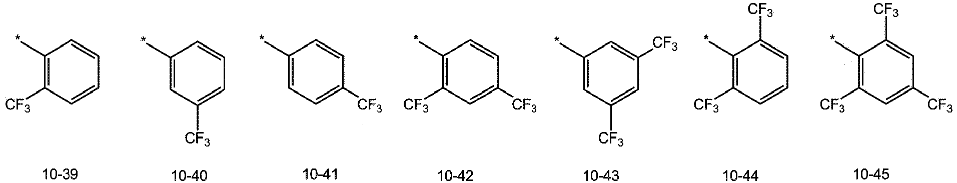

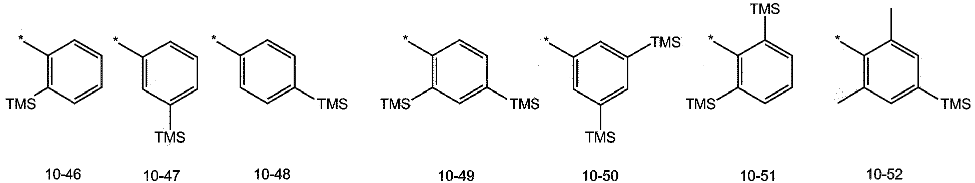

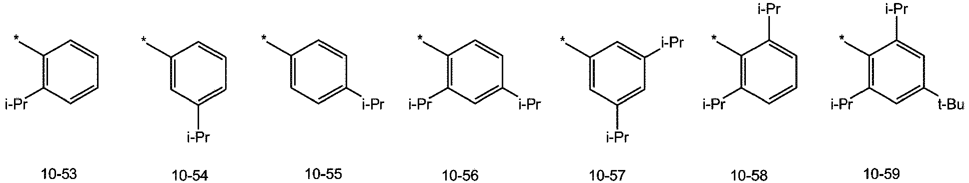

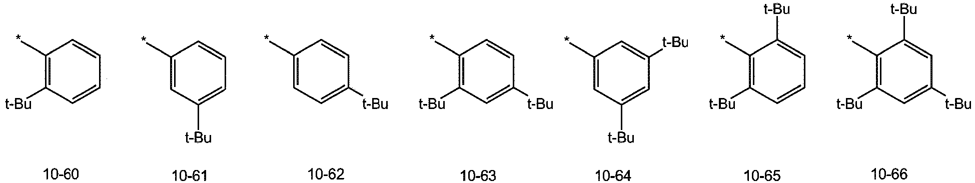

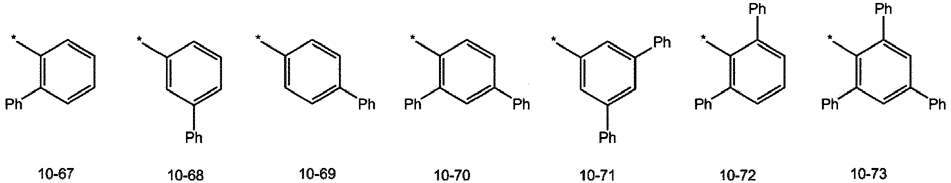

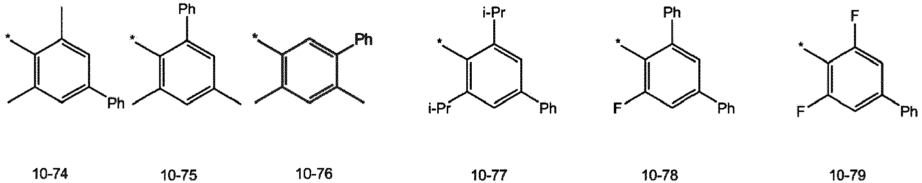

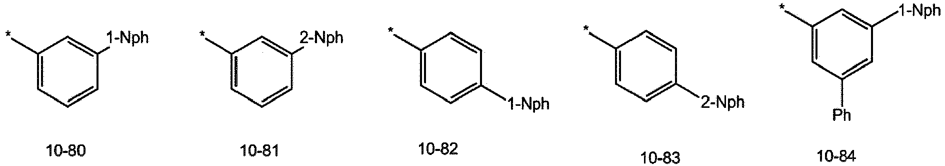

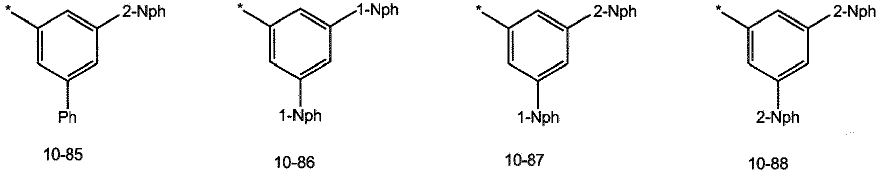

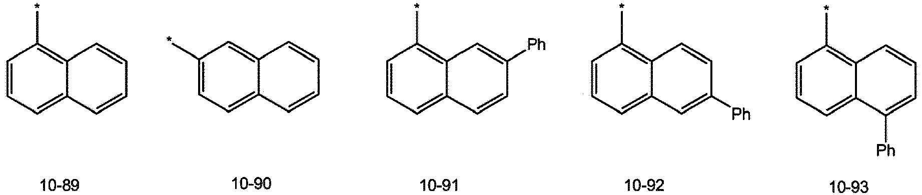

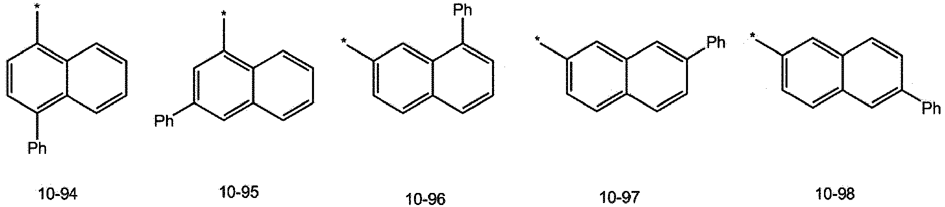

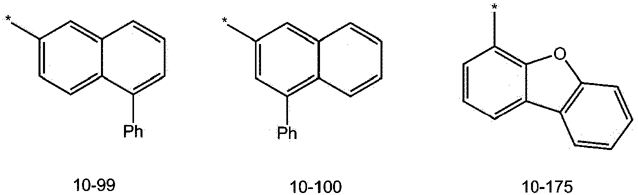

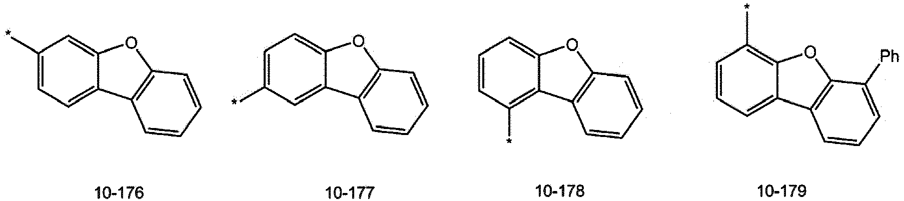

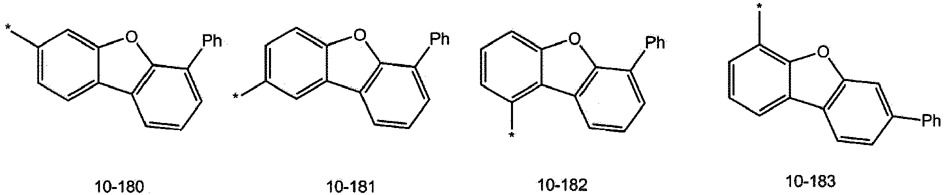

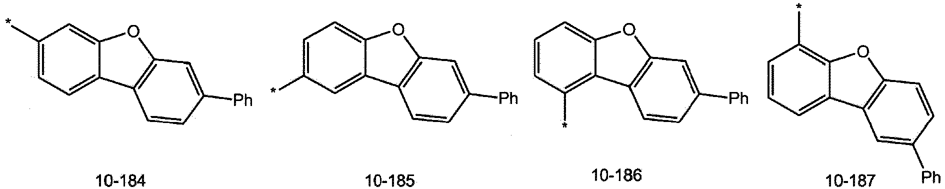

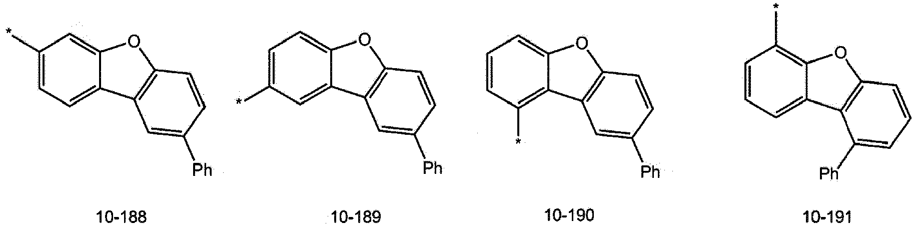

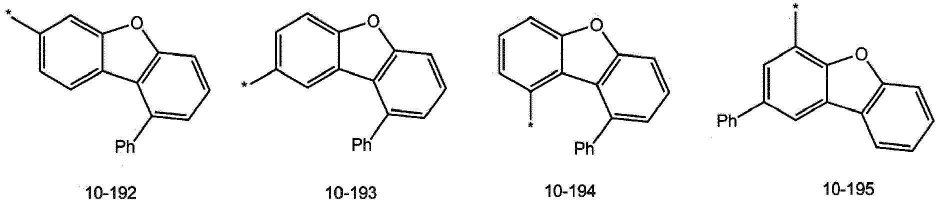

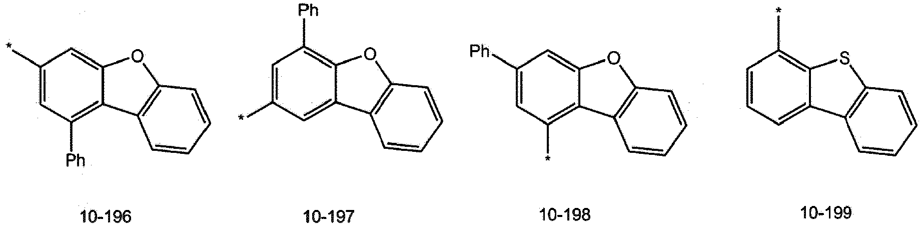

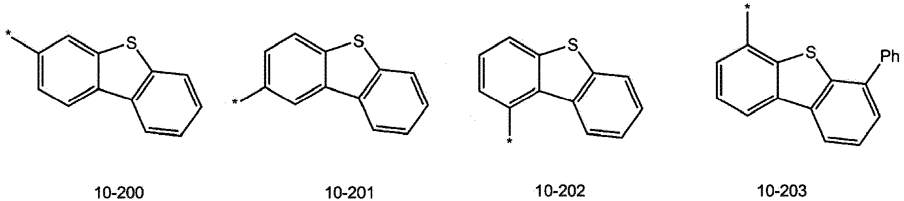

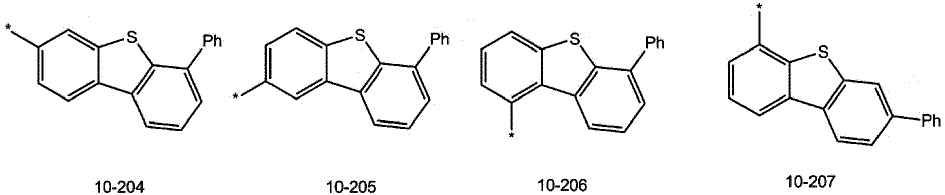

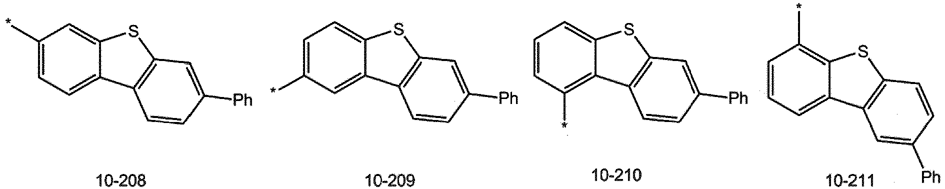

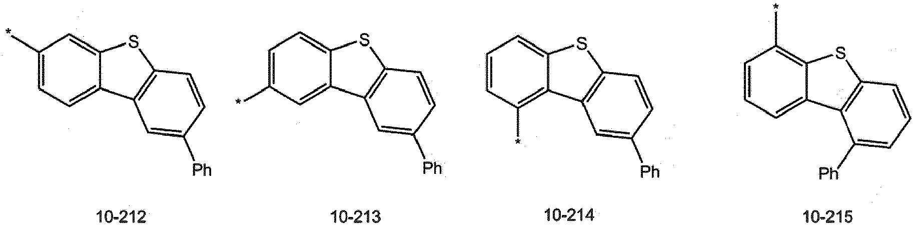

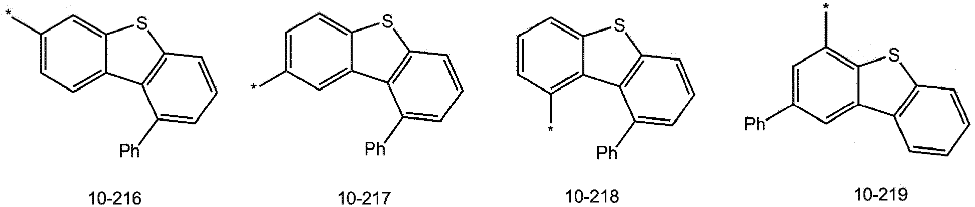

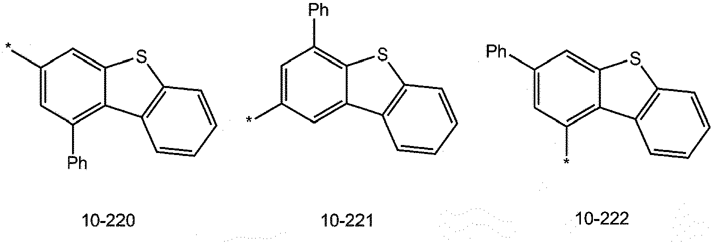

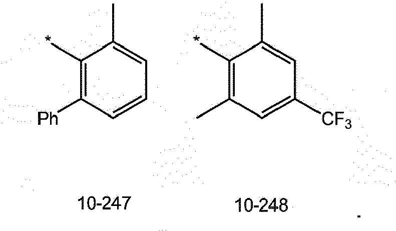

In Formulae 10-17 to 10-100, 10-175 to 10-222, 10-247, and 10-248,
* indicates a binding site to a neighboring atom,
i-Pr indicates an isopropyl group, and t-Bu indicates a t-butyl group,
Ph indicates a phenyl group,
1-Nph indicates a 1-naphthyl group, and 2-Nph indicates a 2-naphthyl group, and
TMS indicates a trimethylsilyl group.

In Formula 1, b11 indicates the number of substitution of R₁₁, wherein b11 may be 1, 2, 3, 4, 5, 6, 7, or 8.

The designation n in Formula 1 indicates the number of ligands represented by 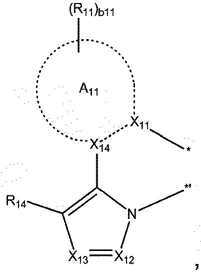 wherein n may be 1, 2, or 3.

For example, n in Formula 1 may be 2, but embodiments of the present disclosure are not limited thereto.

L₁₁ in Formula 1 may be a monodentate ligand, a bidentate ligand, or a tridentate ligand.

For example, L₁₁ in Formula 1 may be a monodentate ligand, for example, I⁻, Br, Cl⁻, sulfide, nitrate, azide, hydroxide, cyanate, isocyanate, thiocyanate, water, acetonitrile, pyridine, ammonia, carbon monoxide, P(Ph)₃, P(Ph)₂CH₃, PPh(CH₃)₂, or P(CH₃)₃, but embodiments of the present disclosure are not limited thereto.

In one or more embodiments, L₁₁ in Formula 1 may be a bidentate ligand, for example, oxalate, acetylacetonate, picolinic acid, 1,2-bis(diphenylphosphino)ethane, 1,1-bis(diphenylphosphino)methane, glycinate, or ethylenediamine, but embodiments of the present disclosure are not limited thereto.

In one or more embodiments, L₁₁ in Formula 1 may be a ligand represented by one of Formulae 7-1 to 7-11, but embodiments of the present disclosure are not limited thereto:

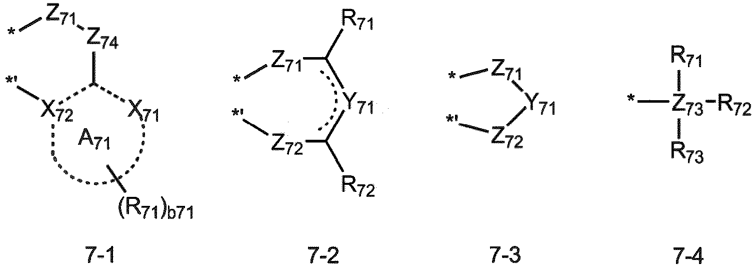

*-X₇₁≡X₇₂-R₇₁ 7-5

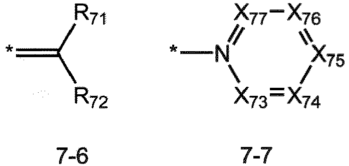

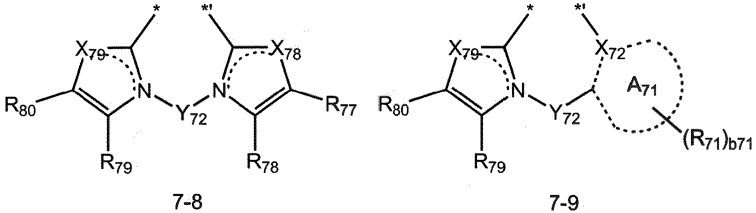

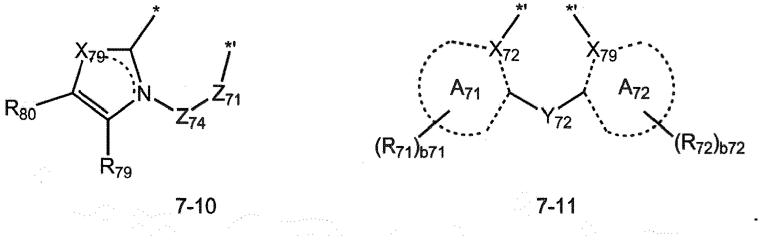

In Formulae 7-1 to 7-11,
A₇₁ and A₇₂ may each independently be a C₅-C₂₀ carbocyclic group or a C₁-C₂₀ heterocyclic group,
X₇₁ and X₇₂ are each independently C or N,
X₇₃ may be N or C(Q₇₃), X₂₄ may be N or C(Q₇₄), X₇₅ may be N or C(Q₇₅), X₇₆ may be N or C(Q₇₆), and X₂₇ may be N or C(Q₇₇),
X₇₈ may be O, S, or N(Q₇₈), and X₂₉ may be O, S, or N(Q₇₉),
Y₇₁ and Y₇₂ may each independently be a single bond, a double bond, a substituted or unsubstituted C₁-C₅ alkylene group, a substituted or unsubstituted C₂-C₅ alkenylene group, or a substituted or unsubstituted C₆-C₁₀ arylene group,
Z₇₁ and Z₇₂ may each independently be N, O, N(R₇₅), P(R₇₅)(R₇₆), or AS(R₇₅)(R₇₆),
Z₇₃ may be P or As,
Z₇₄ may be C(=O) or CH₂,
R₇₁ to R₈₀ and Q₇₃ to Q₇₉ may each independently be hydrogen, deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, wherein R₇₁ and R₇₂ may optionally be linked to each other to form a ring, R₇₇ and R₇₈ may optionally be linked to each other to form a ring, R₇₈ and R₇₉ may optionally be linked to each other to form a ring, and R₇₉ and R₈₀ may optionally be linked to each other to form a ring,
b71 and b72 may each independently be 1, 2, or 3, and
* and *' each independently indicate a binding site to a neighboring atom.

For example, A₇₁ and A₇₂ in Formula 7-1 may each independently be a benzene group, a naphthalene group, an imidazole group, a benzimidazole group, a pyridine group, a pyrimidine group, a triazine group, a quinoline group, or an isoquinoline group, but embodiments of the present disclosure are not limited thereto.

For example, X₇₂ and X₇₉ in Formula 7-1 may each be N, but embodiments of the present disclosure are not limited thereto.

For example, in Formula 7-7, X₇₃ may be C(Q₇₃); X₇₄ may be C(Q₇₄); X₇₅ may be C(Q₇₅); X₇₆ may be C(Q₇₆); and X₇₇ may be C(Q₇₇), but embodiments of the present disclosure are not limited thereto.

For example, in Formula 7-8, X₇₈ may be N(Q₇₈); and X₇₉ may be N(Q₇₉), but embodiments of the present disclosure are not limited thereto.

For example, Y₇₁ and Y₇₂ in Formulae 7-2, 7-3, and 7-8 may each independently be a substituted or unsubstituted methylene group, or a substituted or unsubstituted phenylene group, but embodiments of the present disclosure are not limited thereto.

For example, Z₇₁ and Z₇₂ in Formulae 7-1 and 7-2 may each be O, but embodiments of the present disclosure are not limited thereto.

For example, Z₇₃ in Formula 7-4 may each be P, but embodiments of the present disclosure are not limited thereto.

For example, R₇₁ to R₈₀ and Q₇₃ to Q₇₉ in Formulae 7-1 to 7-8 may each independently be:
hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, or a C₁-C₂₀ alkoxy group;
a C₁-C₂₀ alkyl group or a C₁-C₂₀ alkoxy group, each substituted with at least one deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a phenyl group, a naphthyl group, a pyridinyl group, or a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, or an imidazopyridinyl group; or
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, or an imidazopyridinyl group, each substituted with at least one deuterium, -F, -Cl, -Br, -I, -CD₃, -CD₂H, -CDH₂,-CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, or an imidazopyridinyl group, but embodiments of the present disclosure are not limited thereto.

In one or more embodiments, L₁₁ in Formula 1 may be a ligand represented by one of Formulae 5-1 to 5-116 and 8-1 to 8-29, but embodiments of the present disclosure are not limited thereto:

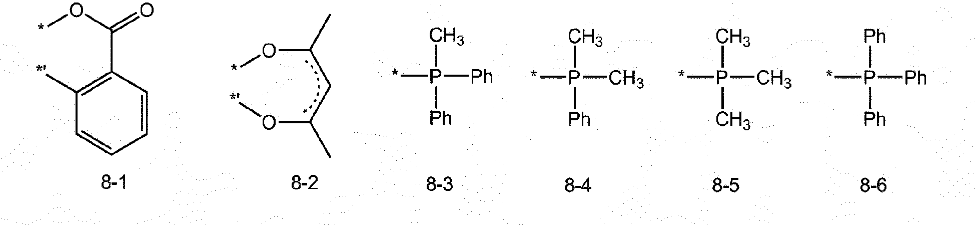

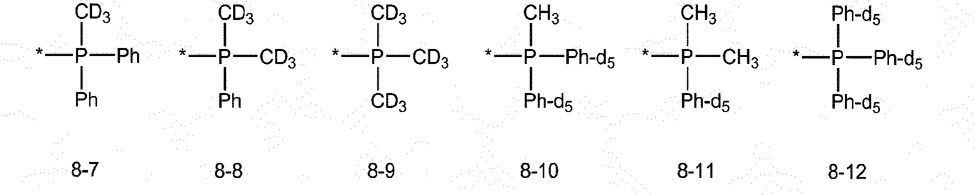

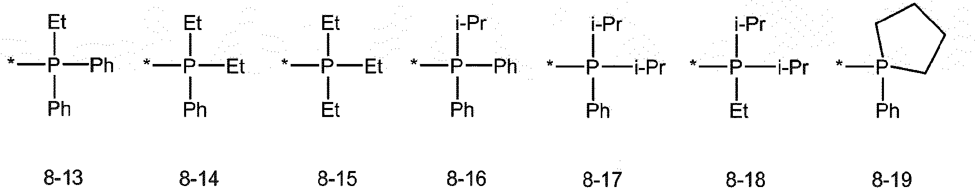

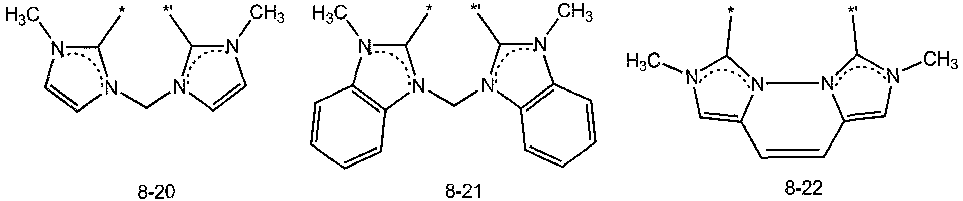

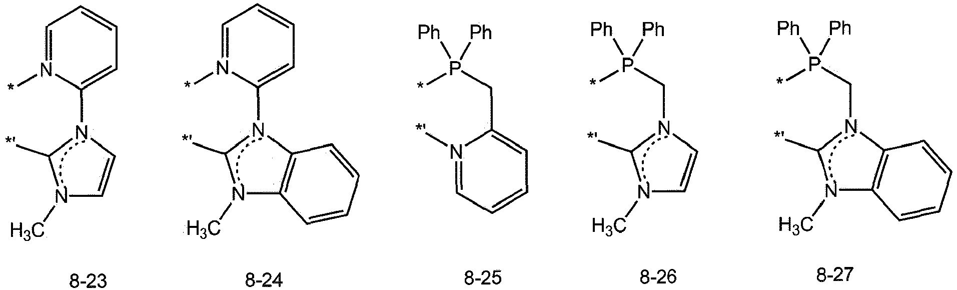

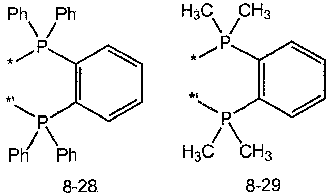

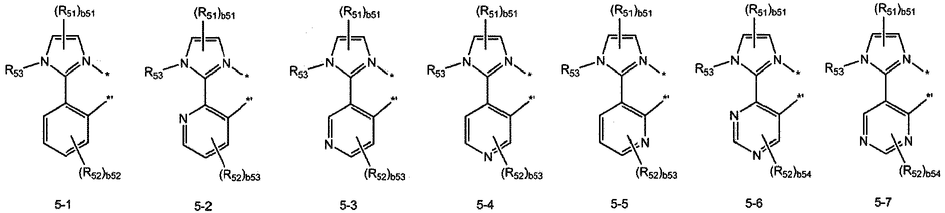

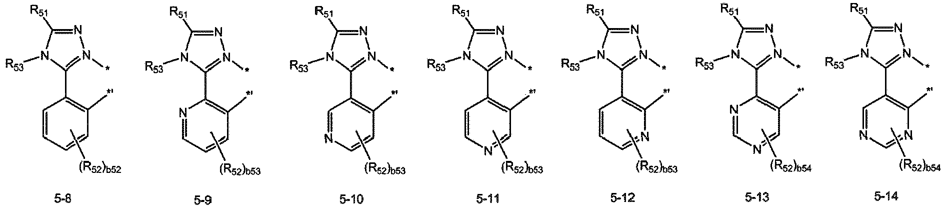

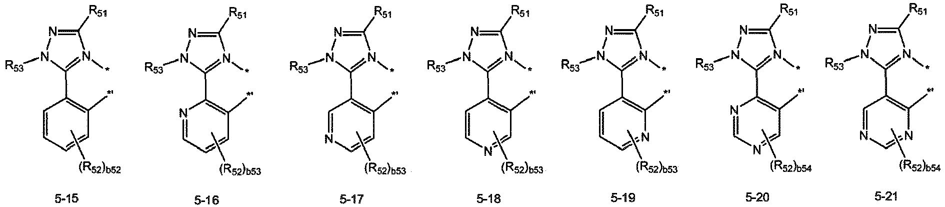

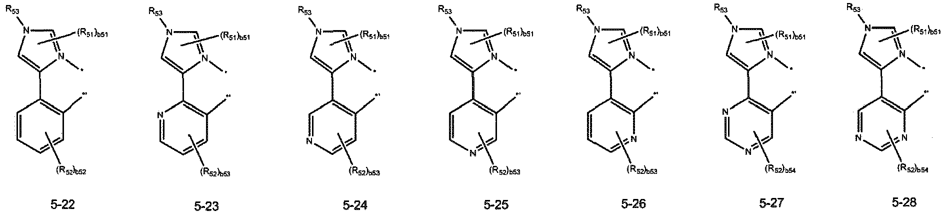

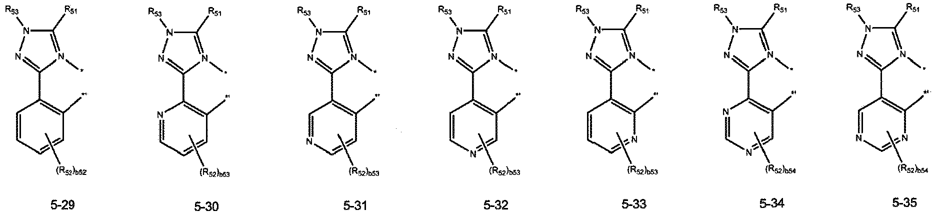

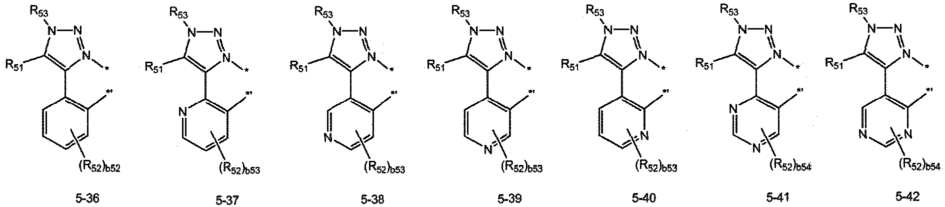

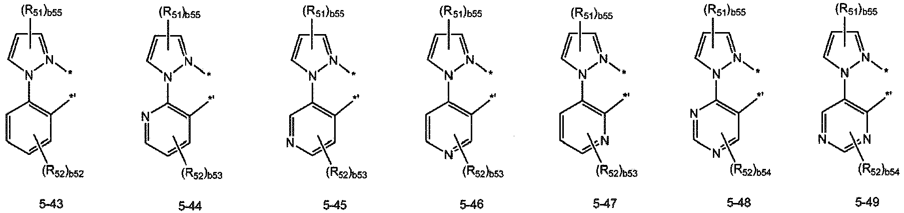

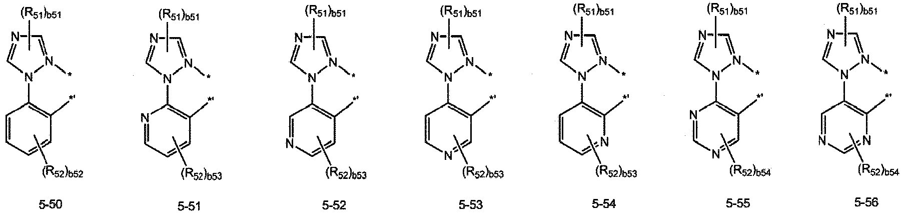

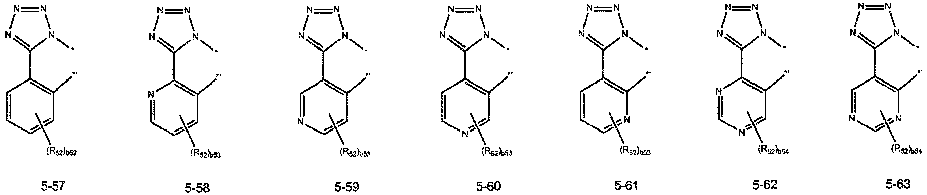

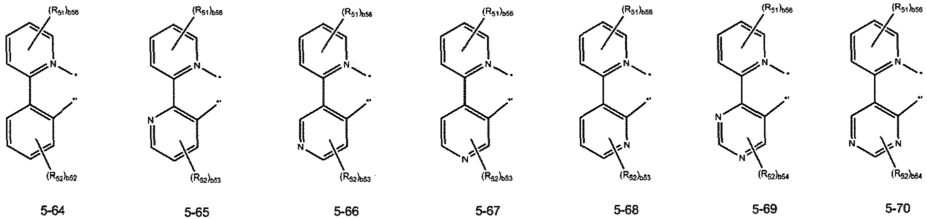

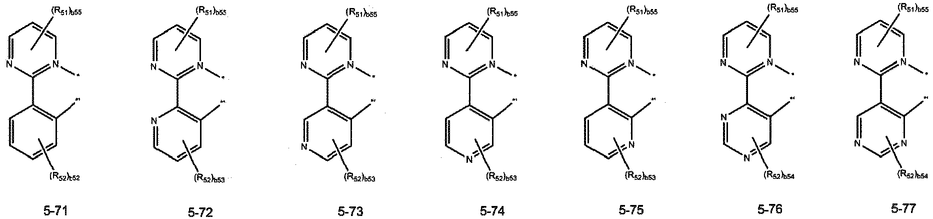

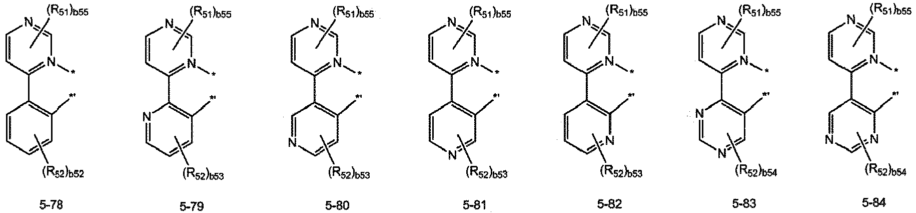

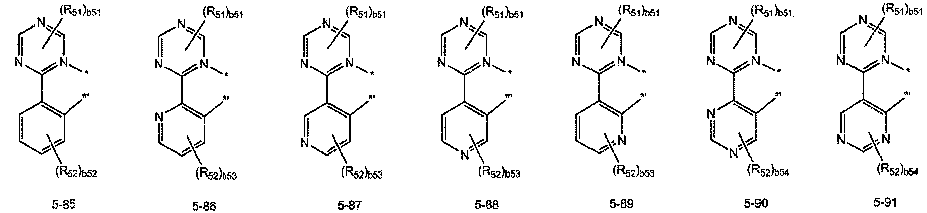

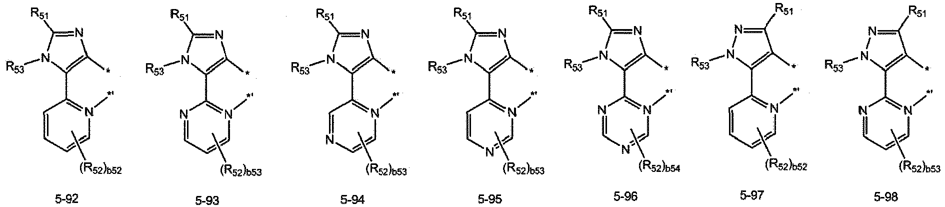

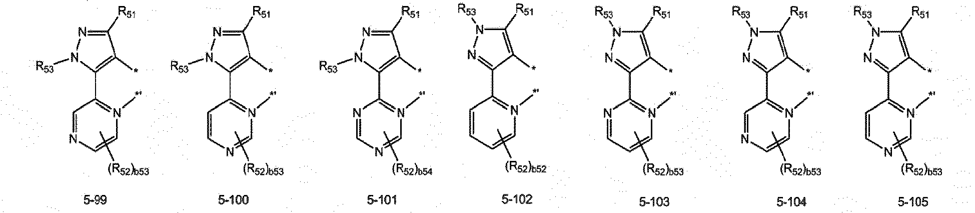

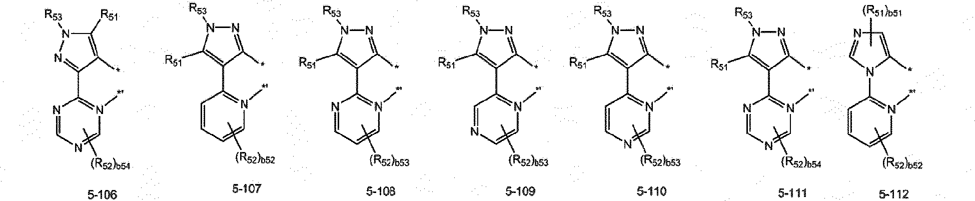

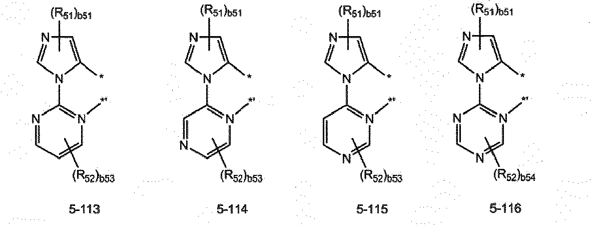

In Formulae 5-1 to 5-116 and 8-1 to 8-29,
R₅₁ to R₅₃ may each independently be hydrogen, -F, a cyano group, a nitro group, a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decanyl group, an isodecanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, or a dibenzothiophenyl group; or
a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decanyl group, an isodecanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, or a dibenzothiophenyl group, each substituted with at least one -F, a cyano group, a nitro group, or any combination thereof,
b51 and b54 may each independently be 1 or 2,
b53 and b55 may each independently be 1, 2, or 3,
b52 may be 1, 2, 3, or 4,
Ph indicates a phenyl group,
Ph-d5 indicates a phenyl group in which all hydrogen atoms are substituted with deuterium,
Et indicates an ethyl group,
i-Pr indicates an isopropyl group, and
* and *' each indicate a binding site to a neighboring atom.

The designation m in Formula 1 indicates the number of L₁₁(s), wherein m may be 0, 1, 2, 3, 4, or 5.

For example, in Formula 1, L₁₁ may be a monodentate ligand, and m may be 2, but embodiments of the present disclosure are not limited thereto.

In one or more embodiments, the organometallic compound represented by Formula 1 may be represented by Formula 1-1, but embodiments of the present disclosure are not limited thereto:

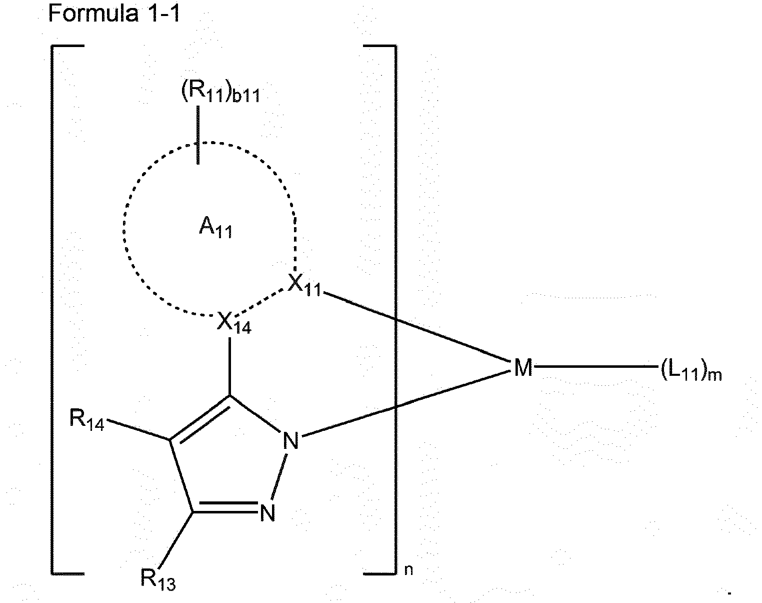

In Formula 1-1,
M, A₁₁, X₁₁, X₁₄, R₁₁, R₁₃, R₁₄, b11, L₁₁, n, and m may each independently be the same as described in connection with Formula 1.

For example, in Formula 1-1, M may be Ru or Os, n may be 2, L₁₁ may be a monodentate ligand, and m may be 2, but embodiments of the present disclosure are not limited thereto.

In one or more embodiments, the organometallic compound represented by Formula 1 may be represented by one of Formulae 1-11 to 1-24, but embodiments of the present disclosure are not limited thereto:

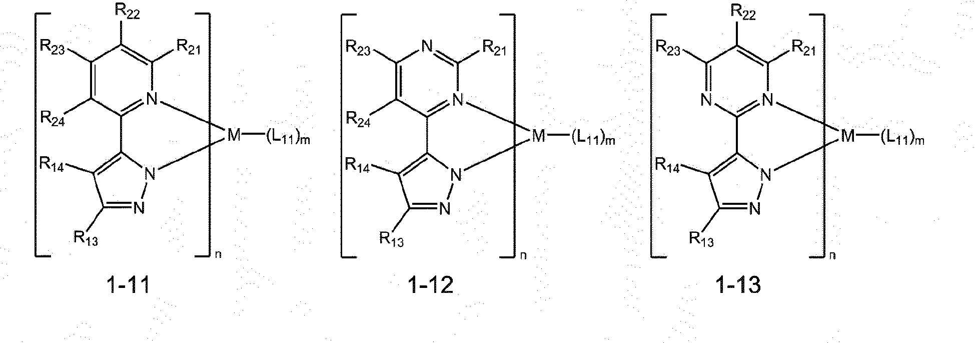

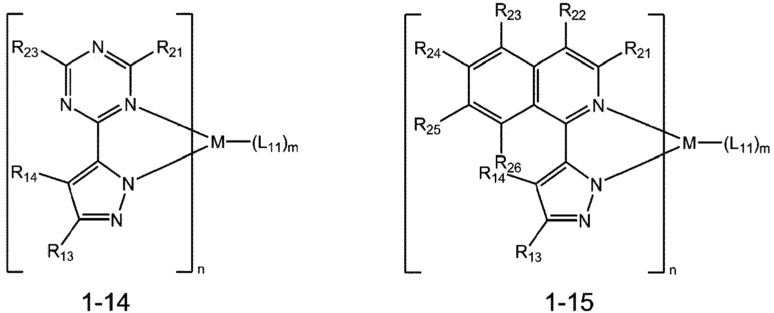

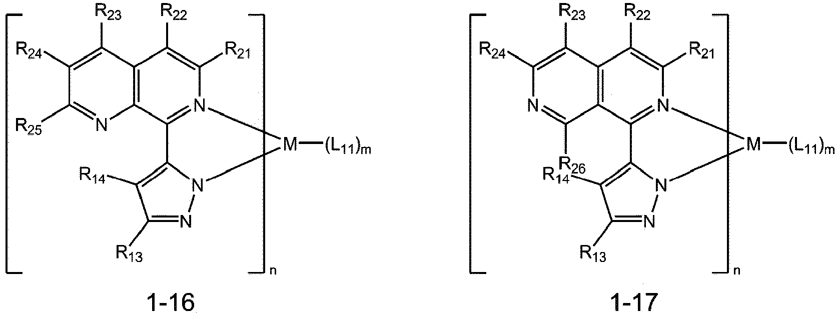

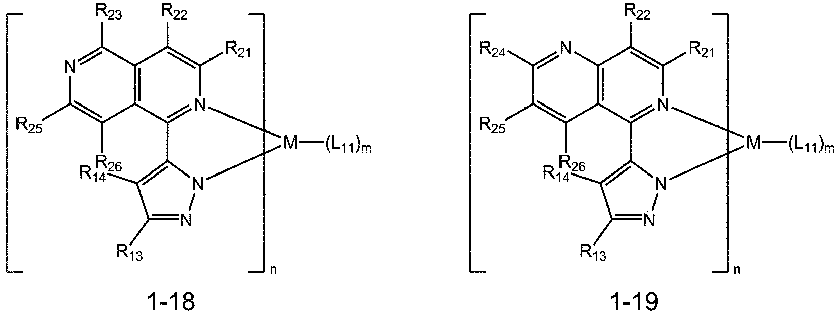

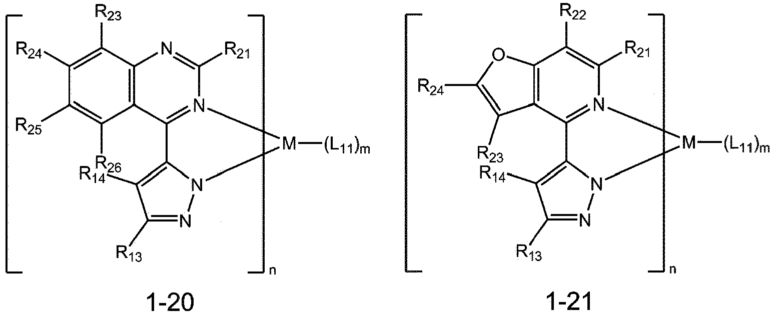

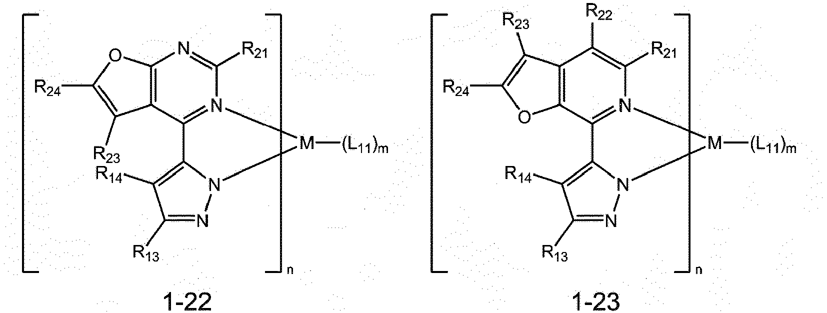

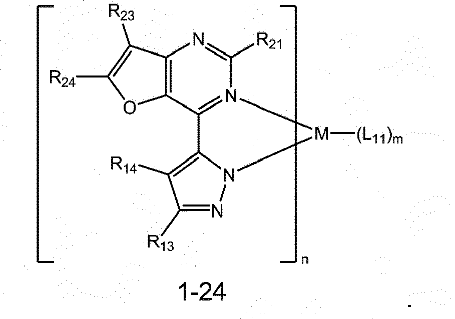

In Formulae 1-11 to 1-24,
M, A₁₁, X₁₁, X₁₄, R₁₁, R₁₃, R₁₄, b11, L₁₁, n, and m may each independently be the same as described in connection with Formula 1.

For example, in Formulae 1-11 to 1-24, M may be Ru or Os, n may be 2, L₁₁ may be a monodentate ligand, and m may be 2, but embodiments of the present disclosure are not limited thereto.

In one or more embodiments, the organometallic compound may be of Compounds 1 to 11, but embodiments of the present disclosure are not limited thereto:

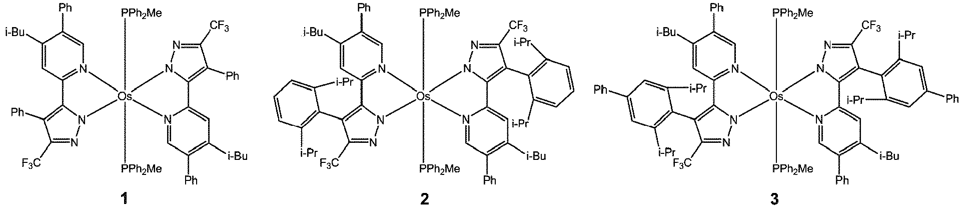

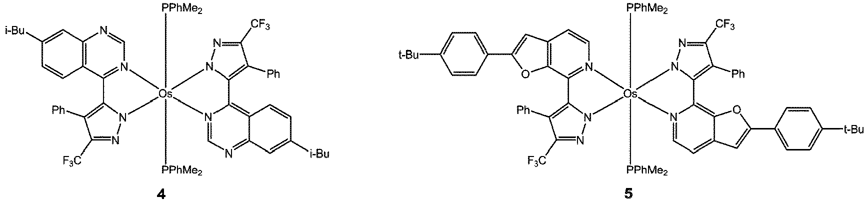

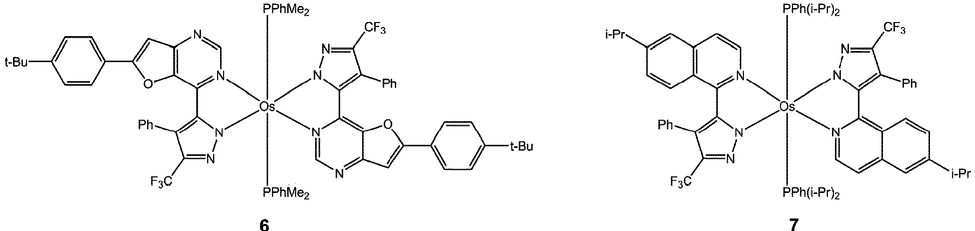

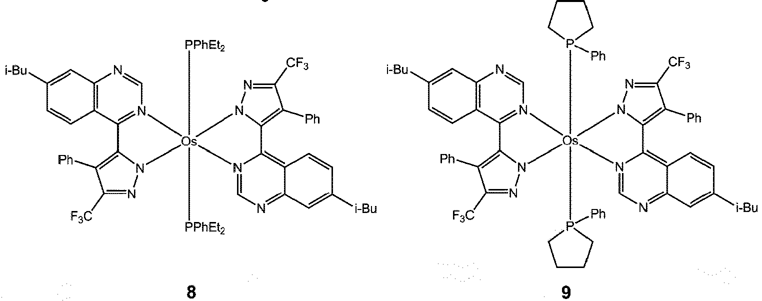

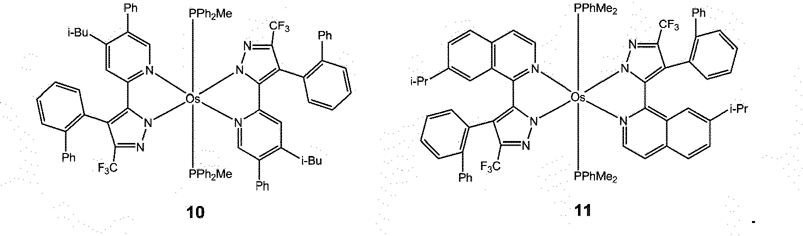

In Compounds 1 to 11,
Ph indicates a phenyl group, i-Pr indicates an isopropyl group, i-Bu indicates an isobutyl group, and t-Bu indicates a tert-butyl group.

A maximum emission wavelength (actually measured value) of the organometallic compound represented by Formula 1 may be about 550 nm or more and about 700 nm or less, for example, about 600 nm to about 650 nm.

When the organometallic compound represented by Formula 1 includes Os or Ru, the organometallic compound may emit light (for example, green or red light) at long wavelengths while having a molecular weight small enough to be deposited.

Since the organometallic compound represented by Formula 1 essentially includes a substituent capable of giving an electron such as an aryl group at position 4 of a 5-membered ring, the electrical stability of the organometallic compound may be improved. Therefore, the lifespan of an organic light-emitting device including the organometallic compound may be improved.

Since the organometallic compound represented by Formula 1 essentially includes a substituent having a planar shape and having a large steric hindrance such as an aryl group at position 4 of a 5-membered ring, a transition dipole moment of the organometallic compound may be arranged in a predetermined direction. Therefore, the efficiency of an organic light-emitting device including the organometallic compound may be improved.

Since the organometallic compound represented by Formula 1 essentially includes a configuration capable of attracting an electron such as N or CF₃ at position 2 or 3 of a 5-membered ring, the thermal stability of the organometallic compound may be improved. Therefore, the lifespan of an organic light-emitting device including the organometallic compound may be improved.

A highest occupied molecular orbital (HOMO) energy level, a lowest unoccupied molecular orbital (LUMO) energy level, a singlet (S₁) energy level, and a triplet (T₁) energy level of some compounds of the organometallic compound represented by Formula 1 are evaluated by a density functional theory (DFT) of Gaussian 09 program (structurally optimized based on B3LYP, 6-31G(d,p) levels) with molecular structure optimization, and results are shown in Table 1.

**Table 1**

| Compound No. | HOMO (eV) | LUMO (eV) | T₁(eV) |
|---|---|---|---|
| 1 | -4.551 | -1.368 | 2.313 |
| 2 | -4.598 | -1.427 | 2.301 |
| 3 | -4.639 | -1.442 | 2.321 |
| 4 | -4.761 | -2.160 | 1.762 |
| 5 | -4.480 | -1.815 | 1.932 |
| 6 | -4.676 | -2.099 | 1.826 |
| 7 | -4.402 | -1.915 | 1.647 |
| 8 | -4.724 | -2.172 | 1.710 |
| 9 | -4.721 | -2.143 | 1.741 |

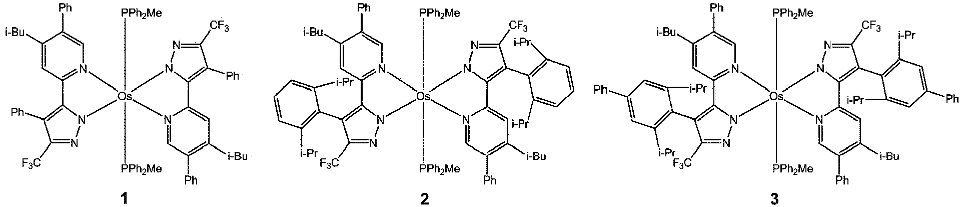

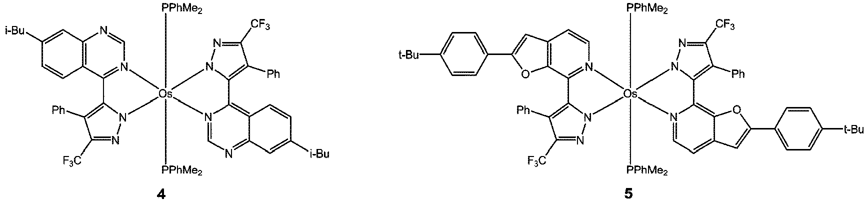

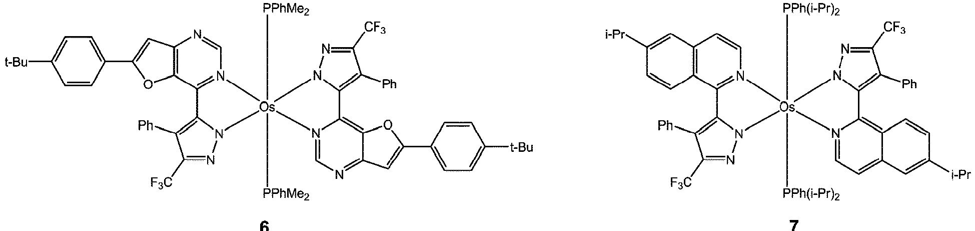

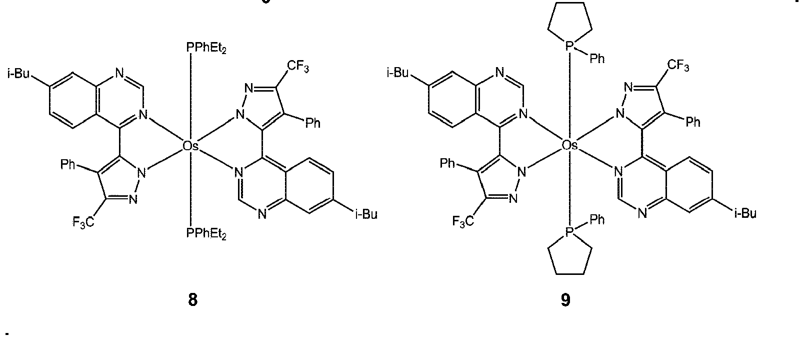

From Table 1, it is confirmed that the organometallic compound represented by Formula 1 has such electric characteristics that are suitable for use in an electric device, for example, for use as a dopant for an organic light-emitting device.

Synthesis methods of the organometallic compound represented by Formula 1 may be understood by those of ordinary skill in the art by referring to Synthesis Examples provided below.

Therefore, the organometallic compound represented by Formula 1 is suitable for use in an organic layer of an organic light-emitting device, for example, for use as a dopant in an emission layer of the organic layer. Thus, another aspect of the present disclosure provides an organic light-emitting device that includes: a first electrode; a second electrode; and an organic layer that is disposed between the first electrode and the second electrode and includes an emission layer, wherein the organic layer includes at least one organometallic compound represented by Formula 1.

The organic light-emitting device may have, due to the inclusion of an organic layer including the organometallic compound represented by Formula 1, a low driving voltage, high efficiency, high power, high quantum efficiency, a long lifespan, a low roll-off ratio, and excellent color purity.

The organometallic compound represented by Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). In this regard, the dopant may emit blue light.

The expression "(an organic layer) includes at least one organometallic compound" as used herein may include a case in which "(an organic layer) includes identical compounds represented by Formula 1" and a case in which "(an organic layer) includes two or more different organometallic compounds represented by Formula 1."

For example, the organic layer may include, as the organometallic compound, only Compound 1. In this regard, Compound 1 may exist only in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer further includes a hole transport region between the first electrode and the emission layer and an electron transport region between the emission layer and the second electrode, and the hole transport region includes at least one a hole injection layer, a hole transport layer, and an electron blocking layer, and the electron transport region includes at least one a hole blocking layer, an electron transport layer, and an electron injection layer.

The term "organic layer" as used herein refers to a single layer and/or a plurality of layers between the first electrode and the second electrode of the organic light-emitting device. The "organic layer" may include, in addition to an organic compound, an organometallic compound including metal.

FIGURE is a schematic cross-sectional view of an organic light-emitting device 10 according to an embodiment. Hereinafter, the structure of an organic light-emitting device according to an embodiment and a method of manufacturing an organic light-emitting device according to an embodiment will be described in connection with FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be materials with a high work function to facilitate hole injection. The first electrode 11 may be a reflective electrode, a semi-reflective electrode, or a transmissive electrode. The material for forming the first electrode 11 may be, for example, indium tin oxide (ITO), indium zinc oxide (IZO), tin oxide (SnO₂), and zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one of a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 °C to about 500 °C, a vacuum pressure of about 10⁻⁸ to about 10⁻³ torr, and a deposition rate of about 0 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may include at least one m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201 below, or a compound represented by Formula 202 below:

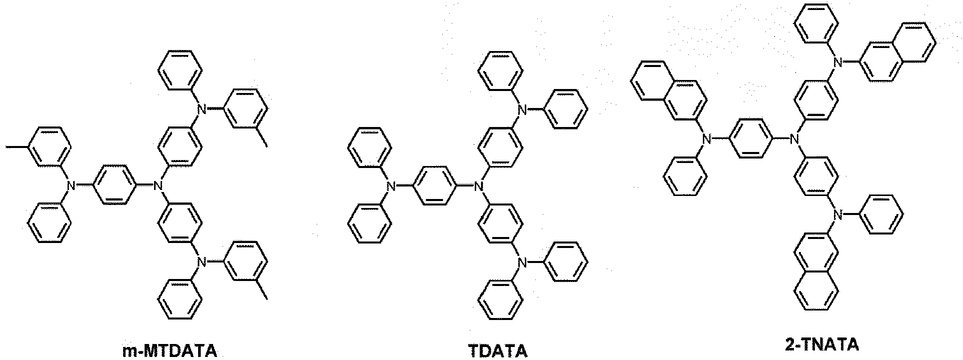

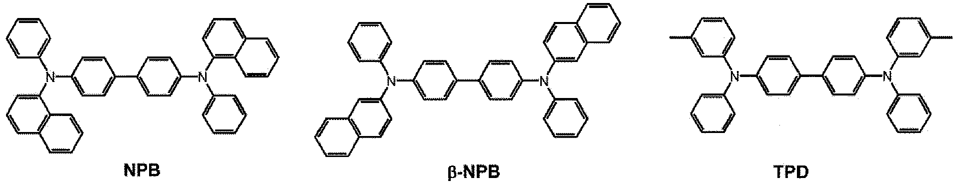

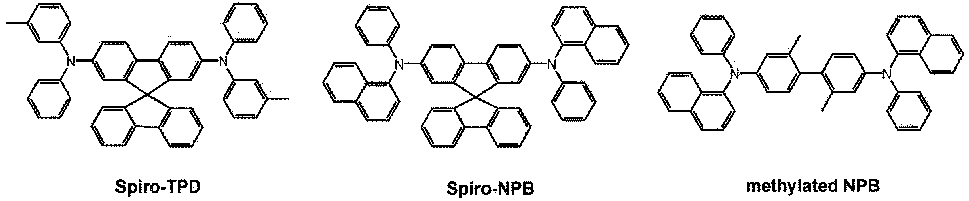

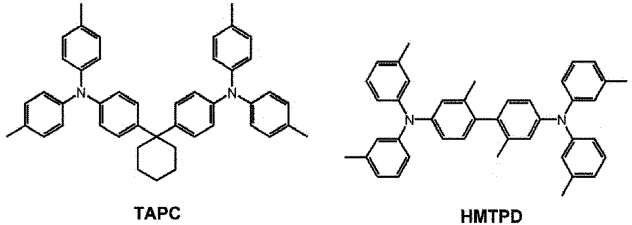

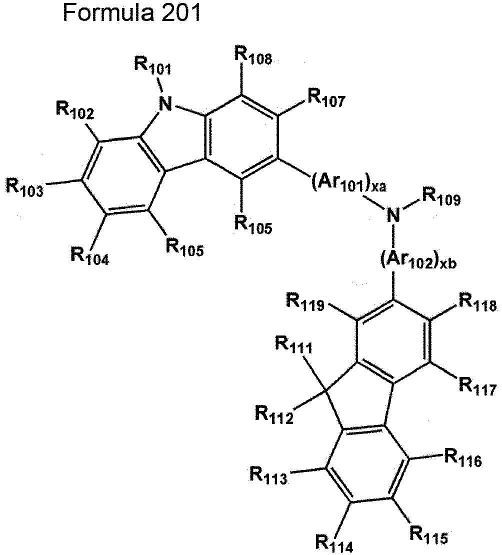

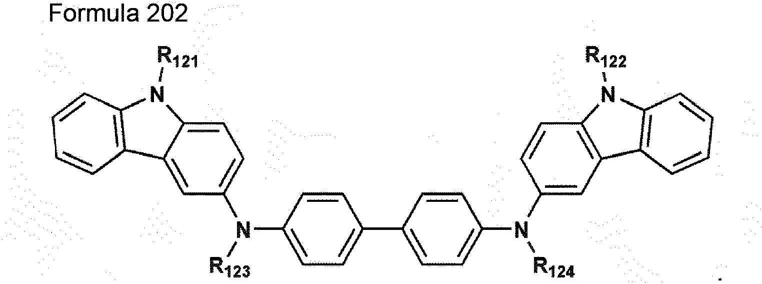

Ar₁₀₁ to Ar₁₀₂ in Formula 201 may each independently be:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one deuterium, -F, -Cl,-Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

The designations xa and xb in Formula 201 may each independently be an integer from 0 to 5, or 0, 1 or 2. For example, xa may be 1 and xb may be 0, but xa and xb are not limited thereto.

R₁₀₁ to R₁₀₈, R₁₁₁ to R₁₁₉, and R₁₂₁ to R₁₂₄ in Formulae 201 and 202 may each independently be:
hydrogen, deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), or a C₁-C₁₀ alkoxy group (for example, a methoxy group, an ethoxy group, a propoxy group, a butoxy group, a pentoxy group, etc.);
a C₁-C₁₀ alkyl group or a C₁-C₁₀ alkoxy group, each substituted with at least one deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, or any combination thereof;
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each substituted with at least one deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₁₀ alkyl group, or a C₁-C₁₀ alkoxy group, or any combination thereof, but embodiments of the present disclosure are not limited thereto.

R₁₀₉ in Formula 201 may be:
a phenyl group, a naphthyl group, an anthracenyl group, or a pyridinyl group; or
a phenyl group, a naphthyl group, an anthracenyl group, or a pyridinyl group, each substituted with at least one deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In one or more embodiments, the compound represented by Formula 201 may be represented by Formula 201A below, but embodiments of the present disclosure are not limited thereto:

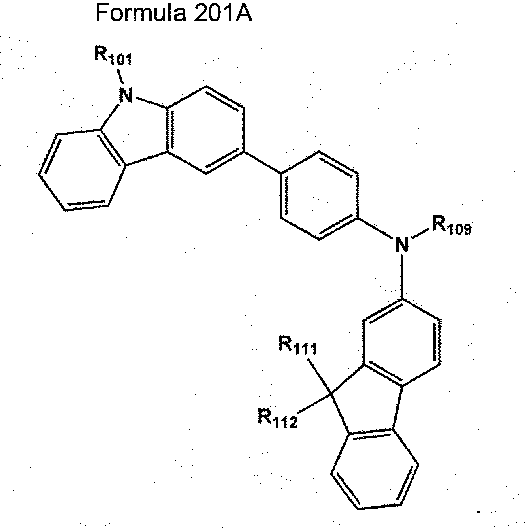

Detailed descriptions about R₁₀₁, R₁₁₁, R₁₁₂, and R₁₀₉ in Formula 201A are already described above.

For example, the compound represented by Formula 201, and the compound represented by Formula 202 may include Compounds HT1 to HT20 illustrated below, but are not limited thereto:

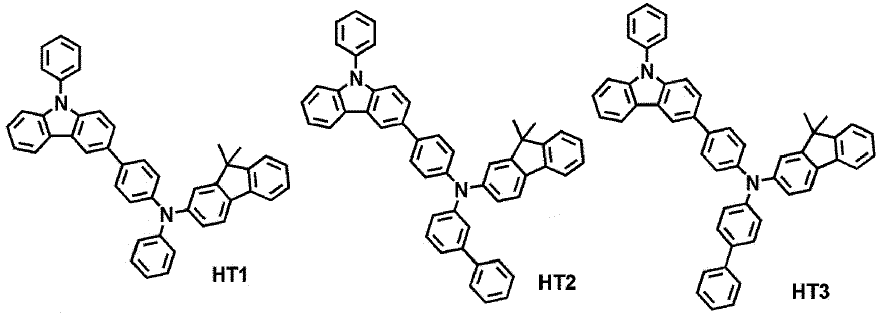

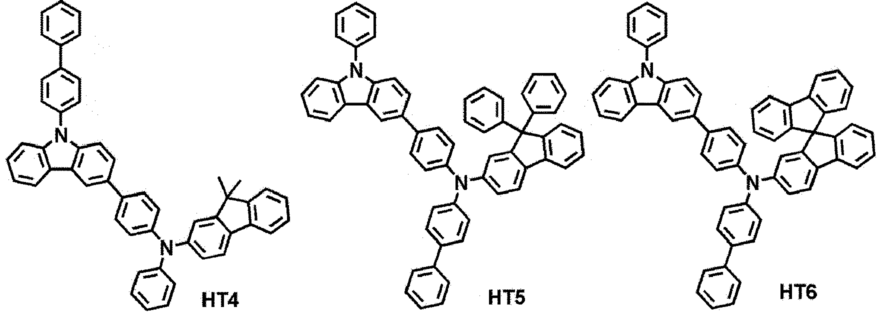

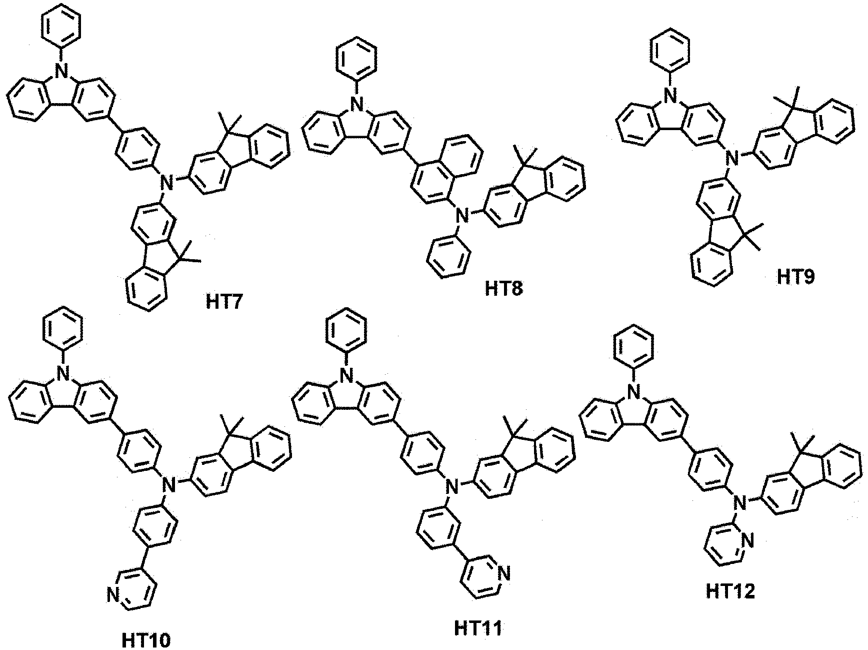

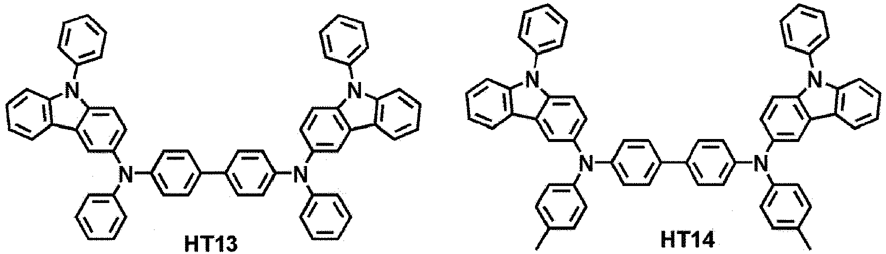

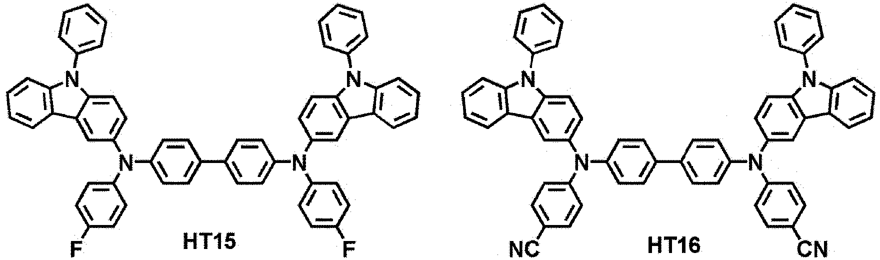

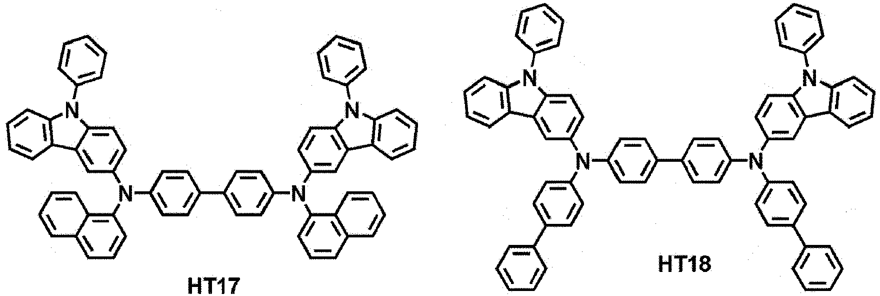

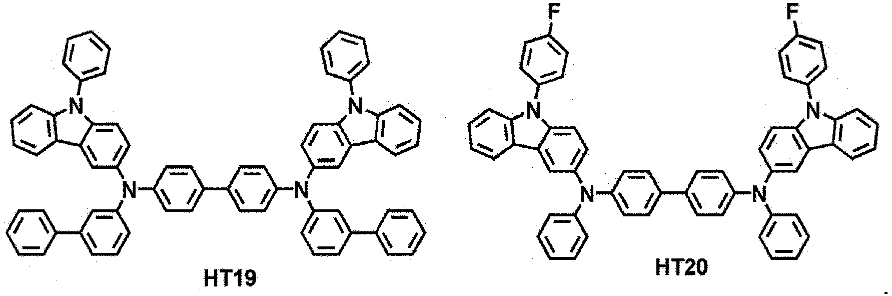

A thickness of the hole transport region may be from about 100 Å to about 10,000 Å, for example, about 100 Å to about 1,000 Å. When the hole transport region includes both a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one a quinone derivative, a metal oxide, or a cyano group-containing compound, but embodiments of the present disclosure are not limited thereto. Non-limiting examples of the p-dopant are a quinone derivative, such as tetracyanoquinodimethane (TCNQ) or 2,3,5,6-tetrafluoro-tetracyano-1,4-benzoquinonedimethane (F4-TCNQ); a metal oxide, such as a tungsten oxide or a molybdenum oxide; and a cyano group-containing compound, such as Compound HT-D1 or Compound HT-D2 below, but are not limited thereto:

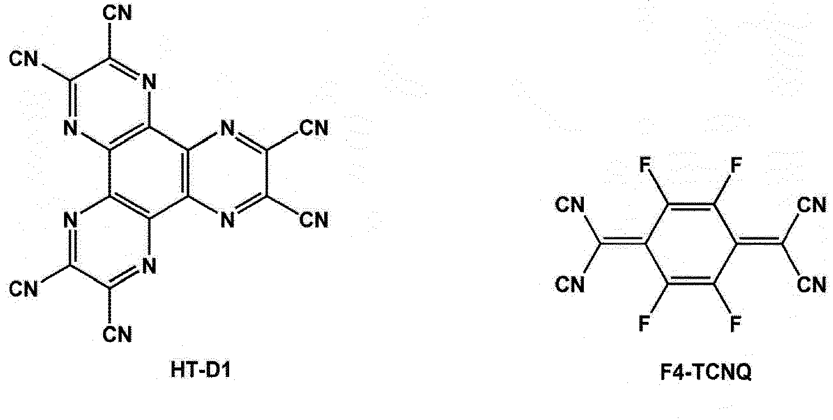

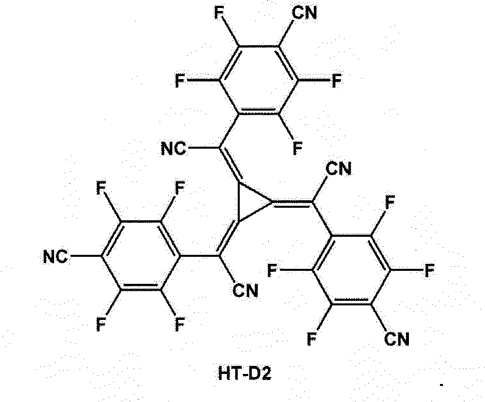

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one TPBi, TBADN, ADN (also referred to as "DNA"), CBP, CDBP, TCP, mCP, Compound H50, Compound H52, or any combination thereof:

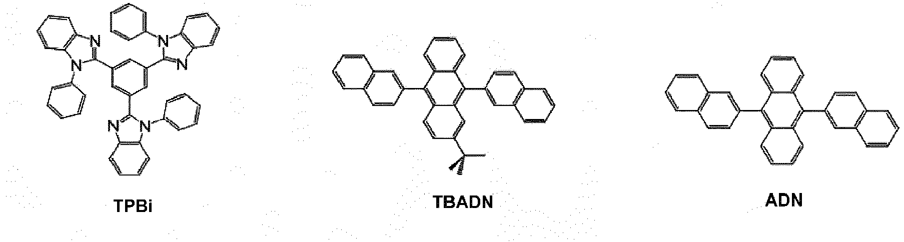

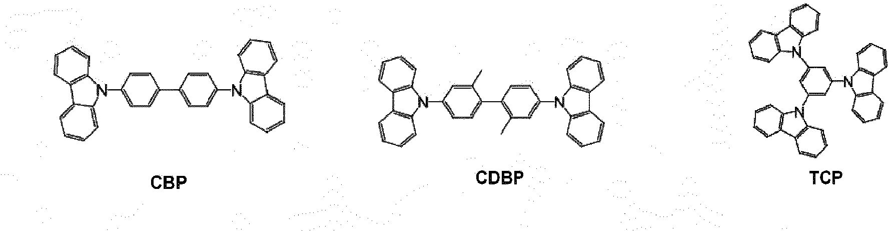

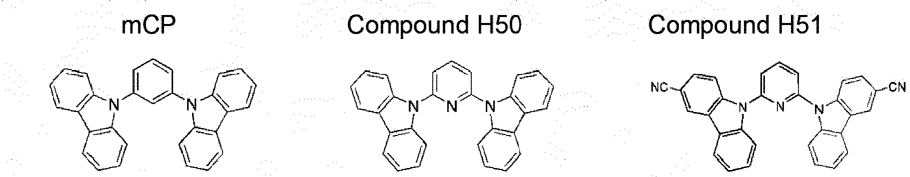

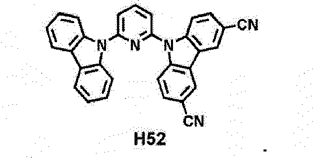

In one or more embodiments, the host may further include a compound represented by Formula 301 below: 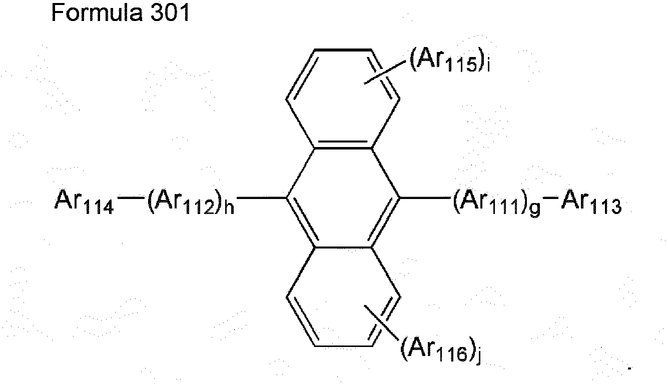
Ar₁₁₁ to Ar₁₁₂ in Formula 301 may each independently be:
   a phenylene group, a naphthylene group, a phenanthrenylene group, or a pyrenylene group; or
   a phenylene group, a naphthylene group, a phenanthrenylene group, or a pyrenylene group, each substituted with at least one a phenyl group, a naphthyl group, an anthracenyl group, or any combination thereof.
Ar₁₁₃ to Ar₁₁₆ in Formula 301 may each independently be:
   a C₁-C₁₀ alkyl group, a phenyl group, a naphthyl group, a phenanthrenyl group, or a pyrenyl group; or
   a phenyl group, a naphthyl group, a phenanthrenyl group, or a pyrenyl group, each substituted with at least one a phenyl group, a naphthyl group, an anthracenyl group, or any combination thereof.
The designations g, h, i, and j in Formula 301 may each independently be an integer from 0 to 4, and may be, for example, 0, 1, or 2.
Ar₁₁₃ to Ar₁₁₆ in Formula 301 may each independently be:
   a C₁-C₁₀ alkyl group, substituted with at least one phenyl group, naphthyl group, anthracenyl group, or any combination thereof;
   a phenyl group, a naphthyl group, an anthracenyl group, a pyrenyl, a phenanthrenyl group, or a fluorenyl group;
   a phenyl group, a naphthyl group, an anthracenyl group, a pyrenyl group, a phenanthrenyl group, or a fluorenyl group, each substituted with at least one deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, a fluorenyl group, 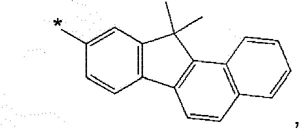 or a combination thereof,
   but embodiments of the present disclosure are not limited thereto.

In one or more embodiments, the host may include a compound represented by Formula 302 below:

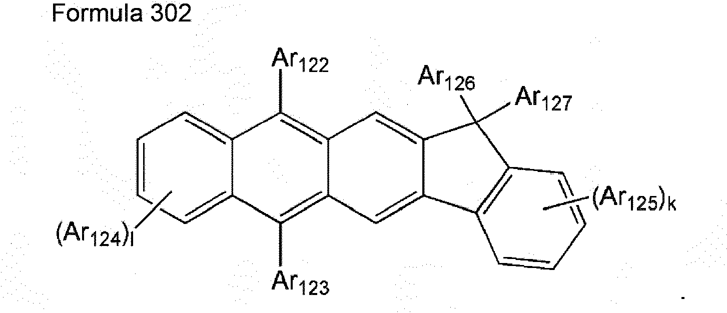

Ar₁₂₂ to Ar₁₂₅ in Formula 302 are the same as described in detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

The designations k and I in Formula 302 may each independently be an integer from 0 to 4. For example, k and I may be 0, 1, or 2.

The compound represented by Formula 301 and the compound represented by Formula 302 may include Compounds H1 to H42 below, but are not limited thereto:

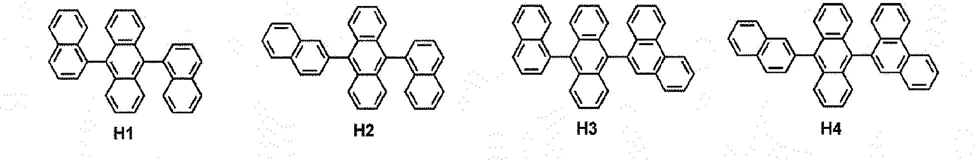

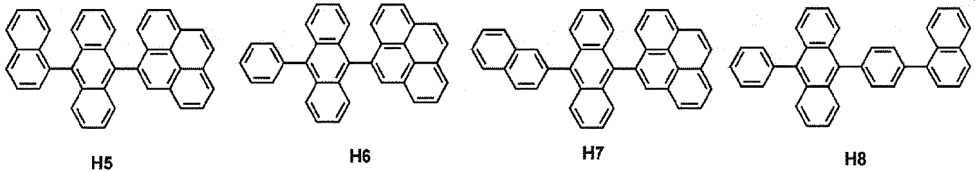

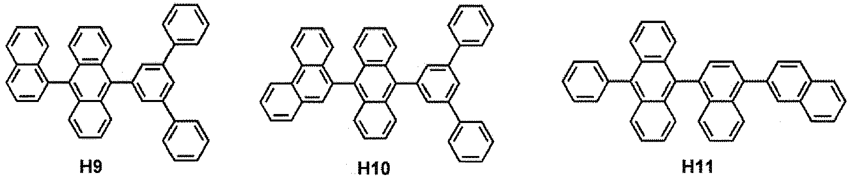

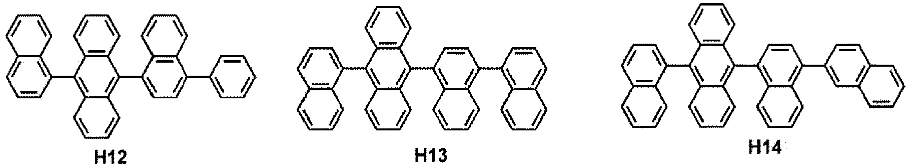

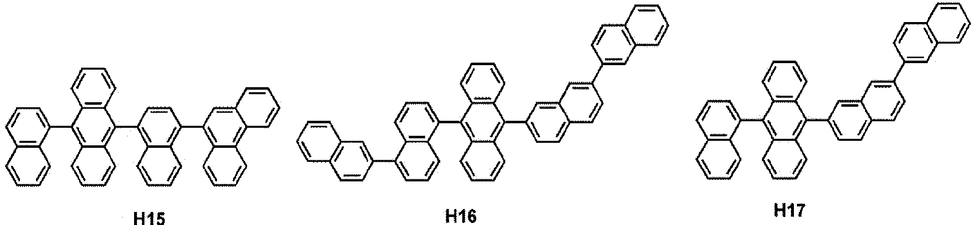

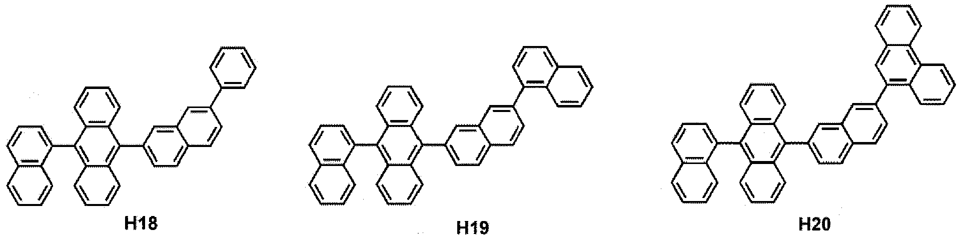

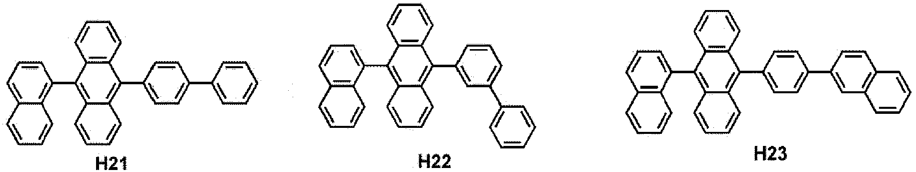

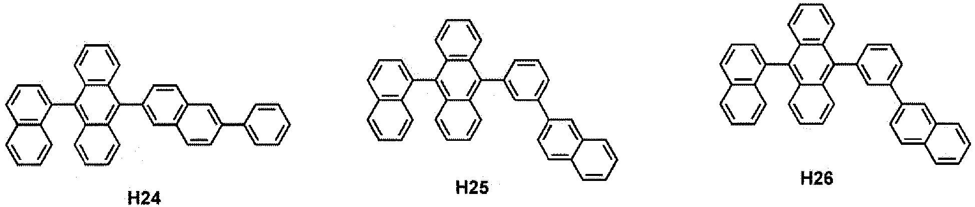

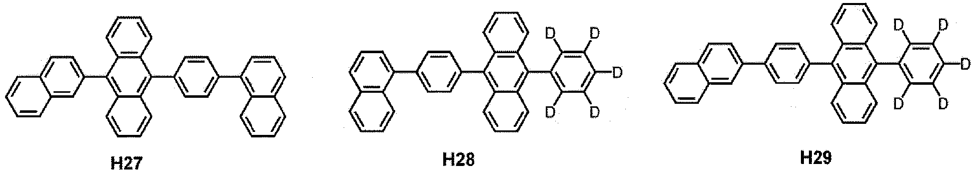

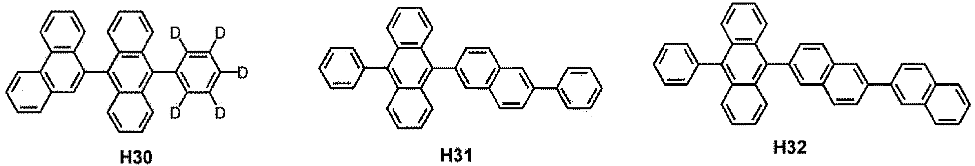

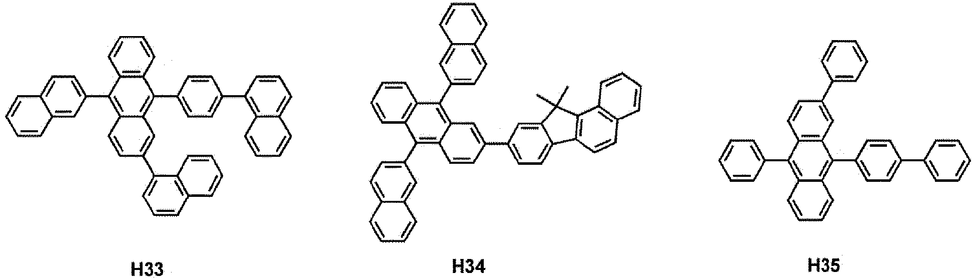

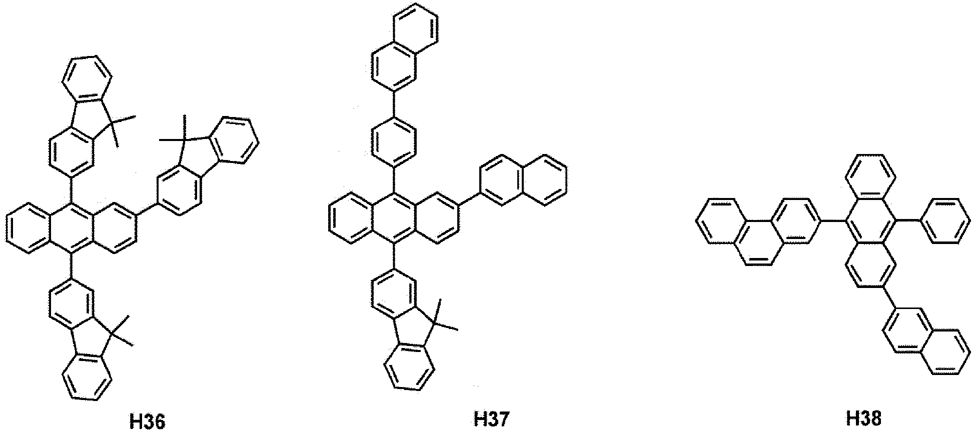

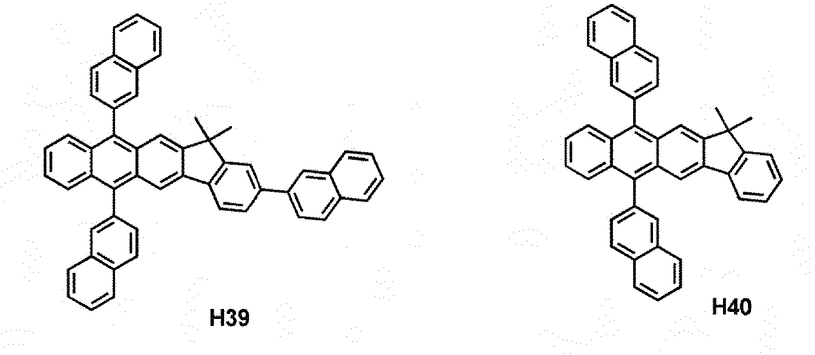

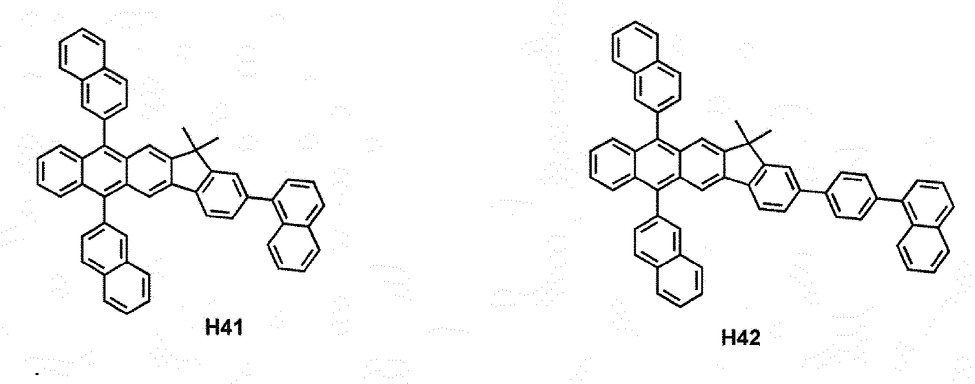

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be generally in a range of about 0.01 parts by weight to about 15 parts by weight based on 100 parts by weight of the host, but embodiments of the present disclosure are not limited thereto.

The dopant may include at least one of organometallic compounds represented by Formula 1.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include at least one a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, BAlq, or any combination thereof, but embodiments of the present disclosure are not limited thereto:

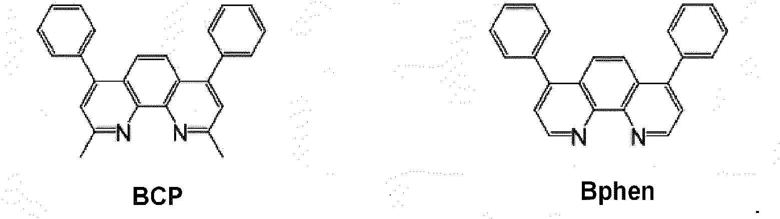

A thickness of the hole blocking layer may be from about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may further include at least one BCP, Bphen, Alq₃, BAlq, TAZ, NTAZ, or any combination thereof:

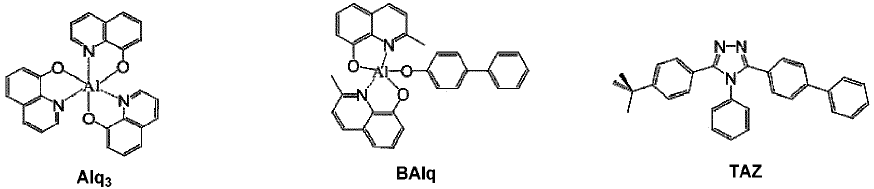

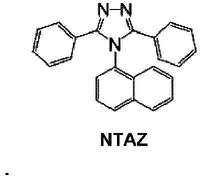

In one or more embodiments, the electron transport layer may include at least one of ET1 and ET25, but are not limited thereto:

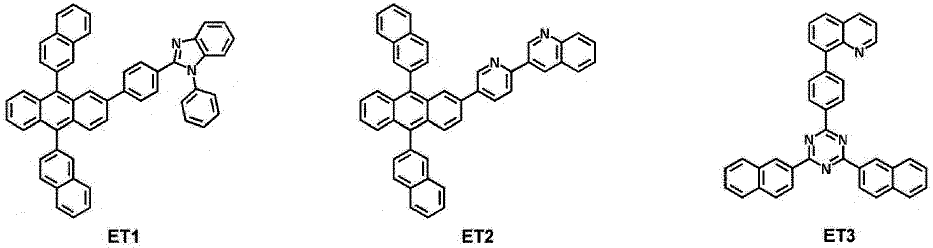

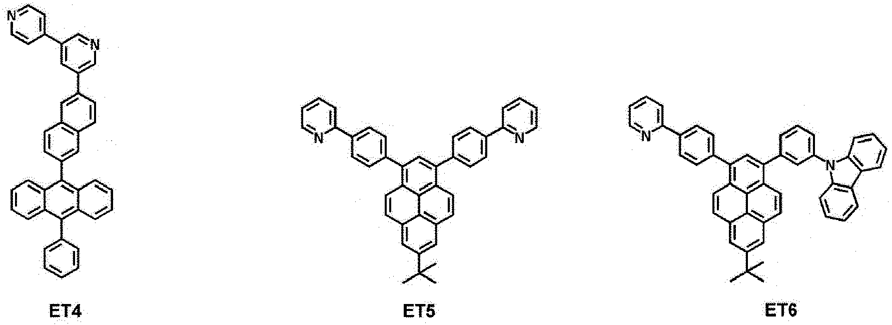

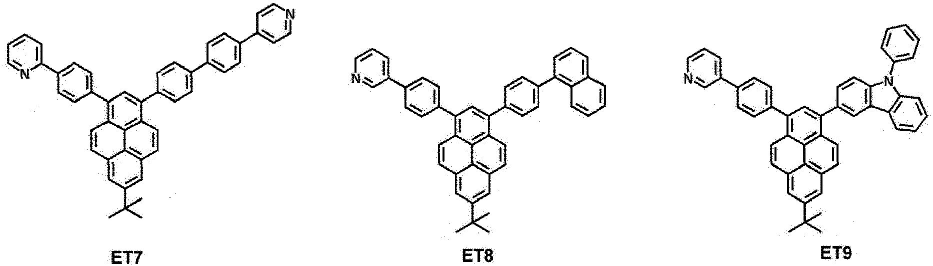

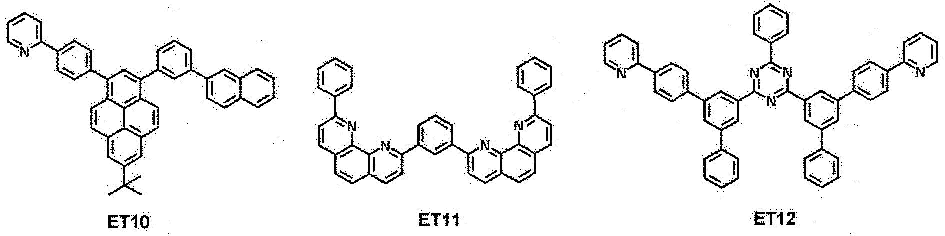

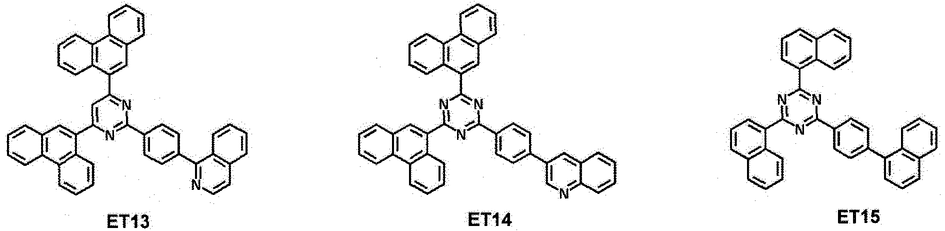

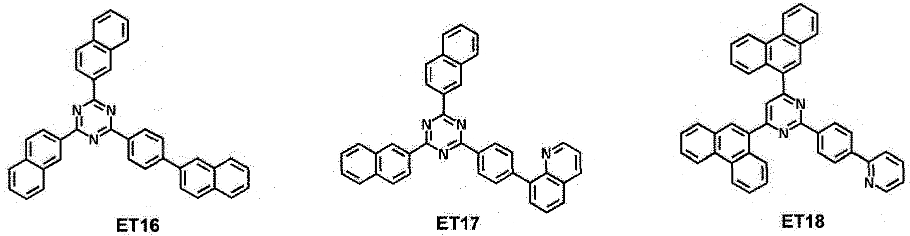

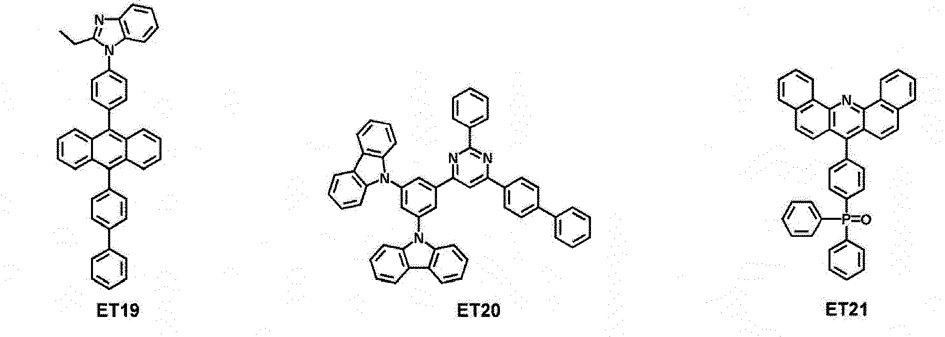

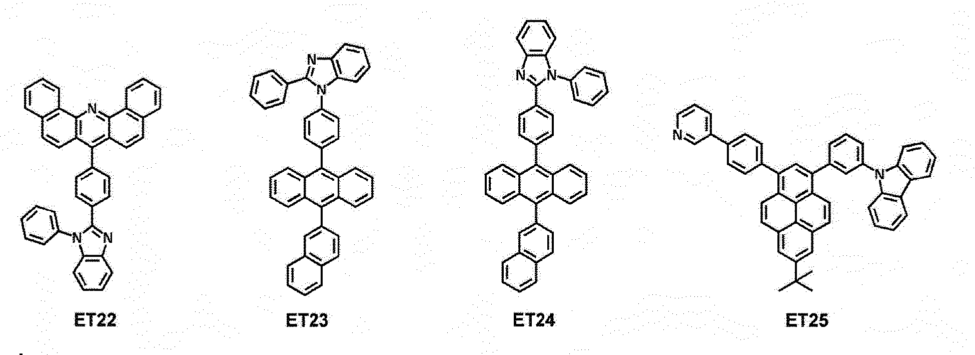

A thickness of the electron transport layer may be from about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2:

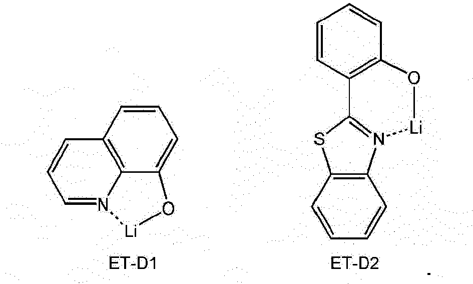

The electron transport region may include an electron injection layer that promotes flow of electrons from the second electrode 19 thereinto.

The electron injection layer may include at least one LiF, NaCl, CsF, Li₂O, BaO, or any combination thereof.

A thickness of the electron injection layer may be in a range of about 1 Å to about 100 Å, for example, about 3 Å to about 90 Å. When a thickness of the electron injection layer is within these ranges, satisfactory electron injection characteristics may be obtained without substantial increase in driving voltage.

The second electrode 19 is disposed on the organic layer 15. The second electrode 19 may be a cathode. A material for forming the second electrode 19 may be metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device according to an embodiment has been described in connection with FIGURE.

The term "first-row transition metal of the Periodic Table of Elements" as used herein refers to a period 4 element of the Periodic Table of Elements while being included in d-block. Examples of the first-row transition metal of the Periodic Table of Elements may include scandium (Sc), titanium (Ti), vanadium (V), chromium (Cr), manganese(Mn), iron (Fe), cobalt (Co), nickel (Ni), copper (Cu), or zinc (Zn).

The term "second-row transition of the Periodic Table of Elements" as used herein refers to a period 5 element of the Periodic Table of Elements while being included in d-block. Examples of the second-row transition of the Periodic Table of Elements may include yttrium (Y), zirconium (Zr), niobium (Nb), molybdenum (Mo), technetium (Tc), ruthenium (Ru), rhodium (Rh), palladium (Pd), silver (Ag), or cadmium (Cd).

The term "third-row transition of the Periodic Table of Elements" as used herein refers to a period 6 element of the Periodic Table of Elements while being included in d-block and f-block. Examples of the third-row transition of the Periodic Table of Elements may include lanthanum (La), Samarium (Sm), europium (Eu), terbium (Tb), thulium (Tm), ytterbium (Yb), lutetium (Lu), hafnium (Hf), tantalum (Ta), tungsten (W), rhenium (Re), osmium (Os), iridium (Ir), platinum (Pr), gold (Au), or mercury (Hg).

The term "C₁-C₆₀ alkyl group" as used herein refers to a linear or branched aliphatic saturated hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₂-C₆₀ alkenyl group" as used herein refers to a hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group having at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one N, O, P, Si, B, Se, Ge, or S as a ring-forming atom and 1 to 10 carbon atoms, and non-limiting examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one N, O, P, Si, B, Se, Ge, or S as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₇-C₆₀ alkylaryl group" as used herein refers to a arylene group, substituted with an alkyl group. A non-limiting example is a benzene ring substituted with a methyl group.

The term "C₁-C₆₀ heteroaryl group" as used herein refers to a monovalent group having a carbocyclic aromatic system that has at least one N, O, P, Si, B, Se, Ge, or S as a ring-forming atom, in addition to 1 to 60 carbon atoms. The term "C₁-C₆₀ heteroarylene group" as used herein refers to a divalent group having a carbocyclic aromatic system that has at least one heteroatom N, O, P, B, Se, Ge, or S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₂-C₆₀ alkylheteroaryl group" as used herein refers to a heteroarylene group, substituted with an alkyl group. A non-limiting example is a pyridine ring substituted with a methyl group.

The term "C₆-C₆₀ aryloxy group" used herein indicates -OA₁₀₂ (wherein A₁₀₂ is the C₆-C₆₀ aryl group), and a C₆-C₆₀ arylthio group used herein indicates -SA₁₀₃ (wherein A₁₀₃ is the C₆-C₆₀ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom N, O, P, Si, B, Se, Ge, or S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The term "C₅-C₃₀ carbocyclic group" as used herein refers to a monocyclic group or a polycyclic group, and, according to its chemical structure, a monovalent, divalent, trivalent, tetravalent, pentavalent, or hexavalent group.

The term "C₁-C₃₀ heterocyclic group" as used herein refers to a saturated or unsaturated cyclic group having, as a ring-forming atom, at least one heteroatom N, O, Si, P, B, Se, Ge, or S other than 1 to 30 carbon atoms. The term "C₁-C₃₀ heterocyclic group" as used herein refers to a monocyclic group or a polycyclic group, and, according to its chemical structure, a monovalent, divalent, trivalent, tetravalent, pentavalent, or hexavalent group.

In the present specification, at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with at least one deuterium, -F, -CI, - Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₈), -B(Q₁₆)(Q₁₇), - P(=O)(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each substituted with at least one deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), - P(=O)(Q₂₈)(Q₂₉), or any combination thereof; or
-N(Q₃₁)(Q₃₂), -Si(Q₃₃)(Q₃₄)(Q₃₅), -B(Q₃₆)(Q₃₇), or -P(=O)(Q₃₈)(Q₃₉), and
Q1 to Q₉, Q₁₁ to Q₁₉, Q₂₁ to Q₂₉, and Q₃₁ to Q₃₉ may each independently be hydrogen, deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one C₁-C₆₀ alkyl group, a C₆-C₆₀ aryl group, or a combination thereof, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording " 'B' was used instead of 'A' " used in describing Synthesis Examples means that a molar equivalent of 'A' was identical to a molar equivalent of 'B'.

### Examples

### Synthesis Example 1: Synthesis of Compound 1

Compound 1 was synthesized according to the following Scheme 1.

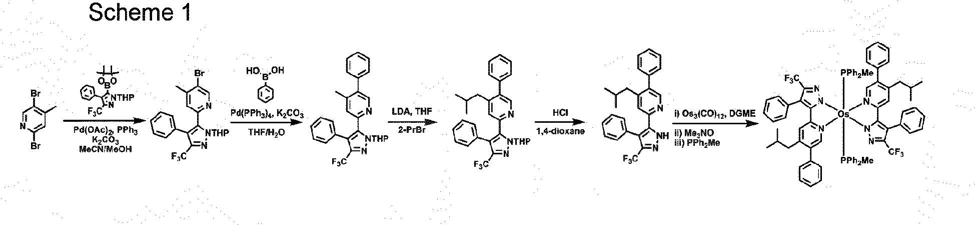

### Synthesis Example 2: Synthesis of Compound 4

Compound 4 was synthesized according to the following Scheme 2.

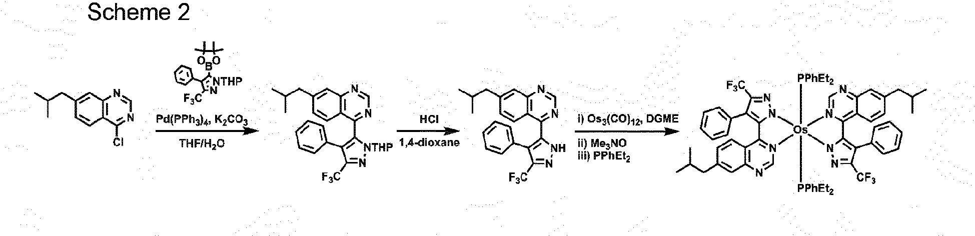

### Example 1

A glass substrate, on which a 1,500 Å ITO electrode (first electrode, anode) was formed, was sonicated with distilled water ultrasonic waves. After the distilled water cleaning was completed, the glass substrate was sonicated by sequentially using isopropyl alcohol, acetone, and methanol, dried, and then transferred to a plasma cleaner. The glass substrate was cleaned for 5 minutes by using oxygen plasma and was then provided to a vacuum deposition apparatus.
Compound HT3 was vacuum-deposited on the ITO electrode of the glass substrate to form a first hole injection layer having a thickness of 3,500 Å, Compound HT-D1 was vacuum-deposited on the first hole injection layer to form a second hole injection layer having a thickness of 300 Å, and TAPC was vacuum-deposited on the second hole injection layer to form an electron blocking layer having a thickness of 100 Å, thereby forming a hole transport region.
Compound H52 (host) and Compound 1 (dopant, 2 wt%) were co-deposited on the hole transport region to form an emission layer having a thickness of 300 Å.
Compound ET3 was vacuum-deposited on the emission layer to form an electron transport layer having a thickness of 250 Å, ET-D1 (LiQ) was deposited on the electron transport layer to form an electron injection layer having a thickness of 5 Å, and Al was deposited on the electron injection layer to form a second electrode (cathode) having a thickness of 1,000 Å, thereby completing the manufacture of an organic light-emitting device.

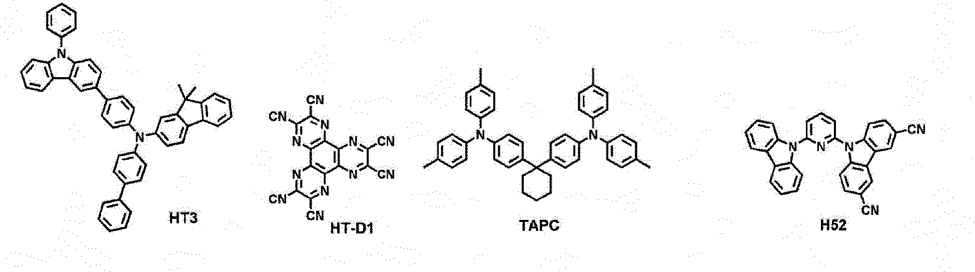

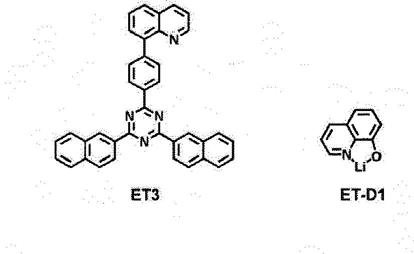

### Comparative Examples 1 to 3

Organic light-emitting devices were manufactured in the same manner as in Example 1, except that Compounds shown in Table 2 were each used instead of Compound 1 as a dopant in forming an emission layer.

### Evaluation Example 5: Evaluation of characteristics of organic light-emitting devices

The EL spectrum, change in current density according to a voltage, change in luminance according to a voltage, efficiency, conversion efficiency, external quantum efficiency, roll-off, lifespan, CIE color coordinates of the organic light-emitting devices manufactured according to Example 1 and Comparative Examples 1 to 3 were measured. Detailed measuring methods are as follows, and results are shown in Table 2 and FIGURE.

### (1) Measurement of EL spectrum

For the manufactured organic light-emitting devices, the EL spectrum was measured at a luminance of 500 cd/m² by using a luminance meter (Minolta Cs-1000A), and results thereof were obtained.

### (2) Measurement of change in current density according to voltage

For the manufactured organic light-emitting devices, a current value flowing through a unit element was manufactured by using a current-voltage meter (Keithley 2400) while increasing a voltage from 0 V to 10 V, and results were obtained by dividing the measured current value by an area.

### (3) Measurement of change in luminance according to voltage

For the manufactured organic light-emitting devices, the luminance was measured by using a luminance meter (Minolta Cs-1000A) while increasing a voltage from 0 V to 10 V, and results thereof were obtained.

### (4) Measurement of conversion efficiency

The current density (cd/A) of the same current density (10 mA/cm²) was measured by using the current density and the luminance measured in (2) and (3) and the voltage. Then, the conversion efficiency was calculated by dividing the current efficiency by an x value of the CIE color coordinates measured in (6).

### (5) Measurement of lifespan

An amount of time that lapsed when the luminance measured in (3) was 95 % (T₉₅) and 50 % (T₅₀) of initial luminance (100 %) was calculated.

### (6) Measurement of CIE color coordinates

For the manufactured organic light-emitting devices, the CIE color coordinates were obtained by measuring the EL spectrum when the luminance was 500 cd/m² by using a luminance meter (Minolta Cs-1000A).

### (7) Measurement of roll-off

For the manufactured organic light-emitting devices, 1-(EQE/EQEₘₐₓ) was calculated to obtain a roll-off value. EQEₘₐₓ is a maximum EQE.

**Table 2**

| No. | Dopant | Current density (mA/cm²) | Luminance (cd/m²) | Efficiency (cd/A) | Conversion efficiency | Maximum efficiency (cd/A) | EQE (%) | Maximum EQE (%) | EL (nm) | Roll-off (%) | Color coordinates (x, y) |
|---|---|---|---|---|---|---|---|---|---|---|---|
| Example 1 | Compound 1 | 5.2 | 1500 | 28.6 | 42.8 | 30.8 | 25.0 | 27.4 | 623 | 7% | 0.647, 0.351 |
| Comparative Example 1 | Compound A | 5.9 | 1500 | 25.6 | 38.8 | 27.6 | 21.9 | 24.1 | 619 | 7% | 0.643, 0.354 |
| Comparative Example 2 | Compound B | 6.1 | 1500 | 26.4 | 37.2 | 24.8 | 19.4 | 23.2 | 624 | 11% | 0.648, 0.349 |
| Comparative Example 3 | Compound C | 5.0 | 1500 | 30.2 | 45.5 | 32.8 | 22.2 | 24.6 | 616 | 8% | 0.633, 0.364 |

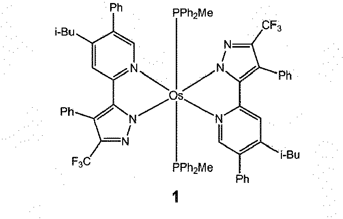

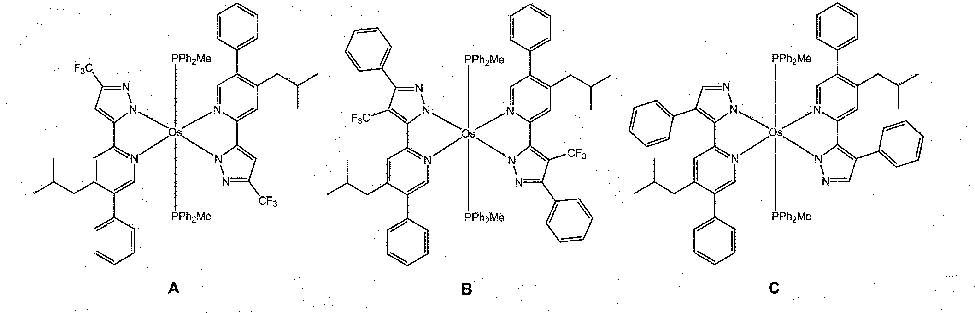

From Table 2, it is confirmed that the organic light-emitting device of Example 1 has improved characteristics, as compared with the organic light-emitting devices of Comparative Examples 1 to 3.

Since the organometallic compound has improved electric characteristics and/or thermal stability, the organic light-emitting device including the organometallic compound may have improved driving voltage, current density, efficiency, power, color purity, and lifespan characteristics.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. An organometallic compound represented by Formula 1: 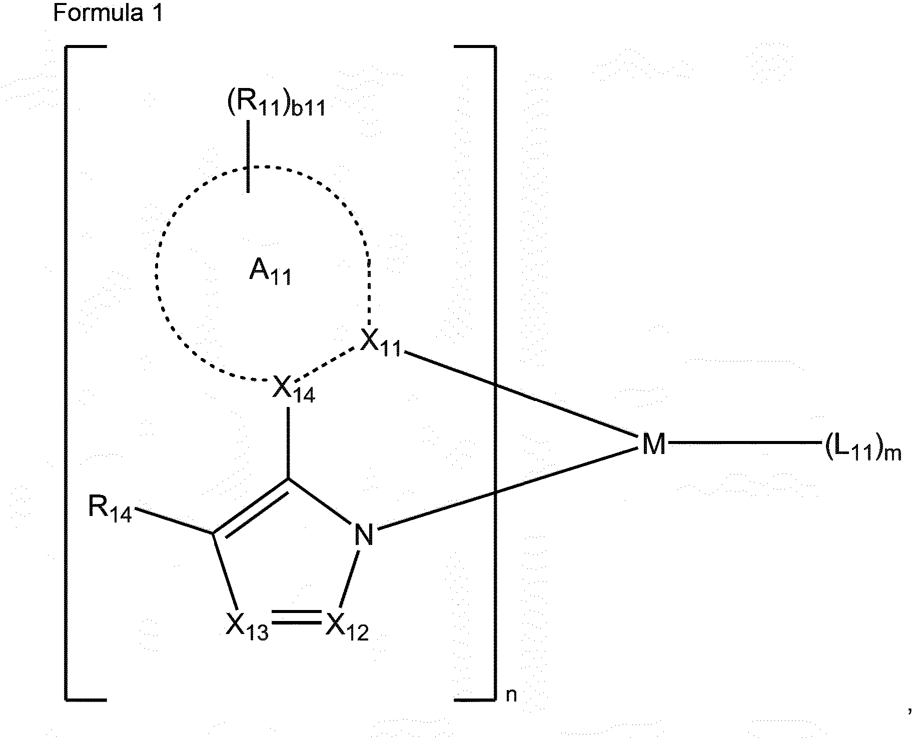 wherein, in Formula 1,
M is a first-row transition metal, a second-row transition metal, or a third-row transition metal of the Periodic Table of Elements,
X₁₁ is N or C, and a bond between X₁₁ and M is a coordinate bond,
X₁₂ is N or C(R₁₂),
X₁₃ is N or C(R₁₃), wherein X₁₂ and X₁₃ are not N at the same time,
X₁₄ is N or C, and a bond between X₁₁ and X₁₄ is a single bond or a double bond,
A₁₁ is a C₅-C₆₀ carbocyclic group or a C₁-C₆₀ heterocyclic group,
R₁₁ is hydrogen, deuterium, -F, -CI, -Br, -I, -SF₅, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, - Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), or -P(=S)(Q₁)(Q₂), wherein two neighboring R₁₁(s) are optionally linked to each other to form a substituted or unsubstituted C₅-C₃₀ carbocyclic group or a substituted or unsubstituted C₁-C₃₀ heterocyclic group,
R₁₂ and R₁₃ are each independently:
-F, -CI, -Br, -I, a cyano group, or a nitro group; or
a C₁-C₆₀ alkyl group substituted with at least one -F, -CI, -Br, -I, a cyano group, a nitro group, or any combination thereof,
R₁₄ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
b11 is 1, 2, 3, 4, 5, 6, 7, or 8,
Q₁ to Q₃ are each independently hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₂-C₆₀ alkylheteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one deuterium, -F, a cyano group, a C₁-C₆₀ alkyl group, a C₆-C₆₀ aryl group, or any combination thereof, or a C₆-C₆₀ aryl group substituted with at least one deuterium, -F, a cyano group, a C₁-C₆₀ alkyl group, a C₆-C₆₀ aryl group, or any combination thereof,
n is 1, 2, or 3,
L₁₁ is a monodentate ligand, a bidentate ligand, or a tridentate ligand, and
m is 0, 1, 2, 3, 4, or 5.

2. The organometallic compound of claim 1, wherein
M is platinum, palladium, copper, silver, gold, rhodium, iridium, ruthenium, osmium, titanium, zirconium, hafnium, europium, terbium, or thulium;
preferably wherein
M is Ru or Os.

3. The organometallic compound of claims 1 or 2, wherein
X₁₂ is N and X₁₃ is C(R₁₃); or
X₁₂ is C(R₁₂) and X₁₃ is N.

4. The organometallic compound of any of claims 1-3, wherein
X₁₂ is N and X₁₃ is C(R₁₃).

5. The organometallic compound of any of claims 1-4, wherein
a moiety represented by 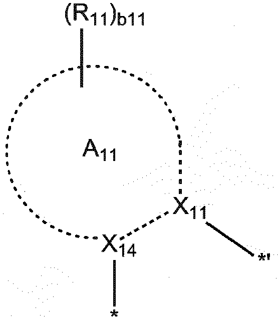 (wherein *' indicates a binding site to M, and * indicates a binding site to a carbon atom) is represented by one of Formulae 2-1 to 2-17: 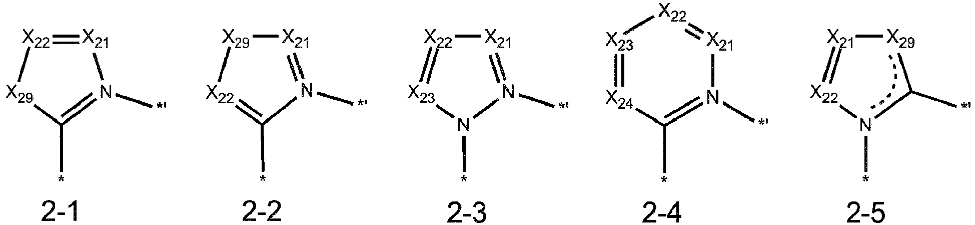 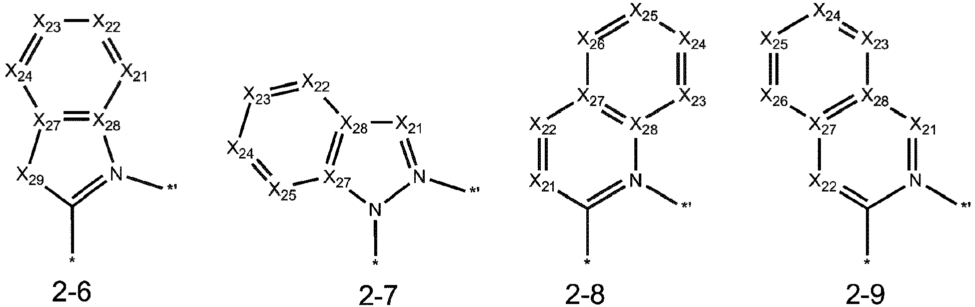 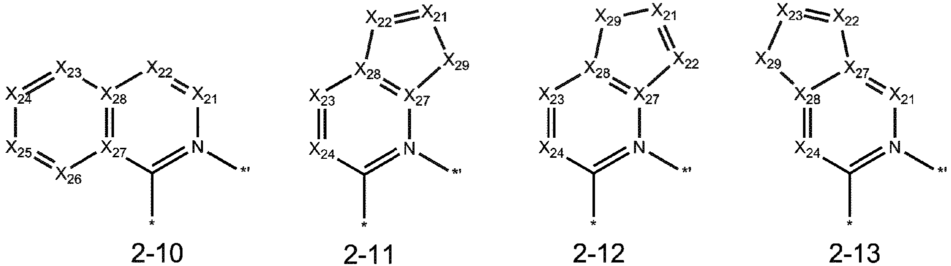 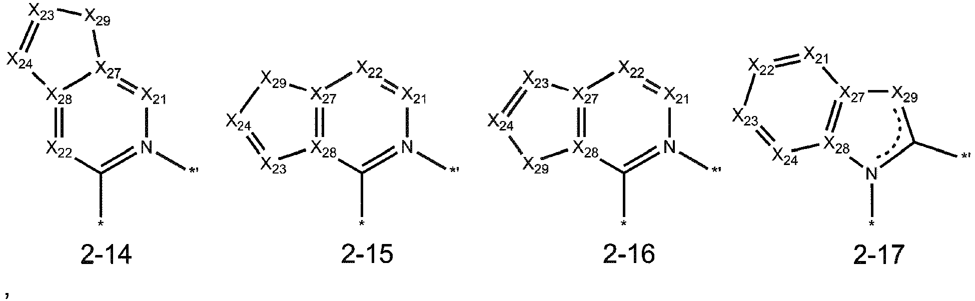 wherein, in Formulae 2-1 to 2-17,
X₂₁ is N or C(R₂₁), X₂₂ is N or C(R₂₂), X₂₃ is N or C(R₂₃), X₂₄ is N or C(R₂₄), X₂₅ is N or C(R₂₅), and X₂₆ is N or C(R₂₆),
X₂₇ and X₂₈ are each independently N or C,
X₂₉ is O, S, N(R₂₉), or C(R₂₉)(R₃₀),
R₂₁ to R₂₆, R₂₉, and R₃₀ are each independently the same as described in connection with R₁₁ in Formula 1 of claim 1,
* indicates a binding site to a carbon atom, and
*' indicates a binding site to M.

6. The organometallic compound of any of claims 1-5, wherein
a moiety represented by 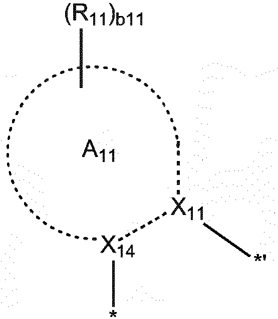 (wherein *' indicates a binding site to M, and * indicates a binding site to a carbon atom) is represented by one of Formulae 3-1 to 3-54: 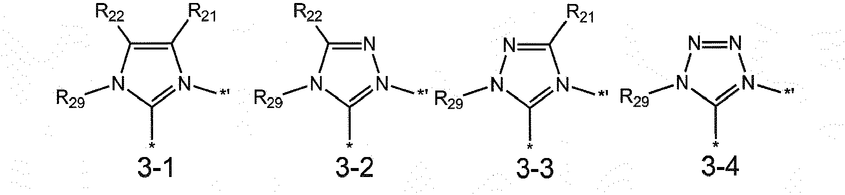 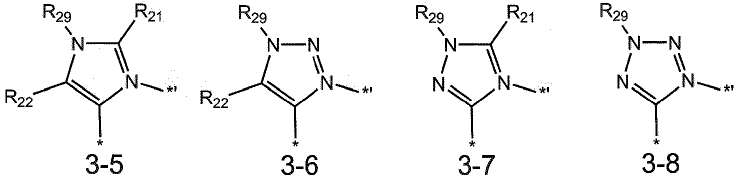 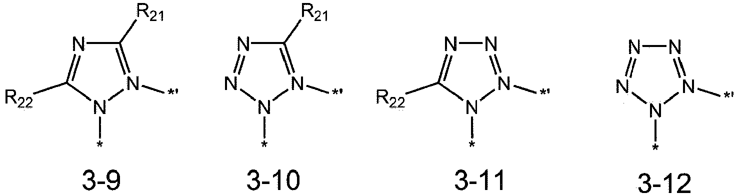 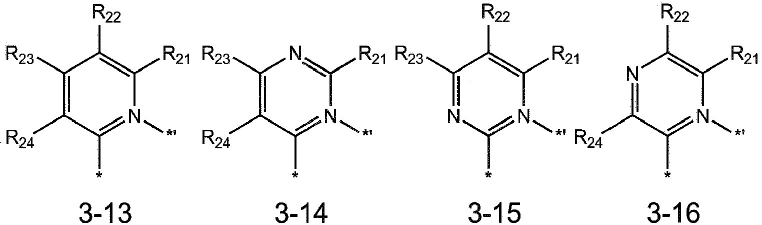 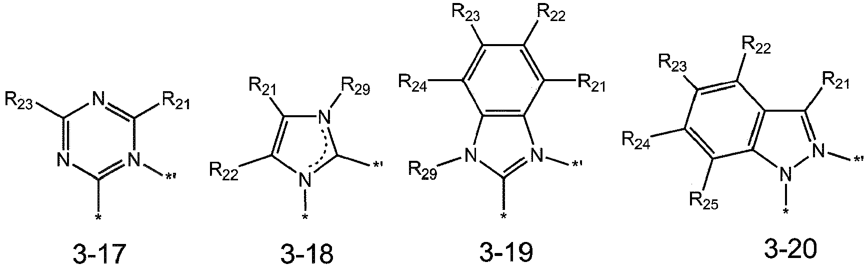 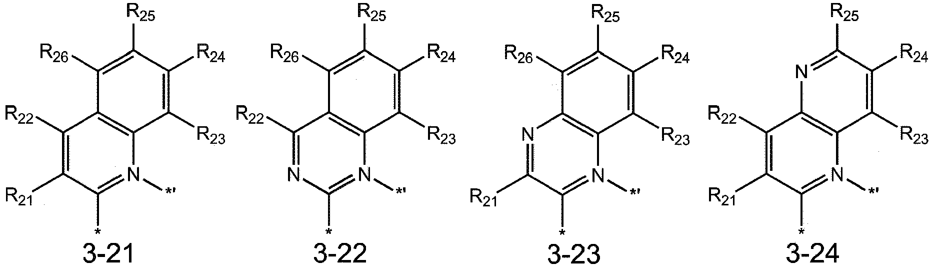 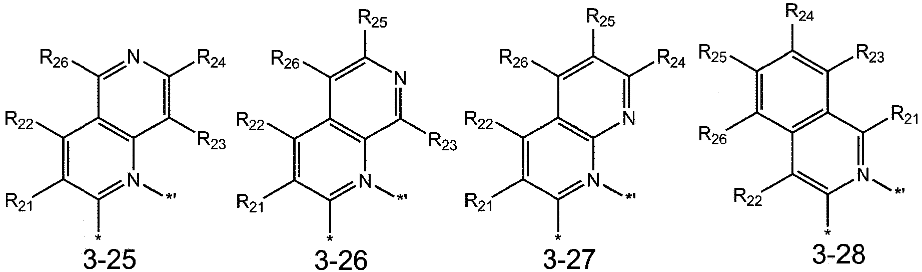 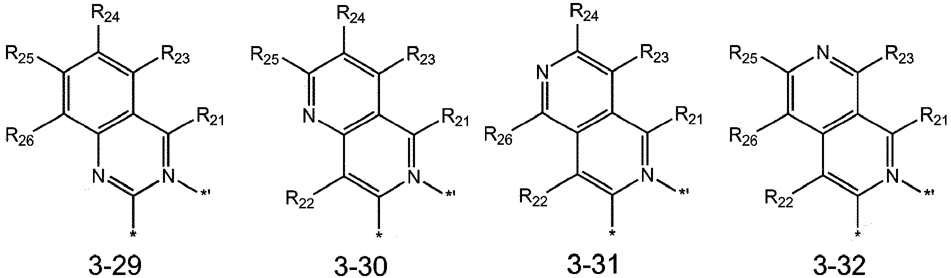 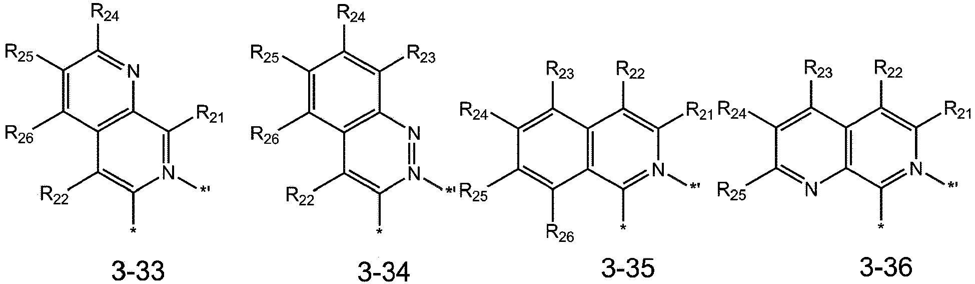 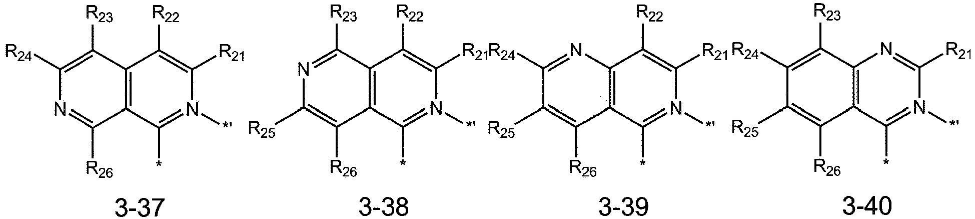 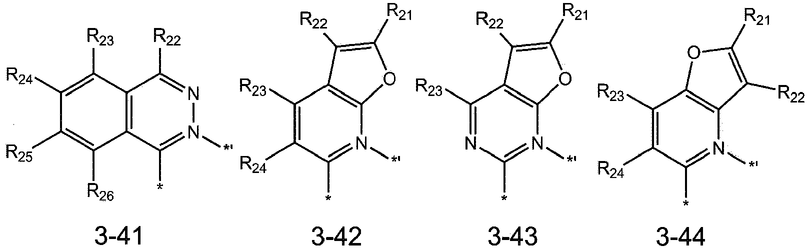 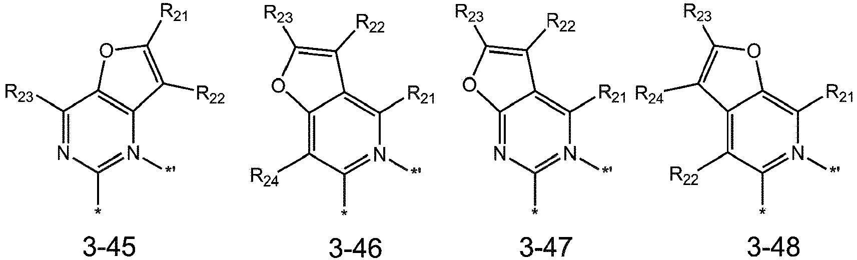 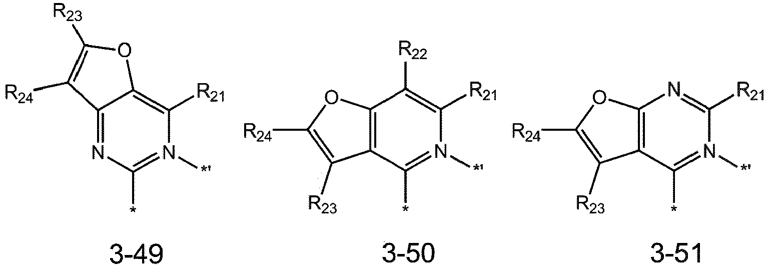 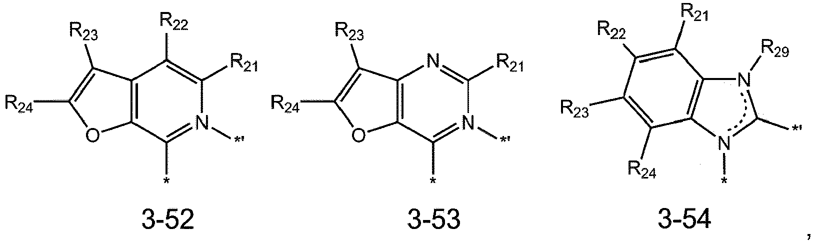 wherein, in Formulae 3-1 to 3-54,
R₂₁ to R₂₆, R₂₉, and R₃₀ are each independently the same as described in connection with R₁₁ in Formula 1 in claim 1,
* indicates a binding site to a carbon atom, and
*' indicates a binding site to M.

7. The organometallic compound of any of claims 1-6, wherein
R₁₁ is:
hydrogen, deuterium, -F, -CI, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, -SF₅, C₁-C₂₀ alkyl group, or a C₁-C₂₀ alkoxy group;
a C₁-C₂₀ alkyl group or a C₁-C₂₀ alkoxy group, each substituted with at least one deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a pyridinyl group, a pyrimidinyl group, or any combination thereof;
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with at least one deuterium, -F, -CI, -Br, -I, -CD₃, -CD₂H, -CDH₂, - CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, -Si(Q₃₃)(Q₃₄)(Q₃₅), or any combination thereof; or
-N(Q₁)(Q₂), -Si(Q₃)(Q₄)(Q₅), -B(Q₆)(Q₇), or -P(=O)(Q₈)(Q₉), and
Q₁ to Q₉ and Q₃₃ to Q₃₅ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one deuterium, a C₁-C₁₀ alkyl group, a phenyl group, or any combination thereof.

8. The organometallic compound of any of claims 1-7, wherein
R₁₂ and R₁₃ are each independently:
-F, -CI, or a cyano group; or
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with at least one -F, -CI, a cyano group, or any combination thereof.

9. The organometallic compound of any of claims 1-8, wherein
R₁₂ and R₁₃ are each independently:
-F or a cyano group; or
a methyl group, an ethyl group, an n-propyl group, an isopropyl group, an n-butyl group, an isobutyl group, a sec-butyl group, or a tert-butyl group, each substituted with at least one -F, a cyano group, or any combination thereof;
preferably wherein
R₁₂ and R₁₃ are each independently -F, a cyano group, -CF₃, or any combination thereof.

10. The organometallic compound of any of claims 1-9, wherein
R₁₄ is:
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an oxazolyl group, a pyridinyl group, a pyrazinyl group, a pyrimidinyl group, an indolyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoxazolyl group, a triazolyl group, a tetrazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group; or
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an oxazolyl group, a pyridinyl group, a pyrazinyl group, a pyrimidinyl group, an indolyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoxazolyl group, a triazolyl group, a tetrazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with at least one deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantyl group, a norbornyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, -Si(Q₃₃)(Q₃₄)(Q₃₅), or any combination thereof, and
Q33 to Q₃₅ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one deuterium, a C₁-C₁₀ alkyl group, a phenyl group, or any combination thereof; or
wherein
R₁₄ is:
a phenyl group, a naphthyl group, a fluorenyl group, a phenanthrenyl group, an anthracenyl group, a benzofuranyl group, a benzothiophenyl group, a benzoxazolyl group, a dibenzofuranyl group, a dibenzothiophenyl group, or a dibenzosilolyl group; and
a phenyl group, a naphthyl group, a fluorenyl group, a phenanthrenyl group, an anthracenyl group, a benzofuranyl group, a benzothiophenyl group, a benzoxazolyl group, a dibenzofuranyl group, a dibenzothiophenyl group, or a dibenzosilolyl group, each substituted with at least one deuterium, -F, -CI, -Br, -I, - CD₃, -CD₂H, -CDH₂, -CF₃, -CF₂H, -CFH₂, a methyl group, an ethyl group, an n-propyl group, an isopropyl group, an n-butyl group, an isobutyl group, a sec-butyl group, a tert-butyl group, a methoxy group, an ethoxy group, a propoxy group, a butoxy group, a cyclopentyl group, a cyclohexyl group, a phenyl group, a naphthyl group, - Si(Q33)(Q34)(Q35), or any combination thereof, and
Q33 to Q₃₅ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, or a tert-butyl group; or
an n-propyl group, an isopropyl group, an n-butyl group, an isobutyl group, a sec-butyl group, or a tert-butyl group, each substituted with deuterium; or
wherein
R₁₄ is Formulae 10-17 to 10-100, 10-175 to 10-222, 10-247, and 10-248: 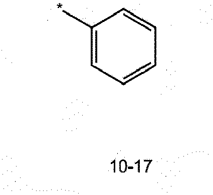 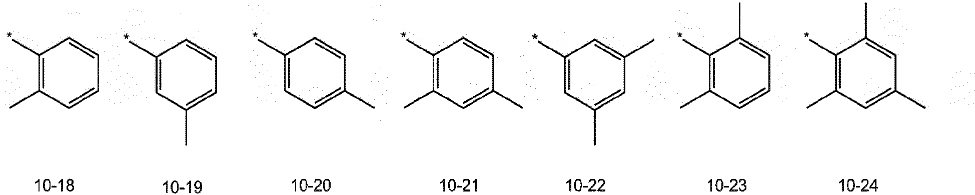 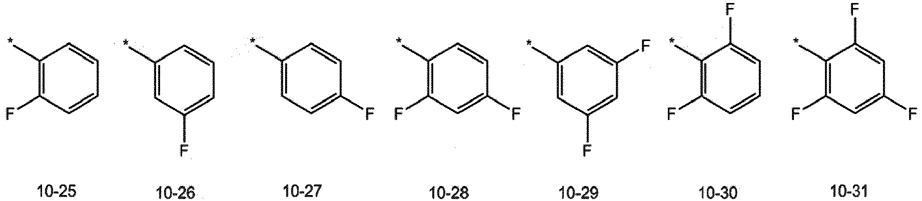 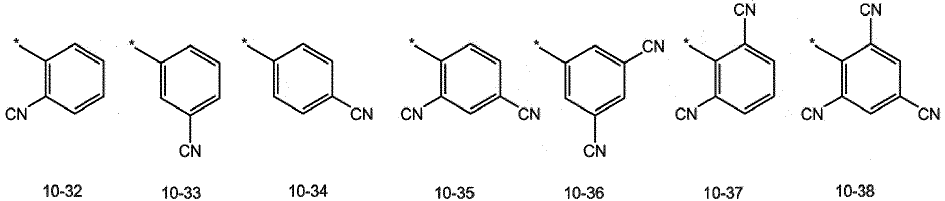 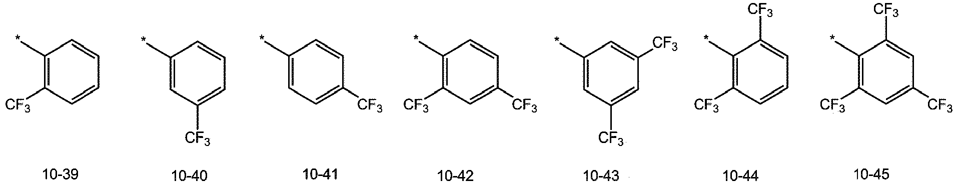 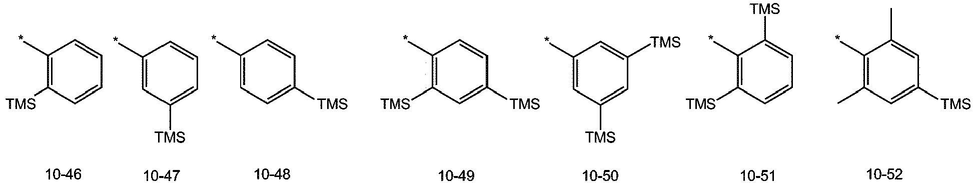 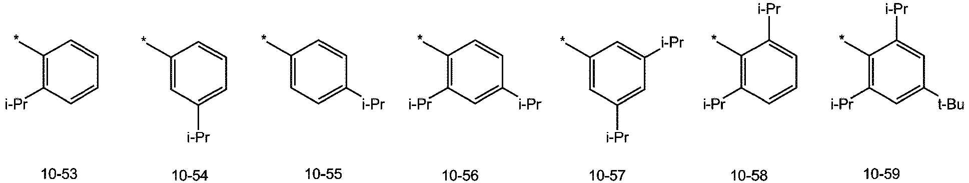 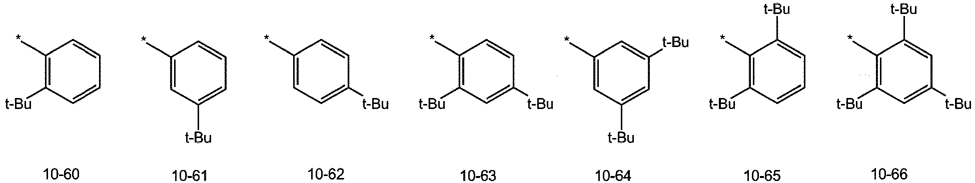 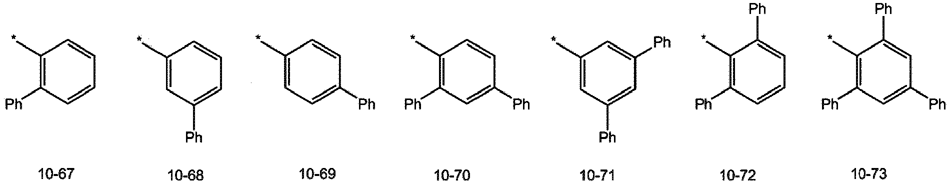 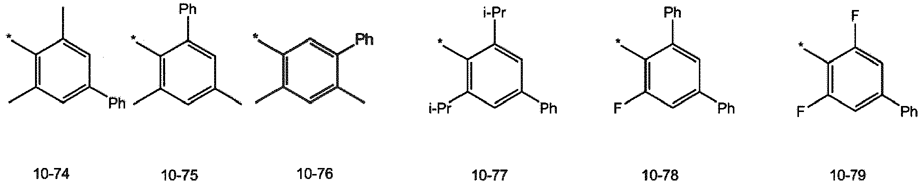 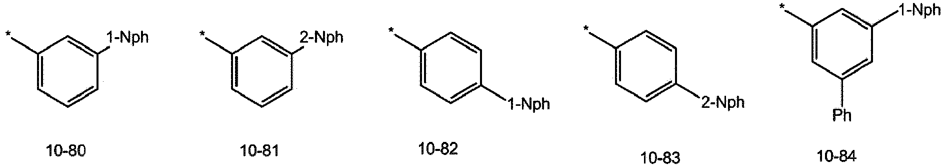 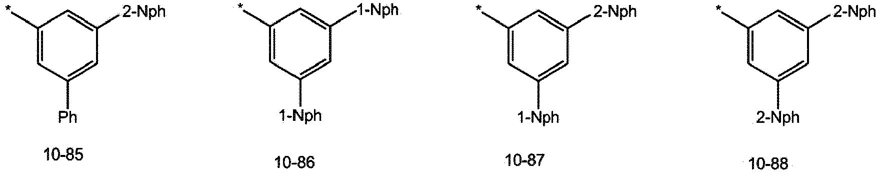 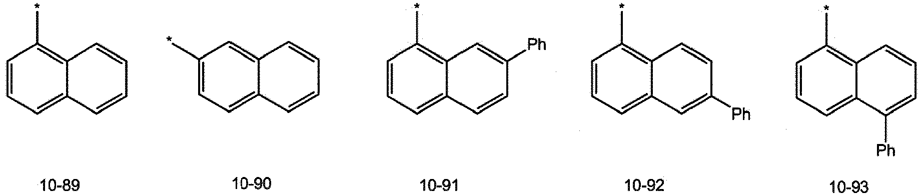 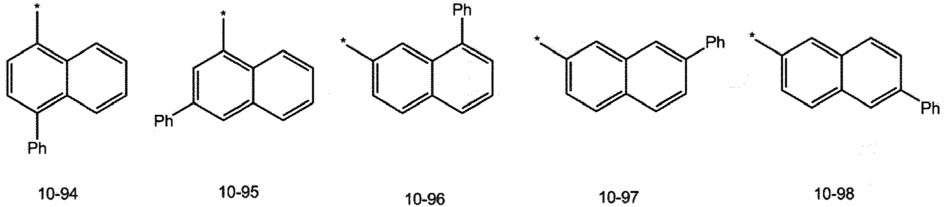 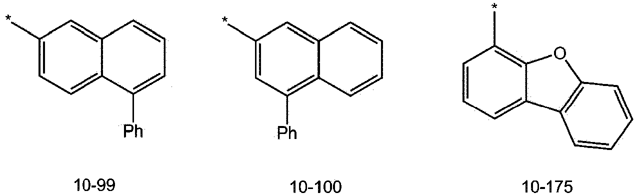 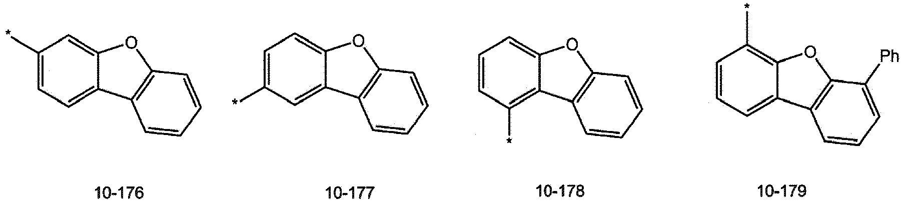 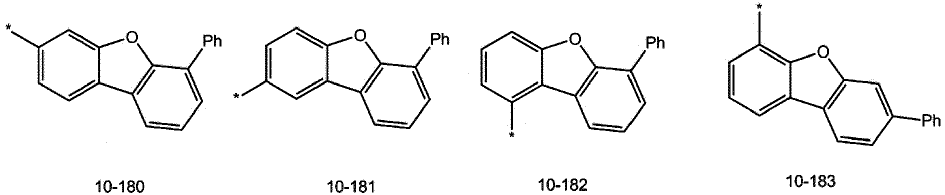 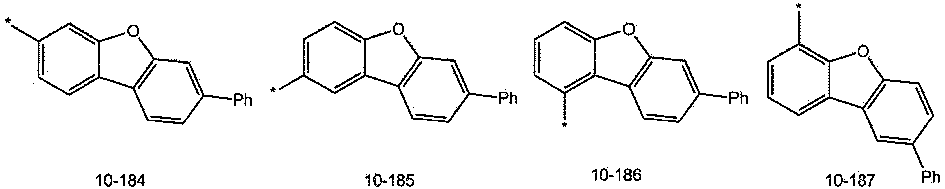 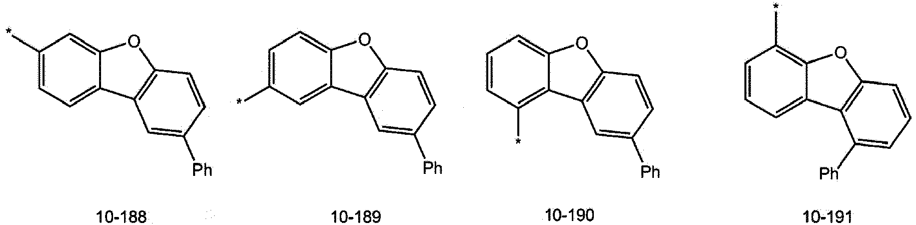 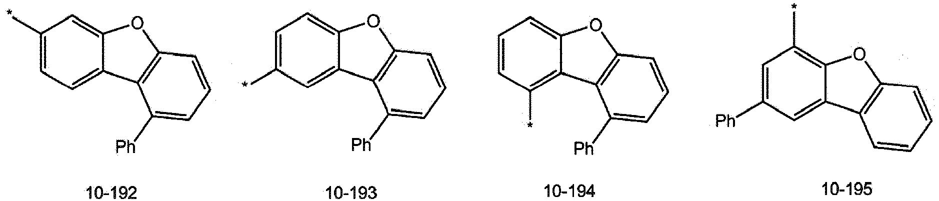 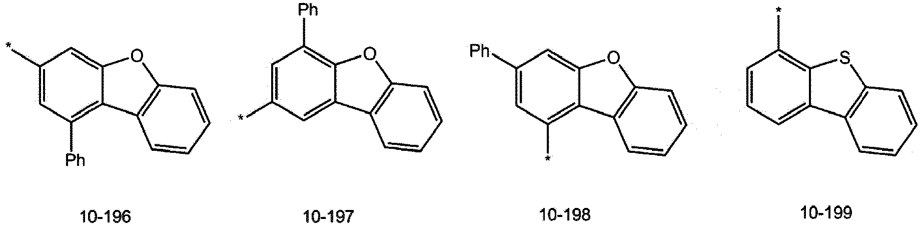 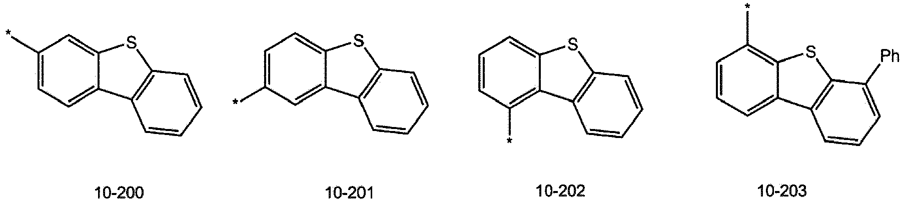 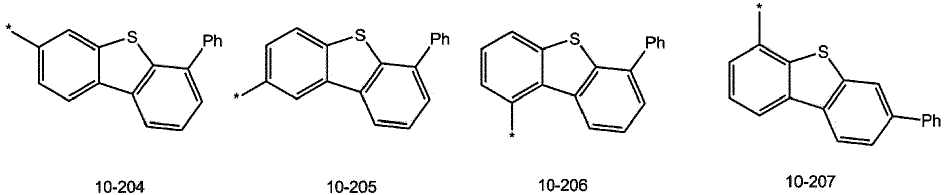 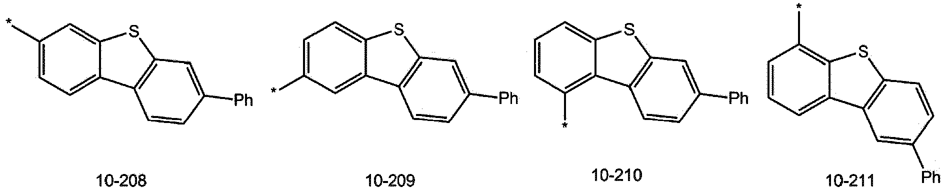 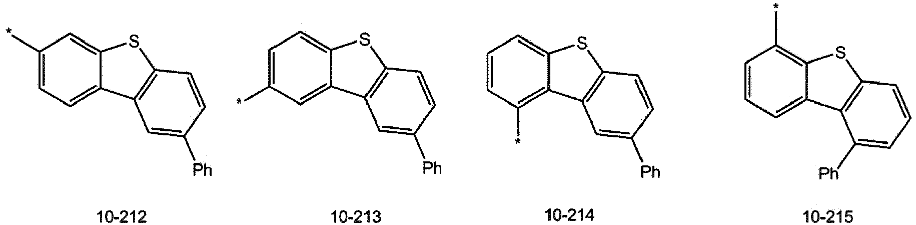 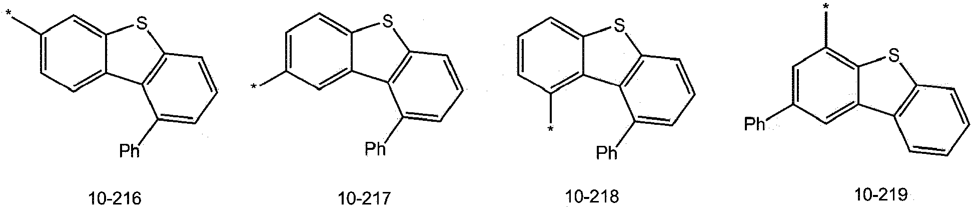 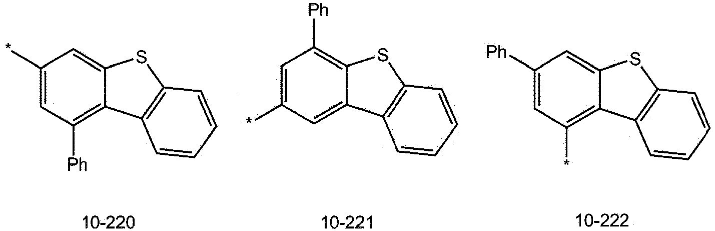 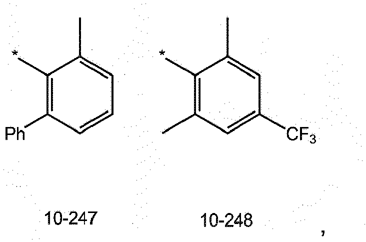
wherein, in Formulae 10-17 to 10-100, 10-175 to 10-222, 10-247, and 10-248,
* indicates a binding site to a neighboring atom,
i-Pr indicates an isopropyl group, t-Bu indicates a t-butyl group,
Ph indicates a phenyl group,
1-Nph indicates a 1-naphthyl group, 2-Nph indicates a 2-naphthyl group, and TMS indicates a trimethylsilyl group.

11. The organometallic compound of any of claims 1-10, wherein
the organometallic compound is represented by Formula 1-1: 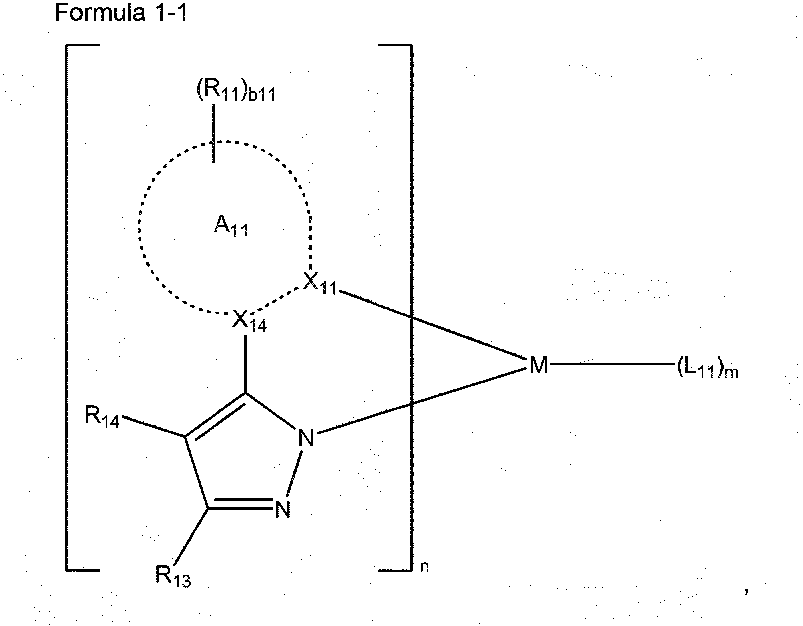 wherein, in Formula 1-1,
M, A₁₁, X₁₁, X₁₄, R₁₁, R₁₃, R₁₄, b11, L₁₁, n, and m are each independently the same as described in connection with Formula 1 in claim 1.

12. The organometallic compound of any of claims 1-11, wherein
the organometallic compound is represented by one of Formulae 1-11 to 1-24: 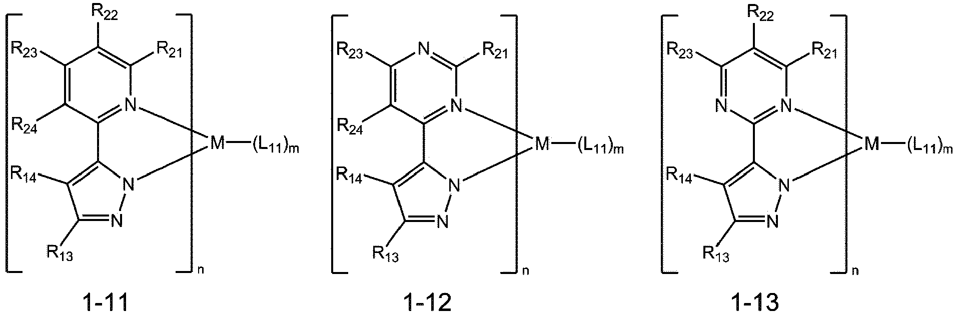 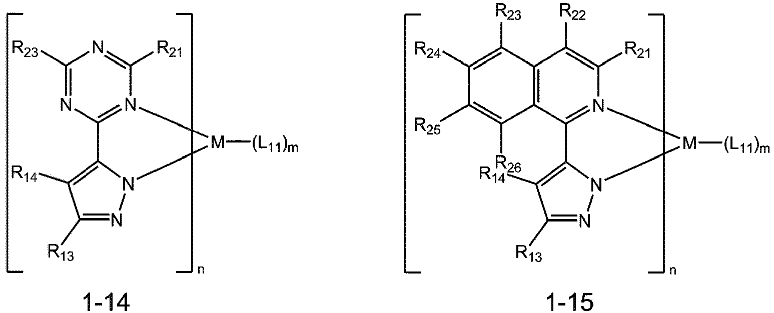 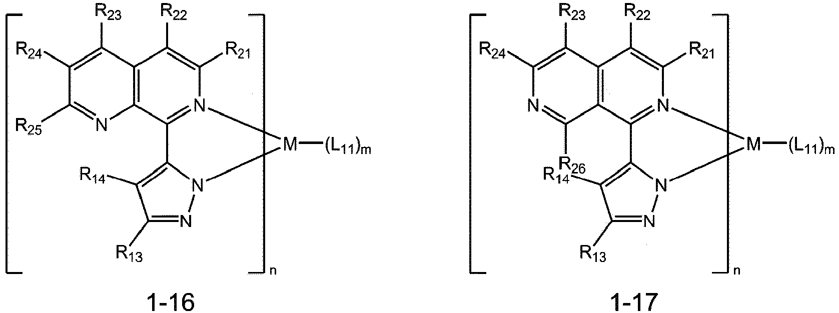 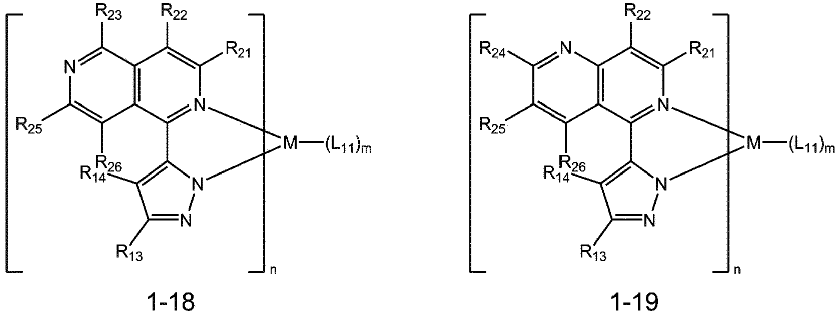 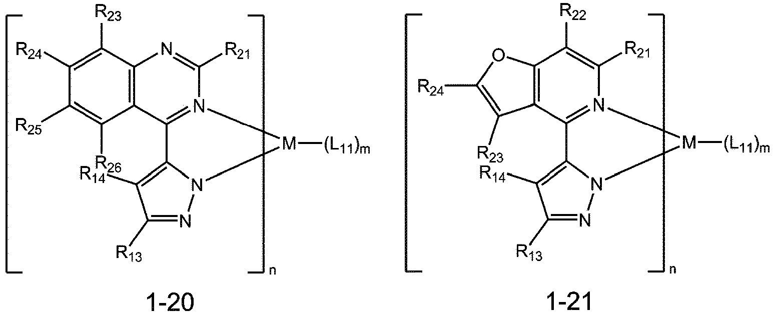 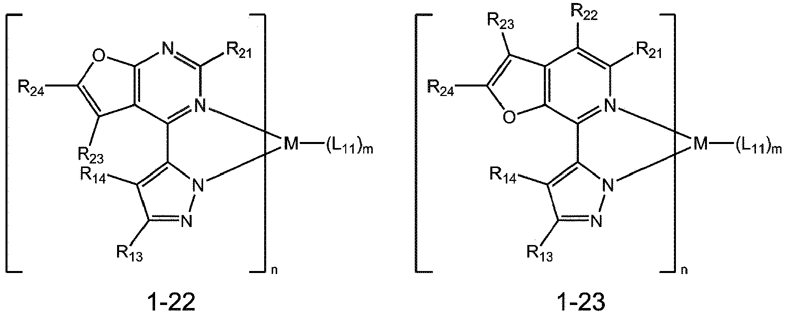 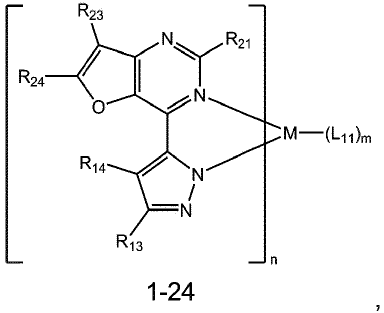 wherein, in Formulae 1-11 to 1-24,
M, A₁₁, X₁₁, X₁₄, R₁₁, R₁₃, R₁₄, b11, L₁₁, n, and m are each independently the same as described in connection with Formula 1 in claim 1.

13. The organometallic compound of claim 1, wherein
the organometallic compound is of Compounds 1 to 11: 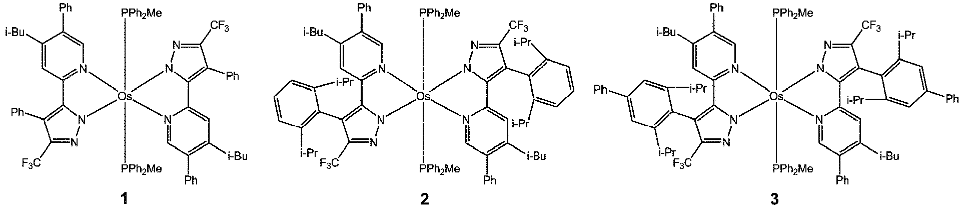 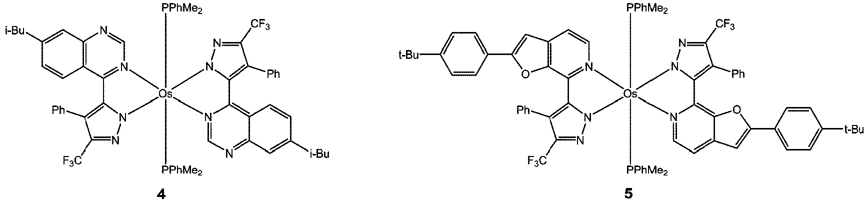 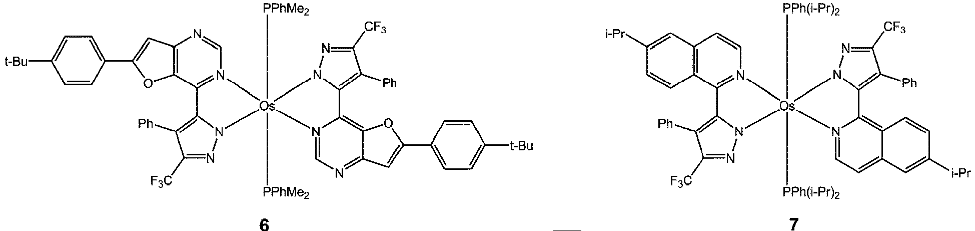 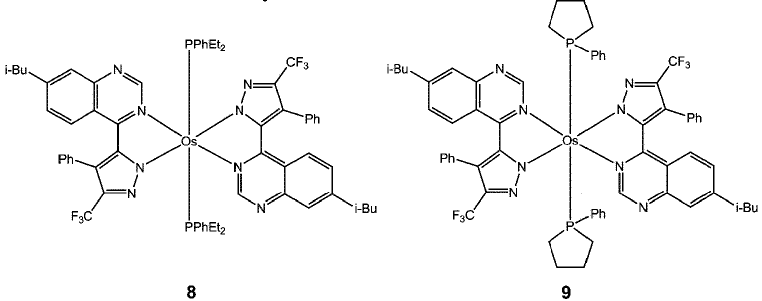 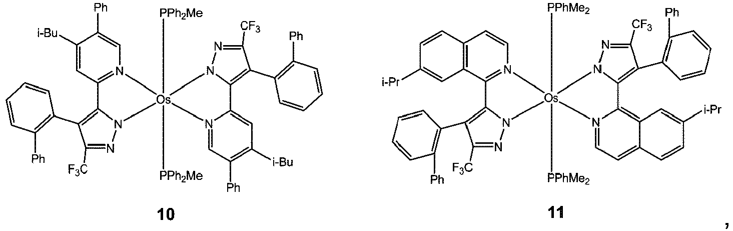 wherein, in Compounds 1 to 11,
Ph indicates a phenyl group, i-Pr indicates an isopropyl group, i-Bu indicates an isobutyl group, and t-Bu indicates a tert-butyl group.

14. An organic light-emitting device comprising:
a first electrode;
a second electrode; and
an organic layer between the first electrode and the second electrode and comprising an emission layer,
wherein the organic layer comprises at least one of the organometallic compound of any of claims 1-13.

15. The organic light-emitting device of claim 14, wherein
the organometallic compound is comprised in the emission layer;
preferably wherein
the emission layer further comprises a host, and an amount of the host in the emission layer is larger than an amount of the organometallic compound in the emission layer.

## Patentansprüche

1. Organometallische Verbindung, die durch die Formel 1 dargestellt ist: 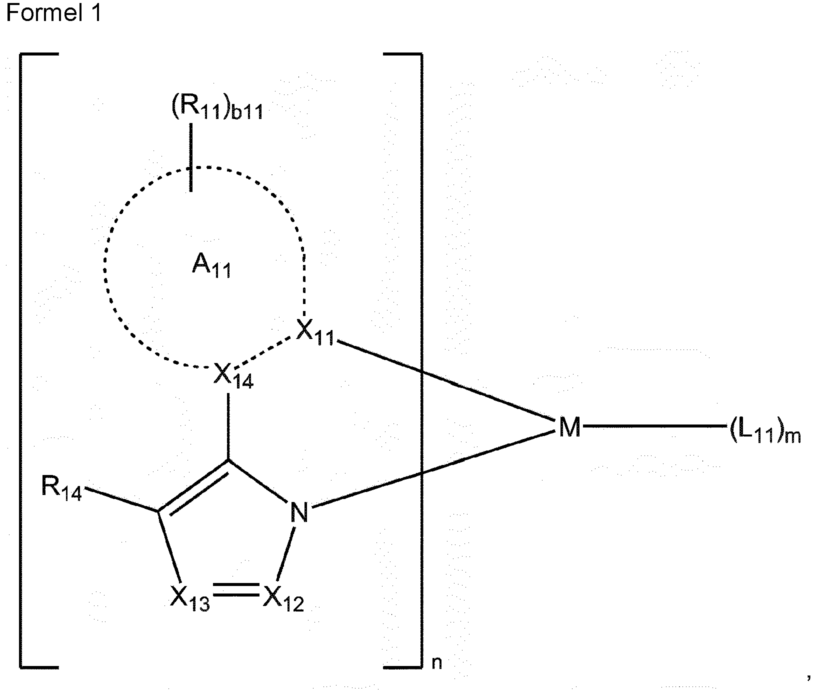 wobei in Formel 1 folgendes gilt:
M ist ein Übergangsmetall der ersten Reihe, ein Übergangsmetall der zweiten Reihe oder ein Übergangsmetall der dritten Reihe des Periodensystems,
X₁₁ ist N oder C, und eine Bindung zwischen X₁₁ und M ist eine koordinative Bindung,
X₁₂ ist N oder C(R₁₂),
X₁₃ ist N oder C(R₁₃), wobei X₁₂ und X₁₃ nicht gleichzeitig N sind,
X₁₄ ist N oder C, und wobei eine Bindung zwischen X₁₁ und X₁₄ eine Einzelbindung oder eine Doppelbindung ist,
A₁₁ ist eine C₅-C₆₀ carbocyclische Gruppe oder eine C₁-C₆₀ heterocyclische Gruppe,
R₁₁ ist Wasserstoff, Deuterium, -F, -Cl, -Br, -I, -SF₅, eine Hydroxylgruppe, eine Cyanogruppe, eine Nitrogruppe, eine Amidinogruppe, eine Hydrazinogruppe, eine Hydrazonogruppe, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkynylgruppe, eine substituierte oder unsubstituierte C₁-C₆₀-Alkoxygruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente, nicht aromatische, kondensierte polycyclische Gruppe, eine substituierte oder unsubstituierte monovalente, nicht aromatische, kondensierte heteropolycyclische Gruppe, -Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂) oder -P(=S)(Q₁)(Q₂), wobei zwei benachbarte R₁₁ optional miteinander verbunden sind, um eine substituierte oder unsubstituierte C₅-C₃₀ carbocyclische Gruppe oder eine substituierte oder unsubstituierte C₁-C₃₀ heterocyclische Gruppe zu bilden,
R₁₂ und R₁₃ sind jeweils unabhängig:
-F, -Cl, -Br, -I, eine Cyanogruppe oder eine Nitrogruppe; oder
eine C₁-C₆₀-Alkylgruppe, substituiert mit mindestens einem aus -F, -Cl, -Br, -I, einer Cyanogruppe, einer Nitrogruppe oder einer beliebigen Kombination davon,
R₁₄ ist eine substituierte oder unsubstituierte C₆-C₆₀-Arylgruppe, eine substituierte oder unsubstituierte C₁-C₆₀-Heteroarylgruppe, eine substituierte oder unsubstituierte monovalente, nicht aromatische, kondensierte polycyclische Gruppe oder eine substituierte oder unsubstituierte monovalente, nicht aromatische, kondensierte heteropolycyclische Gruppe,
b11 ist 1, 2, 3, 4, 5, 6, 7 oder 8,
Q₁ bis Q₃ sind jeweils unabhängig Wasserstoff, Deuterium, -F, -Cl, -Br, -I, eine Hydroxylgruppe, eine Cyanogruppe, eine Nitrogruppe, eine Amidinogruppe, eine Hydrazinogruppe, eine Hydrazonogruppe, eine C₁-C₆₀-Alkylgruppe, eine C₂-C₆₀-Alkenylgruppe, eine C₂-C₆₀-Alkynylgruppe, eine C₁-C₆₀-Alkoxygruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine monovalente, nicht aromatische, kondensierte polycyclische Gruppe, eine monovalente, nicht aromatische, kondensierte heteropolycyclische Gruppe, eine C₁-C₆₀-Alkylgruppe, substituiert mit mindestens einem Deuterium, -F, einer Cyanogruppe, einer C₁-C₆₀-Alkylgruppe, einer C₆-C₆₀-Arylgruppe oder einer beliebigen Kombination davon, oder eine C₆-C₆₀-Arylgruppe, substituiert mit mindestens einem Deuterium, -F, einer Cyanogruppe, einer C₁-C₆₀-Alkylgruppe, einer C₆-C₆₀-Arylgruppe oder einer beliebigen Kombination davon,
n ist 1, 2 oder 3,
L₁₁ ist ein einzähniger Ligand, ein zweizähniger Ligand oder ein dreizähniger Ligand, und
m ist 0, 1, 2, 3, 4 oder 5.

2. Organometallische Verbindung nach Anspruch 1, wobei folgendes gilt:
M ist Platin, Palladium, Kupfer, Silber, Gold, Rhodium, Iridium, Ruthenium, Osmium, Titan, Zirkonium, Hafnium, Europium, Terbium oder Thulium;
wobei vorzugsweise
M Ru oder Os ist.

3. Organometallische Verbindung nach Anspruch 1 oder 2, wobei folgendes gilt:
X₁₂ ist N und X13 ist C(R₁₃); oder
X12 ist C(R₁₂) und X₁₃ ist N.

4. Organometallische Verbindung nach einem der Ansprüche 1 bis 3, wobei folgendes gilt:
X12 ist N und X₁₃ ist C(R₁₃).

5. Organometallische Verbindung nach einem der Ansprüche 1 bis 4, wobei ein durch 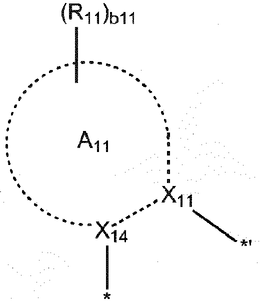 dargestellter Teil (wobei *' eine Bindungsstelle an M anzeigt, und wobei * eine Bindungsstelle an ein Kohlenstoffatom anzeigt) durch eine der Formeln 2-1 bis 2-17 dargestellt ist: 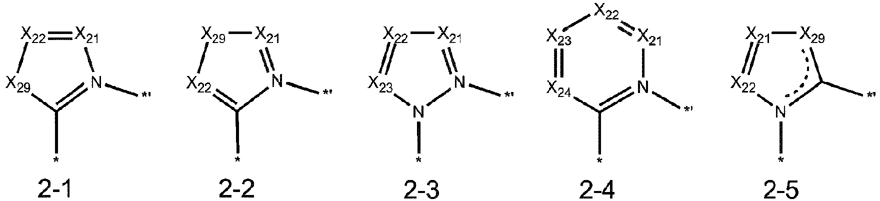 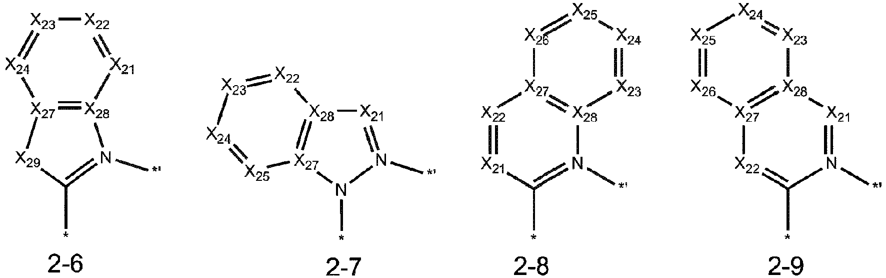 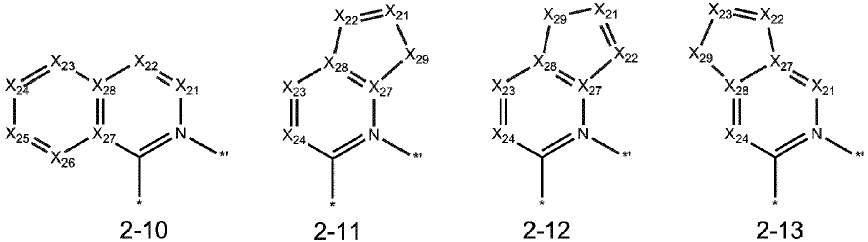 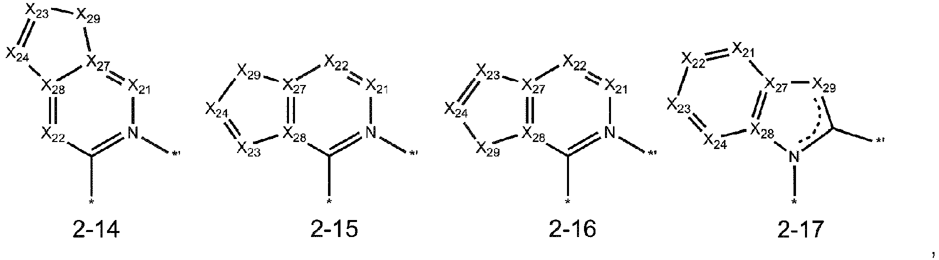 wobei in den Formeln 2-1 bis 2-17 folgendes gilt:
X₂₁ ist N oder C(R₂₁), X₂₂ ist N oder C(R₂₂), X₂₃ ist N oder C(R₂₃), X₂₄ ist N oder C(R24), X₂₅ ist N oder C(R₂₅) und X₂₆ ist N oder C(R₂₆),
X₂₇ und X₂₈ sind jeweils unabhängig N oder C,
X29 ist O, S, N(R29) oder C(R₂₉)(R₃₀),
R₂₁ bis R₂₆, R₂₉ und R₃₀ entsprechen jeweils unabhängig der Beschreibung in Verbindung mit R₁₁ in Formel 1 aus Anspruch 1,
* bezeichnet eine Bindungsstelle an ein Kohlenstoffatom, und
*' bezeichnet eine Bindungsstelle an M.

6. Organometallische Verbindung nach einem der Ansprüche 1 bis 5, wobei ein durch 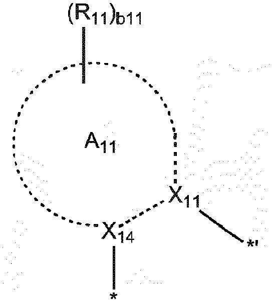 dargestellter Teil (wobei *' eine Bindungsstelle an M anzeigt, und wobei * eine Bindungsstelle an ein Kohlenstoffatom anzeigt) durch eine der Formeln 3-1 bis 3-54 dargestellt ist: 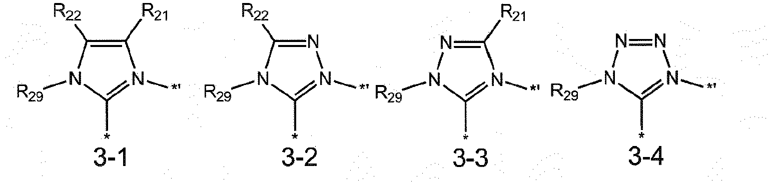 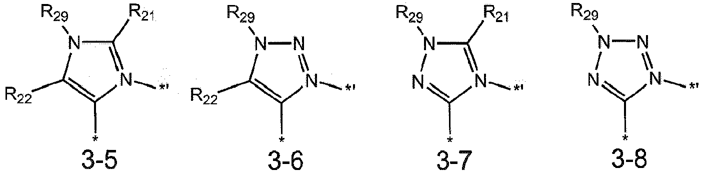 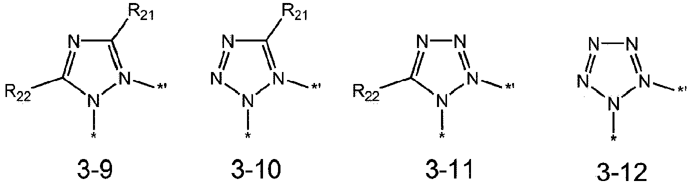 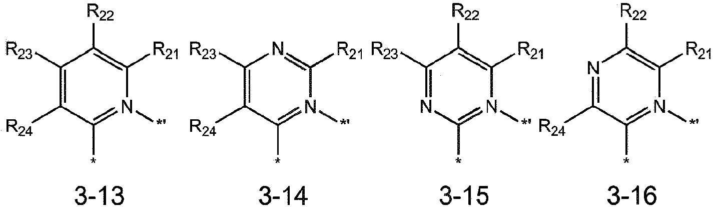 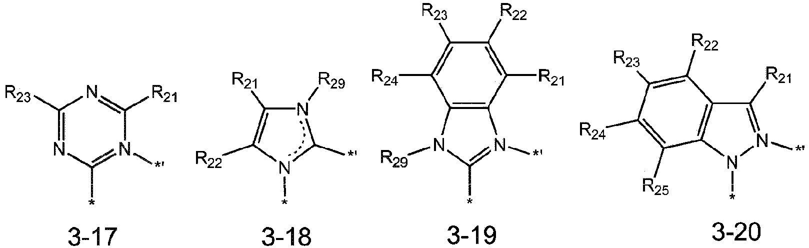 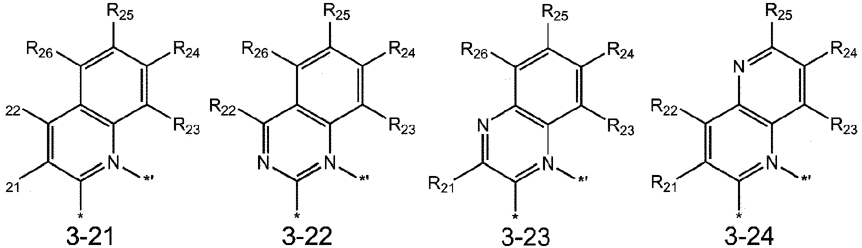 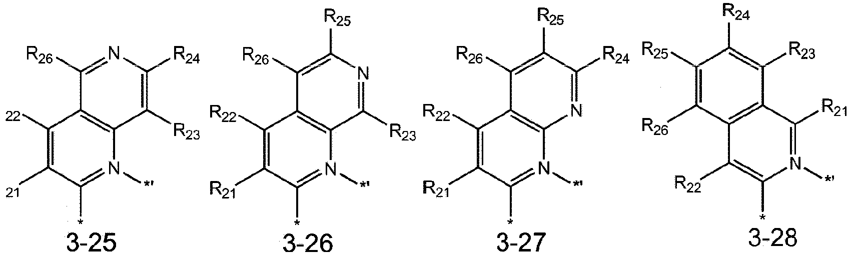 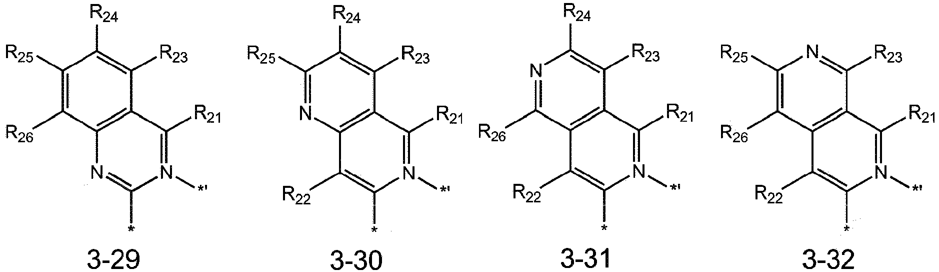 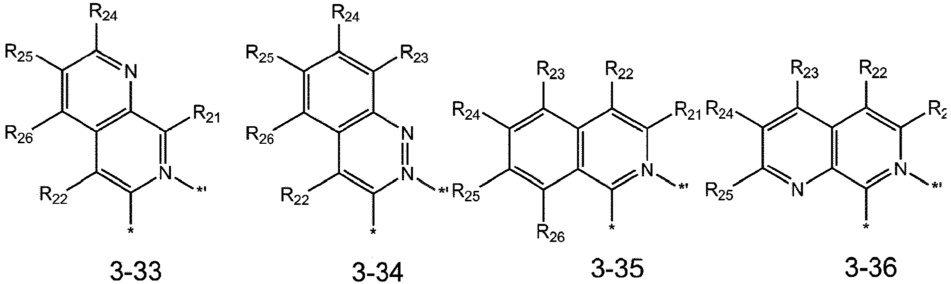 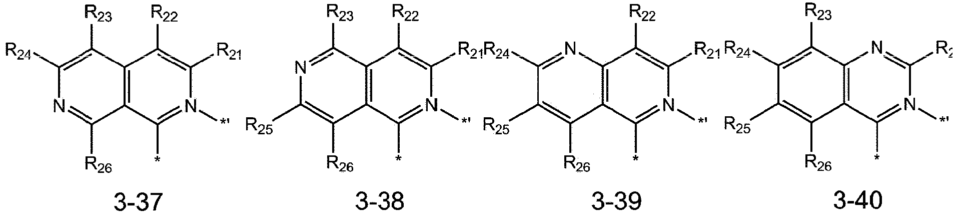 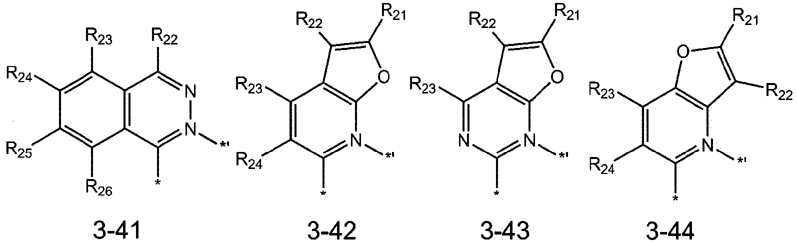 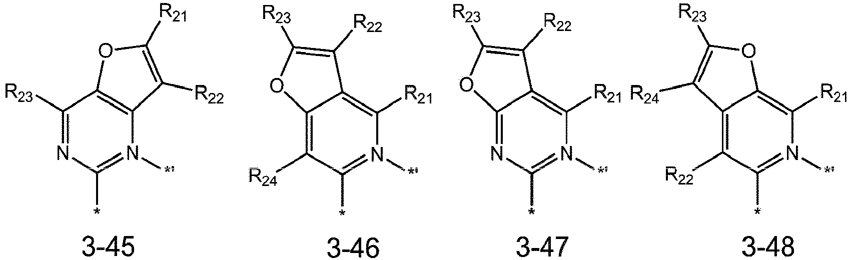 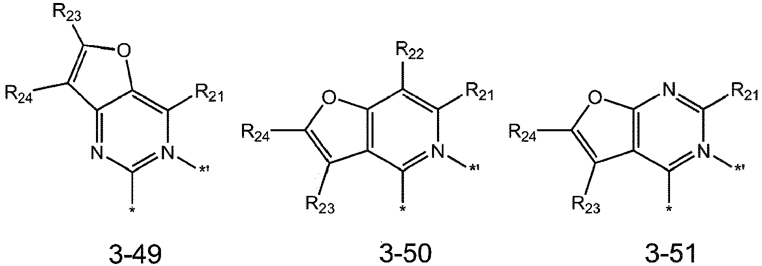 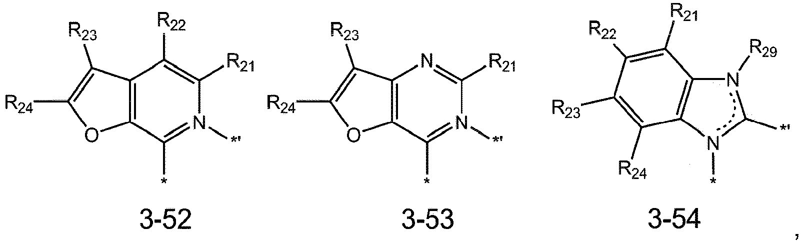 wobei in den Formeln 3-1 bis 3-54 folgendes gilt:
R₂₁ bis R₂₆, R₂₉ und R₃₀ entsprechen jeweils unabhängig der Beschreibung in Verbindung mit R₁₁ in Formel 1 aus Anspruch 1,
* bezeichnet eine Bindungsstelle an ein Kohlenstoffatom, und
*' bezeichnet eine Bindungsstelle an M.

7. Organometallische Verbindung nach einem der Ansprüche 1 bis 6, wobei folgendes gilt:
R₁₁ ist:
Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazinogruppe, eine Hydrazonogruppe, eine Carbonsäuregruppe oder ein Salz davon, eine Sulfonsäuregruppe oder ein Salz davon, eine Phosphorsäuregruppe oder ein Salz davon, -SF₅, eine C₁-C₂₀-Alkylgruppe oder eine C₁-C₂₀-Alkoxygruppe-,
eine C₁-C₂₀-Alkylgruppe oder eine C₁-C₂₀-Alkoxygruppe, jeweils substituiert mit mindestens einem Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantylgruppe, einer Norbornylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe oder einer beliebigen Kombination davon;
eine Cyclopentylgruppe, eine Cyclohexylgruppe, eine Cycloheptylgruppe, eine Cyclooctylgruppe, eine Adamantylgruppe, eine Norbornylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Dibenzosilolylgruppe, eine Benzocarbazolylgruppe, eine Dibenzocarbazolylgruppe, eine Imidazopyridinylgruppe oder eine Imidazopyrimidinylgruppe;
eine Cyclopentylgruppe, eine Cyclohexylgruppe, eine Cycloheptylgruppe, eine Cyclooctylgruppe, eine Adamantylgruppe, eine Norbornylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Dibenzosilolylgruppe, eine Benzocarbazolylgruppe, eine Dibenzocarbazolylgruppe, eine Imidazopyridinylgruppe oder eine Imidazopyrimidinylgruppe, jeweils substituiert mit mindestens einem Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxyruppe, einer Cyclopentylgruppe, einer Cyclohexylgruppe, einer Cycloheptylgruppe, einer Cyclooctylgruppe, einer Adamantylgruppe, einer Norbornylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe, -Si(Q₃₃)(Q₃₄)(Q₃₅) oder einer beliebigen Kombination davon; oder
-N(Q₁)(Q₂), -Si(Q₃)(Q₄)(Q₅), -B(Q₆)(Q₇) oder -P(=O)(Q₈)(Q₉), und
Q₁ bis Q₉ und Q₃₃ bis Q₃₅ sind jeweils unabhängig:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit mindestens einem Deuterium, einer C₁-C₁₀-Alkylgruppe, einer Phenylgruppe oder einer beliebigen Kombination davon.

8. Organometallische Verbindung nach einem der Ansprüche 1 bis 7, wobei folgendes gilt:
R₁₂ und R₁₃ sind jeweils unabhängig:
-F, -Cl oder eine Cyanogruppe; oder
eine Methylgruppe, eine Ethylgruppe, eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine n-Hexylgruppe, eine Isohexylgruppe, eine sec-Hexylgruppe, eine tert-Hexylgruppe, eine n-Heptylgruppe, eine Isoheptylgruppe, eine sec-Heptylgruppe, eine tert-Heptylgruppe, eine n-Octylgruppe, eine Isooctylgruppe, eine sec-Octylgruppe, eine tert-Octylgruppe, eine n-Nonylgruppe, eine Isononylgruppe, eine sec-Nonylgruppe, eine tert-Nonylgruppe, eine n-Decylgruppe, eine Isodecylgruppe, eine sec-Decylgruppe oder eine tert-Decylgruppe, jeweils substituiert mit mindestens einem -F, -Cl, einer Cyanogruppe oder einer beliebigen Kombination davon.

9. Organometallische Verbindung nach einem der Ansprüche 1 bis 8, wobei folgendes gilt:
R₁₂ und R₁₃ sind jeweils unabhängig:
-F oder eine Cyanogruppe; oder
eine Methylgruppe, eine Ethylgruppe, eine n-Propylgruppe, eine Isopropylgruppe, eine n-Butylgruppe, eine Isobutylgruppe, eine sec-Butylgruppe oder eine tert-Butylgruppe, jeweils substituiert mit mindestens einem -F, einer Cyanogruppe oder einer beliebigen Kombination davon;
wobei vorzugsweise
R₁₂ und R₁₃ jeweils unabhängig -F, eine Cyanogruppe, -CF₃ oder eine beliebige Kombination davon sind.

10. Organometallische Verbindung nach einem der Ansprüche 1 bis 9, wobei folgendes gilt:
R₁₄ ist:
eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Oxazolylgruppe, eine Pyridinylgruppe, eine Pyrazinylgruppe, eine Pyrimidinylgruppe, eine Indolylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Benzoxazolylgruppe, eine Triazolylgruppe, eine Tetrazolylgruppe, eine Triazinylgruppe, eine Dibenzofuranylgruppe, eine Dibenzothiophenylgruppe, eine Dibenzosilolylgruppe, eine Benzocarbazolylgruppe, eine Dibenzocarbazolylgruppe, eine Imidazopyridinylgruppe oder eine Imidazopyrimidinylgruppe; oder
eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Oxazolylgruppe, eine Pyridinylgruppe, eine Pyrazinylgruppe, eine Pyrimidinylgruppe, eine Indolylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Benzoxazolylgruppe, eine Triazolylgruppe, eine Tetrazolylgruppe, eine Triazinylgruppe, eine Dibenzofuranylgruppe, eine Dibenzothiophenylgruppe, eine Dibenzosilolylgruppe, eine Benzocarbazolylgruppe, eine Dibenzocarbazolylgruppe, eine Imidazopyridinylgruppe oder eine Imidazopyrimidinylgruppe, jeweils substituiert mit mindestens einem Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazinogruppe, einer Hydrazonogruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer mit Deuterium substituierten Cyclopentylgruppe, einer Cyclohexylgruppe, einer mit Deuterium substituierten Cyclohexylgruppe, einer Cycloheptylgruppe, einer mit Deuterium substituierten Cycloheptylgruppe, einer Cyclooctylgruppe, einer mit Deuterium substituierten Cyclooctylgruppe, einer bicyclo[2.2.1]Heptanylgruppe, einer Adamantylgruppe, einer Norbornylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe, -Si(Q₃₃)(Q₃₄)(Q₃₅) oder einer beliebigen Kombination davon, und
Q₃₃ bis Q₃₅ sind jeweils unabhängig:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit mindestens einem Deuterium, einer C₁-C₁₀-Alkylgruppe, einer Phenylgruppe oder einer beliebigen Kombination davon; oder
wobei folgendes gilt:
R₁₄ ist:
eine Phenylgruppe, eine Naphthylgruppe, eine Fluorenylgruppe, eine Phenanthrenylgruppe, eine Anthracenylgruppe, eine Benzofuranylgruppe, eine Benzothiophenylgruppe, eine Benzoxazolylgruppe, eine Dibenzofuranylgruppe, eine Dibenzothiophenylgruppe oder eine Dibenzosilolylgruppe; und
eine Phenylgruppe, eine Naphthylgruppe, eine Fluorenylgruppe, eine Phenanthrenylgruppe, eine Anthracenylgruppe, eine Benzofuranylgruppe, eine Benzothiophenylgruppe, eine Benzoxazolylgruppe, eine Dibenzofuranylgruppe, eine Dibenzothiophenylgruppe oder eine Dibenzosilolylgruppe, jeweils substituiert mit mindestens einem Deuterium, -F, -Cl, -Br, -I, -CD₃, -CD₂H, -CDH₂, -CF₃, -CF₂H, -CFH₂, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer Methoxygruppe, einer Ethoxygruppe, einer Propoxygruppe, einer Butoxygruppe, einer Cyclopentylgruppe, einer Cyclohexylgruppe, einer Phenylgruppe, einer Naphthylgruppe, -Si(Q₃₃)(Q₃₄)(Q₃₅) oder einer beliebigen Kombination davon, und
Q₃₃ bis Q₃₅ sind jeweils unabhängig:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe oder eine tert-Butylgruppe; oder
eine n-Propylgruppe, eine Isopropylgruppe, eine n-Butylgruppe, eine Isobutylgruppe, eine sec-Butylgruppe oder eine tert-Butylgruppe, jeweils substituiert mit Deuterium; oder
R₁₄ entspricht den Formeln 10-17 bis 10-100, 10-175 bis 10-222, 10-247 und 10-248: 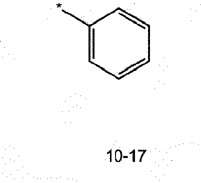 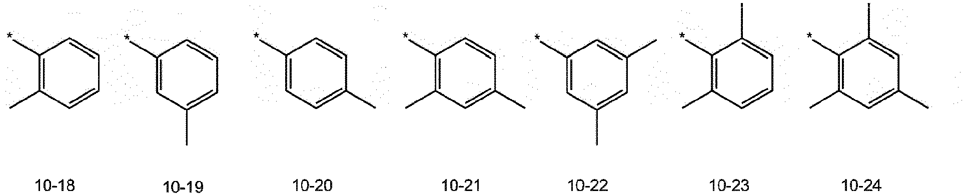 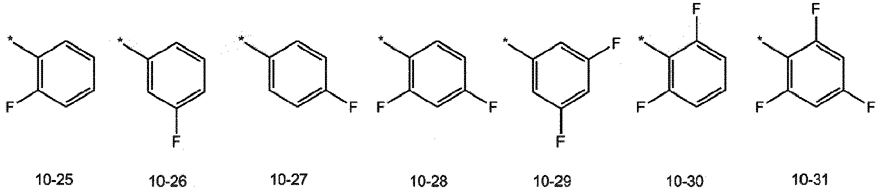 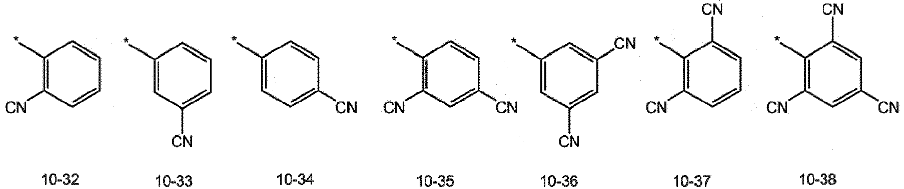 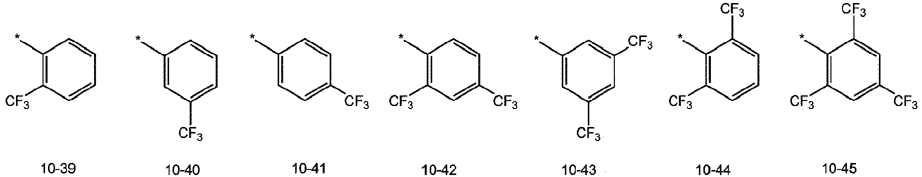 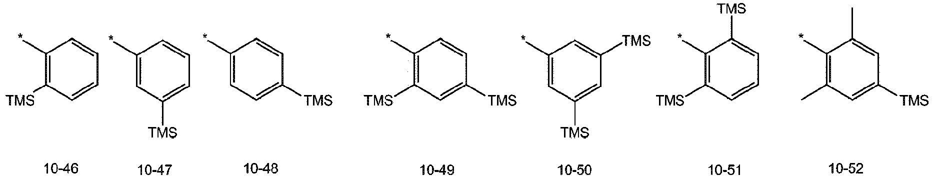 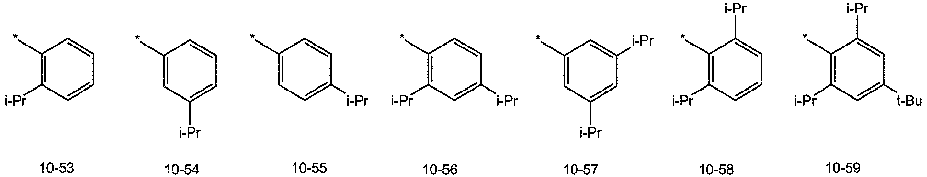 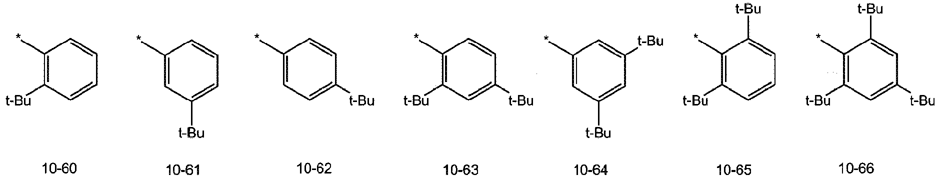 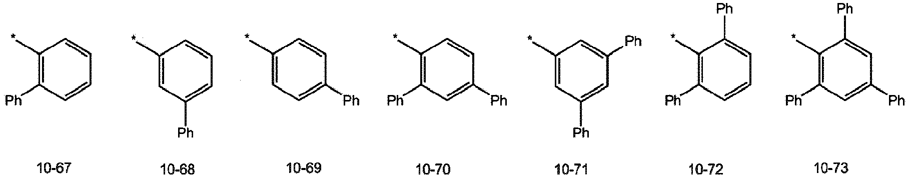 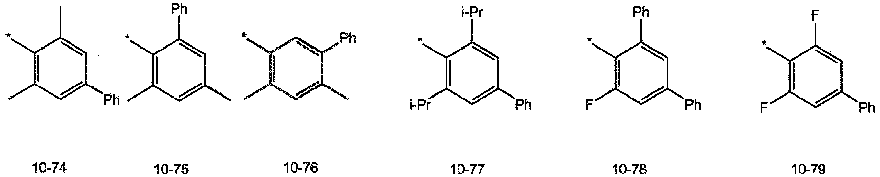 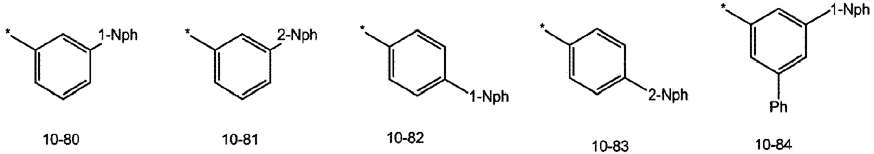 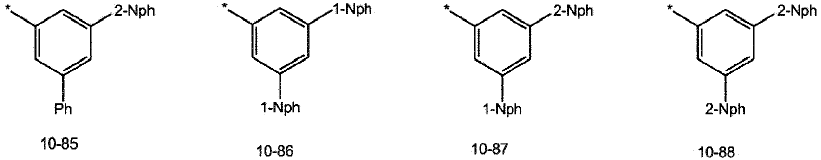 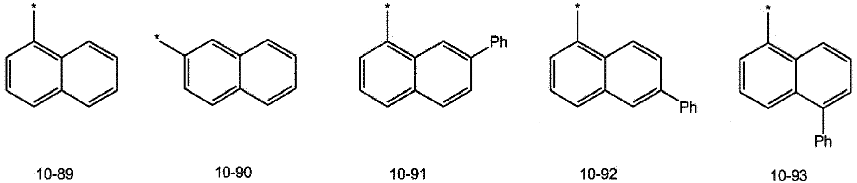 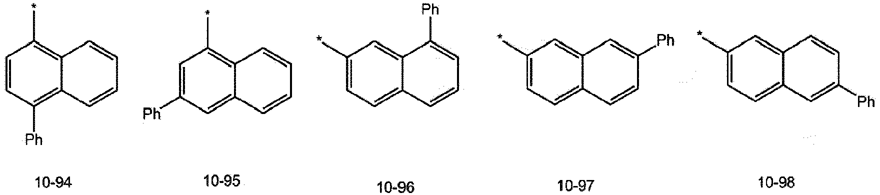 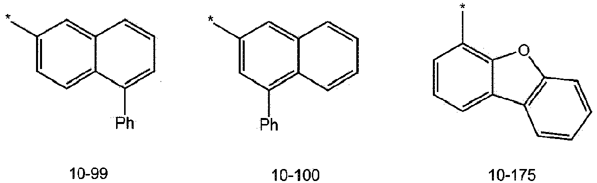 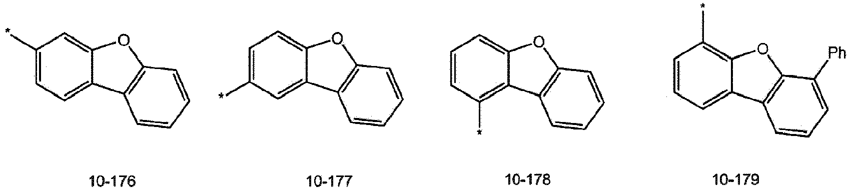 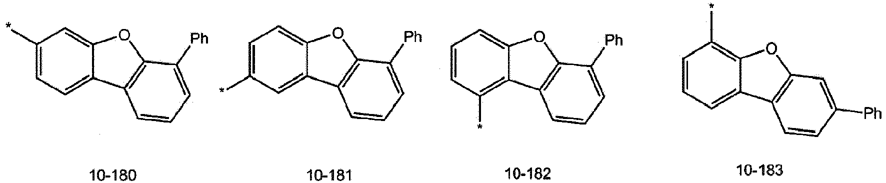 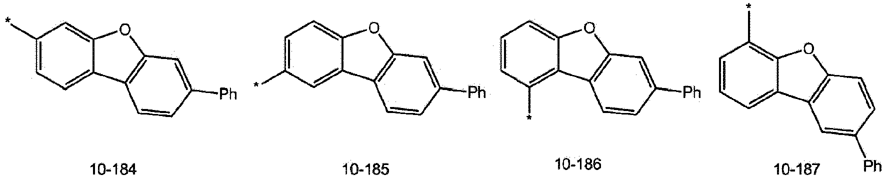 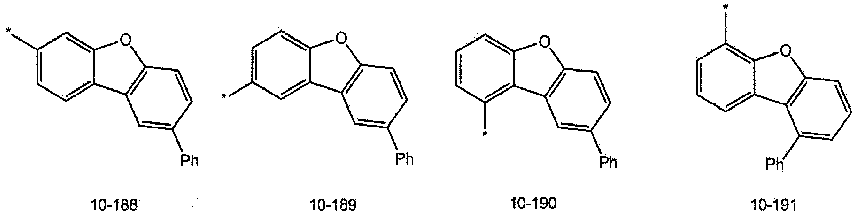 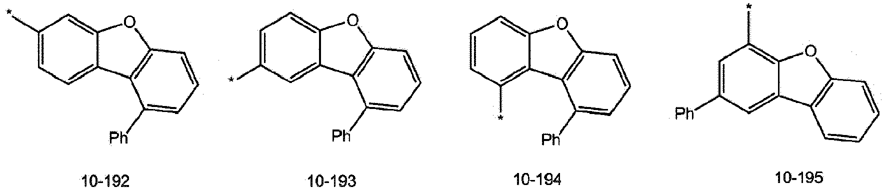 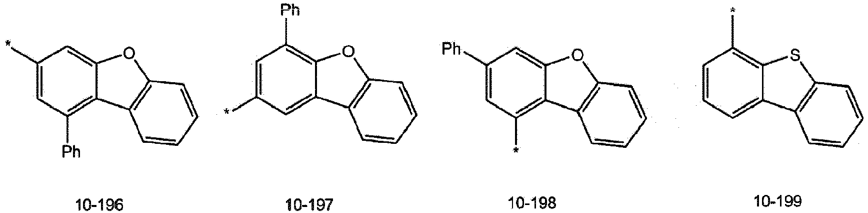 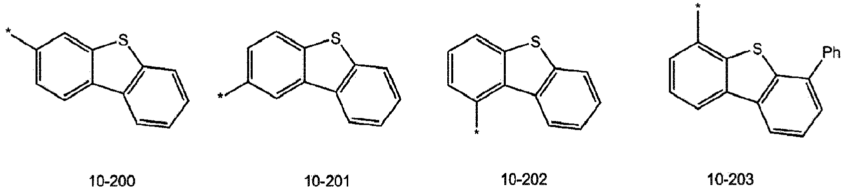 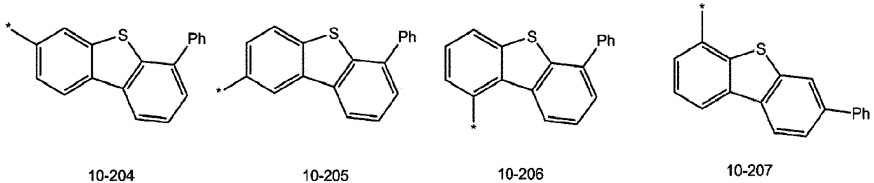 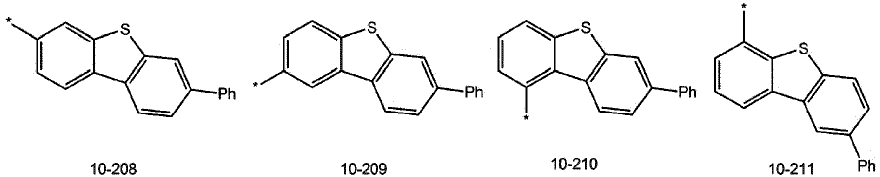 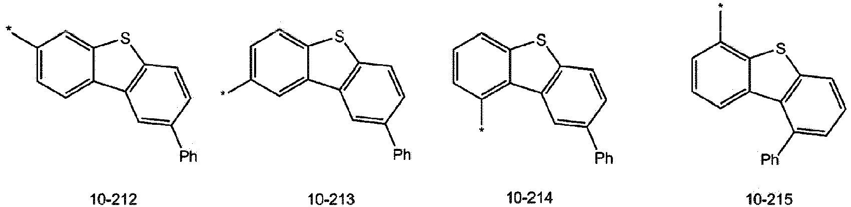 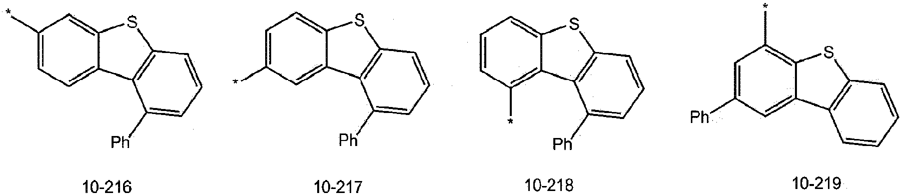 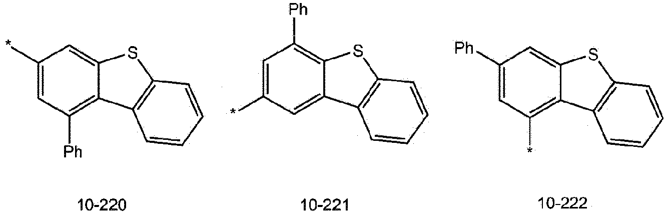 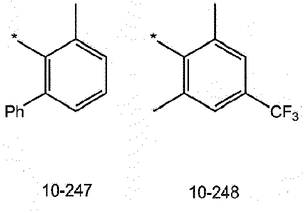 wobei in den Formeln 10-17 bis 10-100, 10-175 bis 10-222, 10-247 und 10-248 folgendes gilt:
* bezeichnet eine Bindungsstelle an ein benachbartes Atom,
i-Pr bezeichnet eine Isopropylgruppe, t-Bu bezeichnet eine t-Butylgruppe,
Ph bezeichnet eine Phenylgruppe,
1-Nph bezeichnet eine 1-Naphthylgruppe, 2-Nph bezeichnet eine 2-Naphthylgruppe, und
TMS bezeichnet eine Trimethylsilylgruppe.

11. Organometallische Verbindung nach einem der Ansprüche 1 bis 10, wobei die organometallische Verbindung durch die Formel 1-1 dargestellt ist: 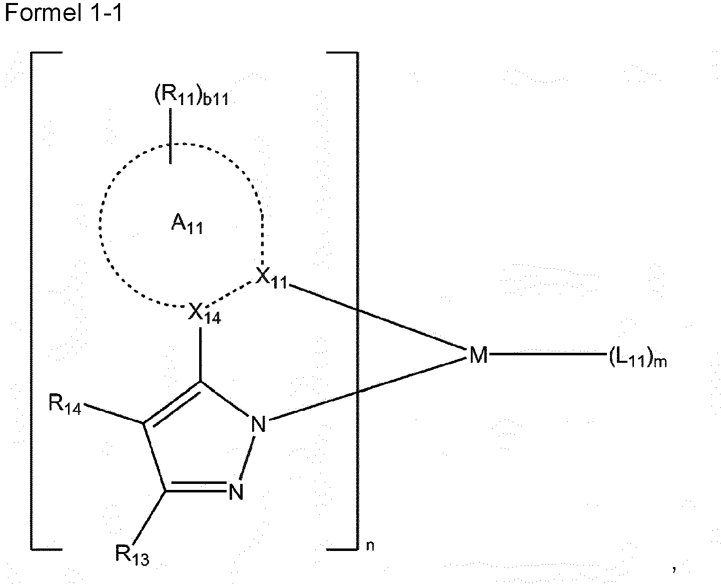 wobei in der Formel 1-1 folgendes gilt:
M, A₁₁, X₁₁, X₁₄, R₁₁, R₁₃, R₁₄, b11, L₁₁, n und m entsprechen jeweils unabhängig der Beschreibung in Verbindung mit der Formel 1 aus Anspruch 1.

12. Organometallische Verbindung nach einem der Ansprüche 1 bis 11, wobei
die organometallische Verbindung durch eine der Formeln 1-11 bis 1-24 dargestellt ist: 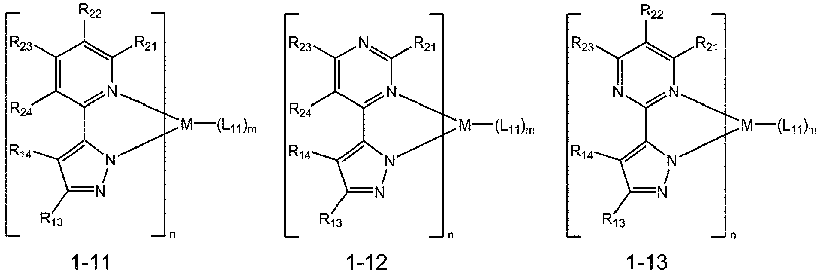 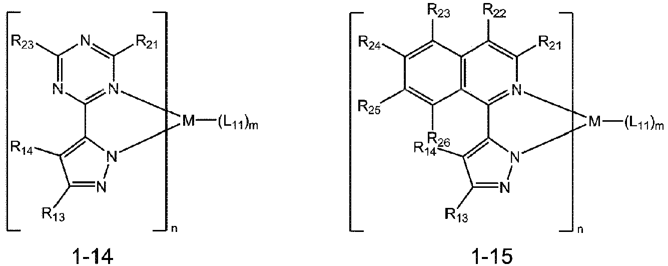 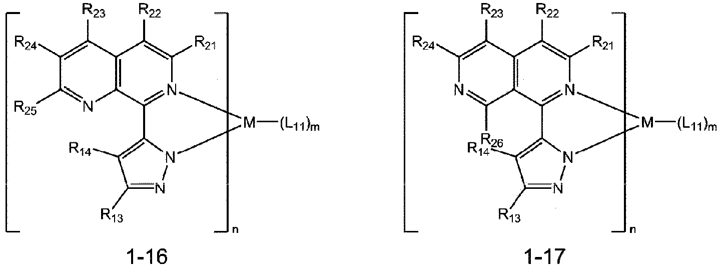 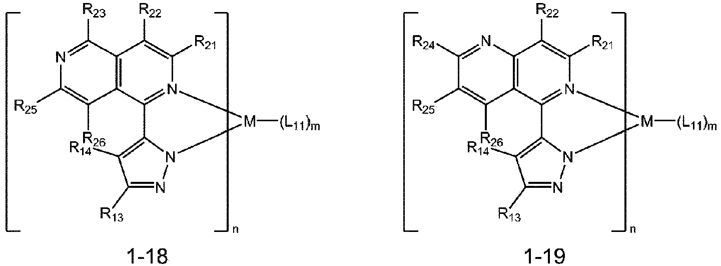 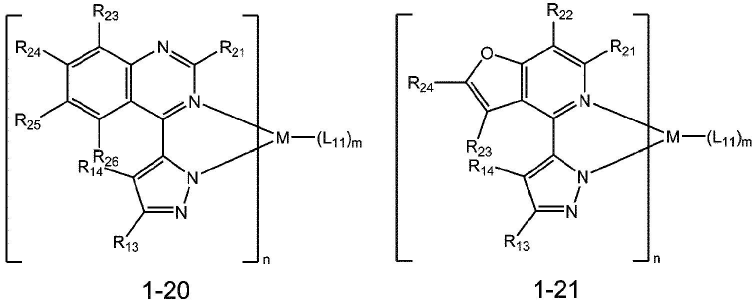 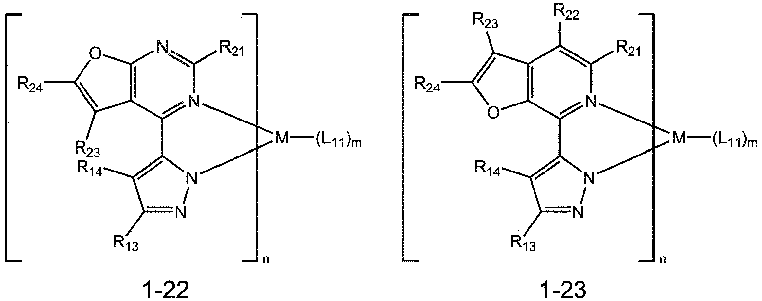 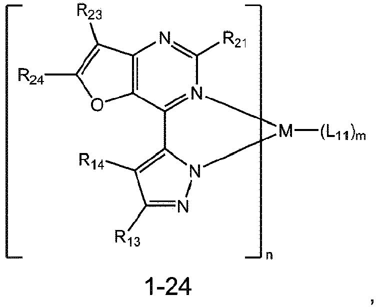 wobei in den Formeln 1-11 bis 1-24 folgendes gilt:
M, A₁₁, X₁₁, X₁₄, R₁₁, R₁₃, R₁₄, b11, L₁₁, n und m entsprechen jeweils unabhängig der Beschreibung in Verbindung mit der Formel 1 aus Anspruch 1.

13. Organometallische Verbindung nach Anspruch 1, wobei
die organometallische Verbindung aus den Verbindungen 1 bis 11 besteht: 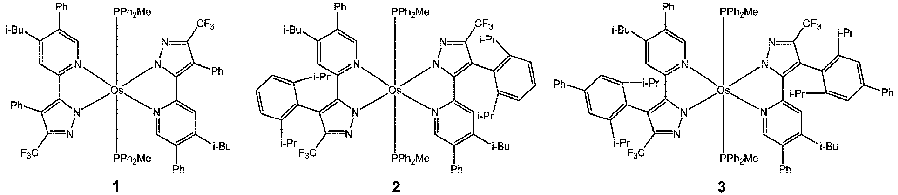 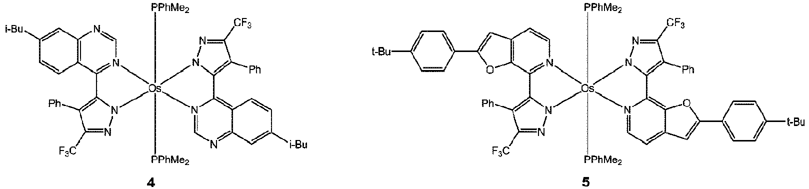 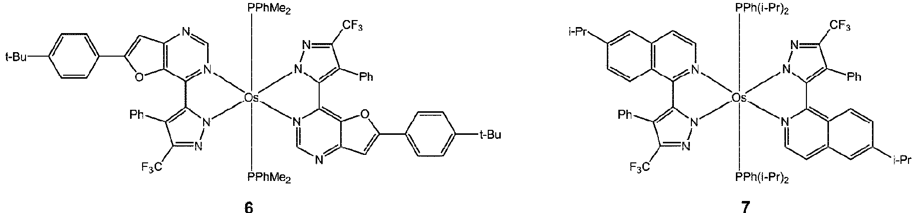 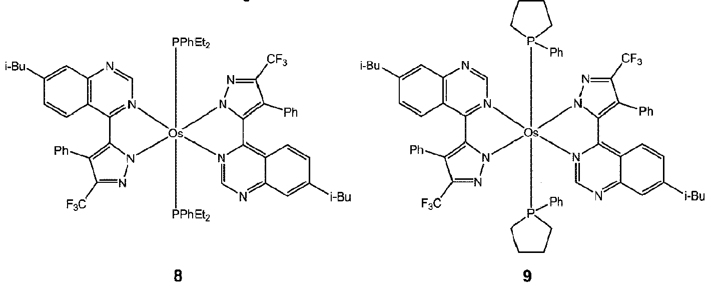 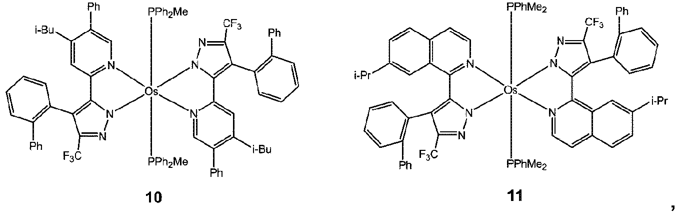 wobei in den Verbindungen 1 bis 11 folgendes gilt:
Ph bezeichnet eine Phenylgruppe, i-Pr bezeichnet eine Isopropylgruppe, i-Bu bezeichnet eine Isobutylgruppe und t-Bu bezeichnet eine tert-Butylgruppe.

14. Organische lichtemittierende Vorrichtung, umfassend:
eine erste Elektrode;
eine zweite Elektrode; und
eine organische Schicht zwischen der ersten Elektrode und der zweiten Elektrode und eine Emissionsschicht umfassend,
wobei die organische Schicht mindestens eine der organometallischen Verbindungen nach einem der Ansprüche 1 bis 13 umfasst.

15. Organische lichtemittierende Vorrichtung nach Anspruch 14, wobei
sich die organometallische Verbindung in der Emissionsschicht befindet;
wobei vorzugsweise
die Emissionsschicht ferner einen Wirt umfasst, und wobei eine Menge des Wirts in der Emissionsschicht größer ist als eine Menge der organometallischen Verbindung in der Emissionsschicht.

## Revendications

1. Composé organométallique représenté par la Formule 1 : 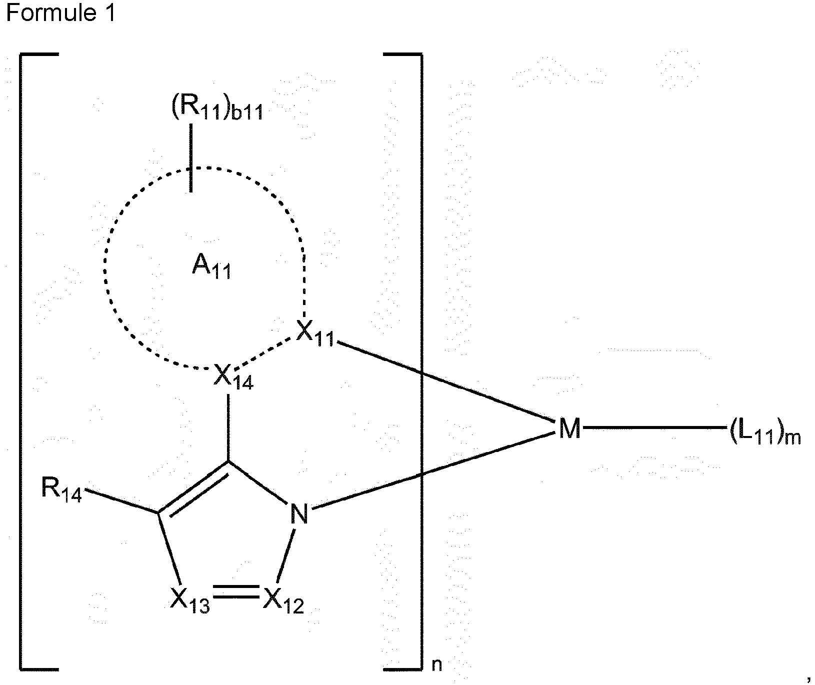 dans la Formule 1,
M étant un métal de transition de première rangée, un métal de transition de deuxième rangée ou un métal de transition de troisième rangée du Tableau périodique des éléments,
X₁₁ étant N ou C, et une liaison entre X₁₁ et M étant une liaison de coordination,
X₁₂ étant N ou C(R₁₂),
X₁₃ étant N ou C(R₁₃), X₁₂ et X₁₃ n'étant pas N en même temps,
X₁₄ étant N ou C, et une liaison entre X₁₁ et X₁₄ étant une simple liaison ou une double liaison,
A₁₁ étant un groupe carbocyclique en C₅-C₆₀ ou un groupe hétérocyclique en C₁-C₆₀,
R₁₁ étant l'hydrogène, le deutérium, -F, -Cl, -Br, -I, -SF₅, un groupe hydroxyle, un groupe cyano, un groupe nitro, un groupe amidino, un groupe hydrazino, un groupe hydrazono, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -B(Q₁)(Q₂), - N(Q₁)(Q₂), -P(Q₁)(Q₂), -C(=O)(Q₁), -S(=O)(Q₁), -S(=O)₂(Q₁), -P(=O)(Q₁)(Q₂) ou - P(=S)(Q₁)(Q₂), deux R₁₁ voisins étant éventuellement reliés l'un à l'autre afin de former un groupe carbocyclique en C₅-C₃₀ substitué ou non substitué ou un groupe hétérocyclique en C₁-C₃₀ substitué ou non substitué,
R₁₂ et R₁₃ étant chacun indépendamment :
-F, -Cl, -Br, -I, un groupe cyano ou un groupe nitro ; ou
un groupe alkyle en C₁-C₆₀ substitué avec au moins un -F, -Cl, -Br, -I, un groupe cyano, un groupe nitro ou une combinaison quelconque de ceux-ci,
R₁₄ étant un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué,
b11 étant 1, 2, 3, 4, 5, 6, 7 ou 8,
Q₁ à Q₃ étant chacun indépendamment l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, un groupe alkyle en C₁-C₆₀ substitué avec au moins un deutérium, -F, un groupe cyano, un groupe alkyle en C₁-C₆₀, un groupe aryle en C₆-C₆₀ ou une combinaison quelconque de ceux-ci, ou un groupe aryle en C₆-C₆₀ substitué avec au moins un deutérium, -F, un groupe cyano, un groupe alkyle en C₁-C₆₀, un groupe aryle en C₆-C₆₀ ou une combinaison quelconque de ceux-ci,
n étant 1, 2 ou 3,
L₁₁ étant un ligand monodentate, un ligand bidentate ou un ligand tridentate, et
m étant 0, 1, 2, 3, 4 ou 5.

2. Composé organométallique selon la revendication 1,
M étant le platine, le palladium, le cuivre, l'argent, l'or, le rhodium, l'iridium, le ruthénium, l'osmium, le titane, le zirconium, le hafnium, l'europium, le terbium ou le thulium ;
de préférence
M étant Ru ou Os.

3. Composé organométallique selon la revendication 1 ou 2,
X₁₂ étant N et X₁₃ étant C(R₁₃) ; ou
X₁₂ étant C(R₁₂) et X₁₃ étant N.

4. Composé organométallique selon l'une quelconque des revendications 1 à 3,
X₁₂ étant N et X₁₃ étant C(R₁₃).

5. Composé organométallique selon l'une quelconque des revendications 1 à 4,
une fraction représentée par 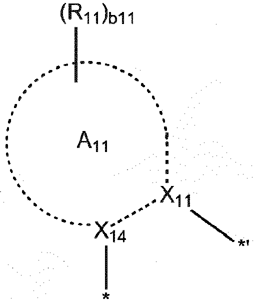 (*' indiquant un site de liaison à M, et * indiquant un site de liaison à un atome de carbone) étant représentée par une des Formules 2-1 à 2-17 : 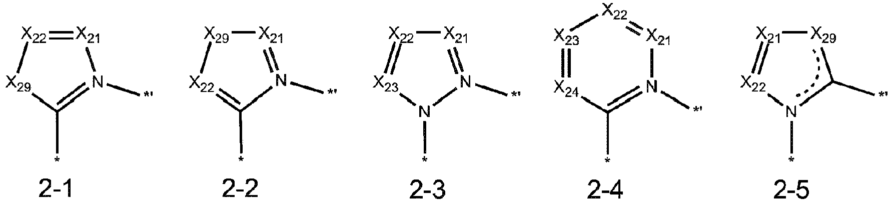 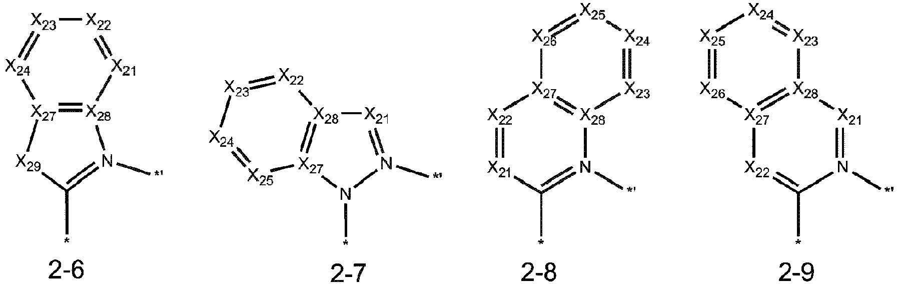 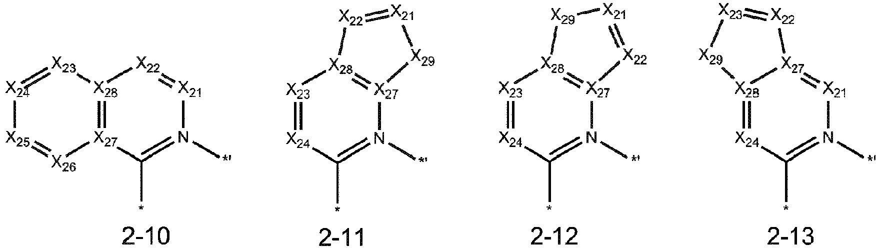 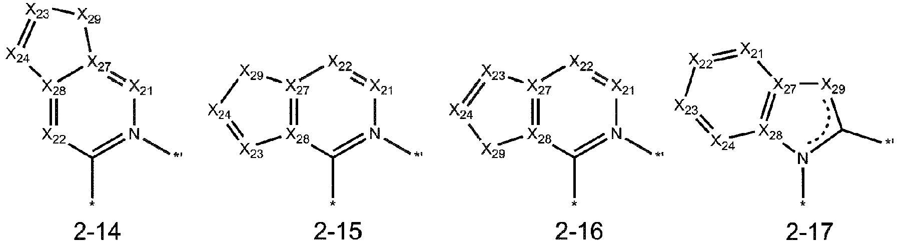 dans les Formules 2-1 à 2-17,
X₂₁ étant N ou C(R₂₁), X₂₂ étant N ou C(R₂₂), X₂₃ étant N ou C(R₂₃), X₂₄ étant N ou C(R₂₄), X₂₅ étant N ou C(R₂₅), et X₂₆ étant N ou C(R₂₆),
X₂₇ et X₂₈ étant chacun indépendamment N ou C,
X29 étant O, S, N(R29), ou C(R₂₉)(R₃₀),
R₂₁ à R₂₆, R₂₉ et R₃₀ étant chacun indépendamment les mêmes que décrits en connexion avec R₁₁ dans la Formule 1 selon la revendication 1,
* indiquant un site de liaison à un atome de carbone, et
*' indiquant un site de liaison à M.

6. Composé organométallique selon l'une quelconque des revendications 1 à 5,
une fraction représentée par 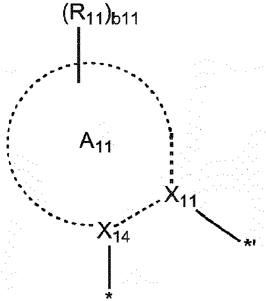 (*' indiquant un site de liaison à M, et * indiquant un site de liaison à un atome de carbone) étant représentée par une des Formules 3-1 à 3-54 : 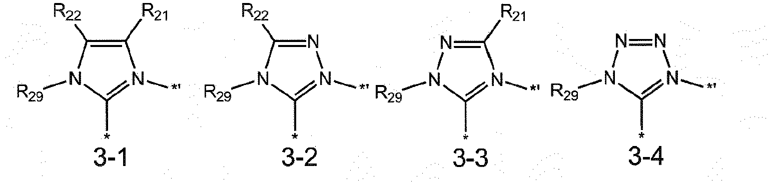 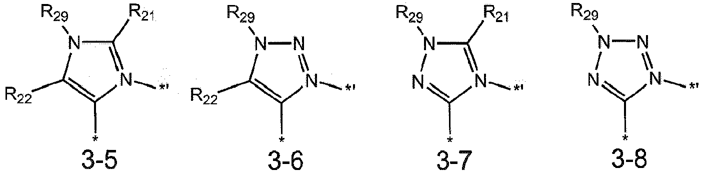 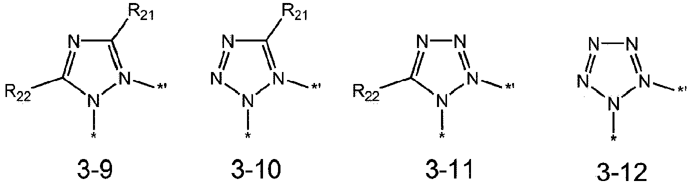 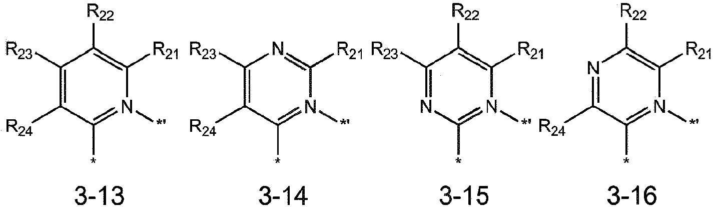 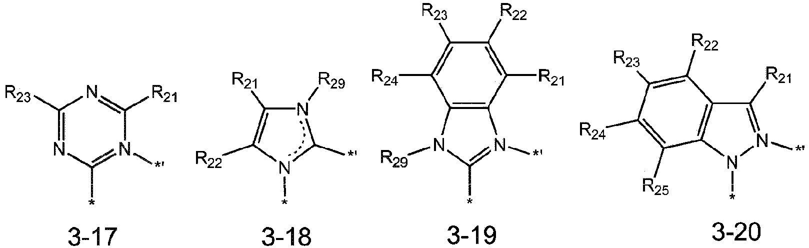 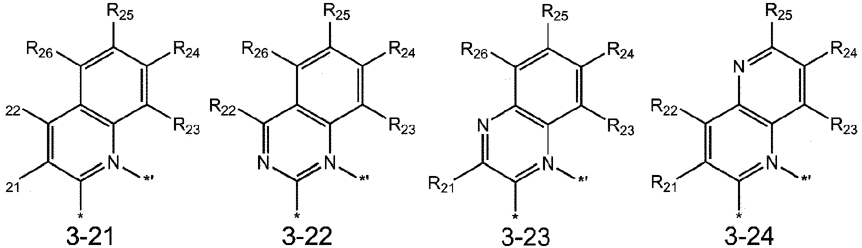 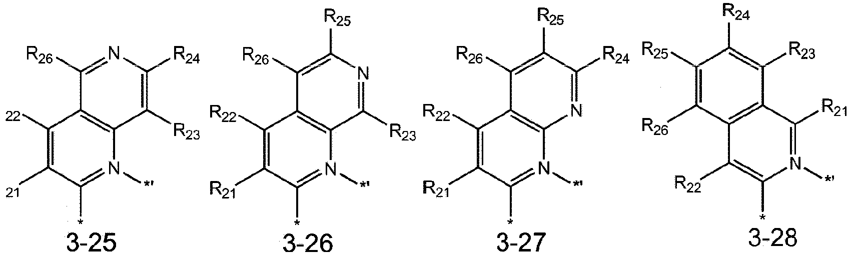 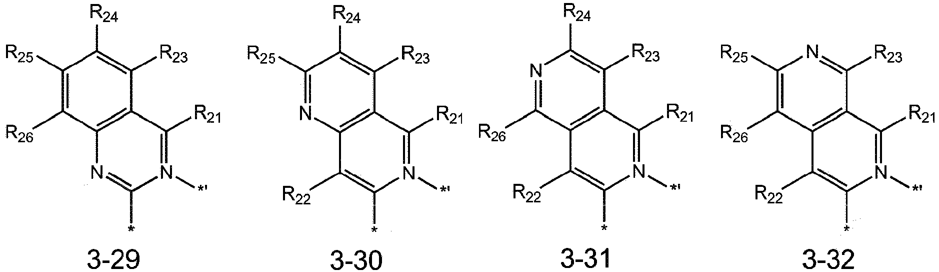 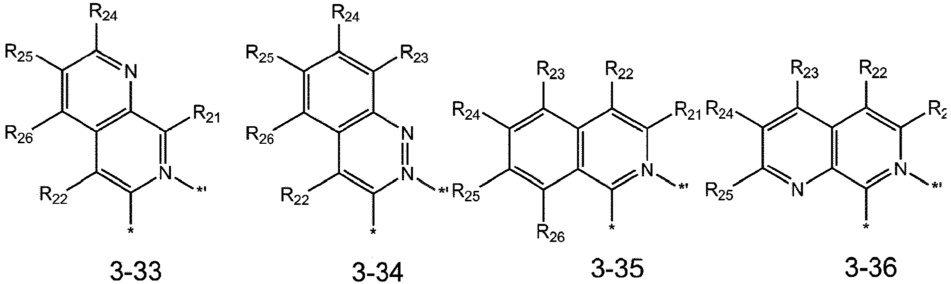 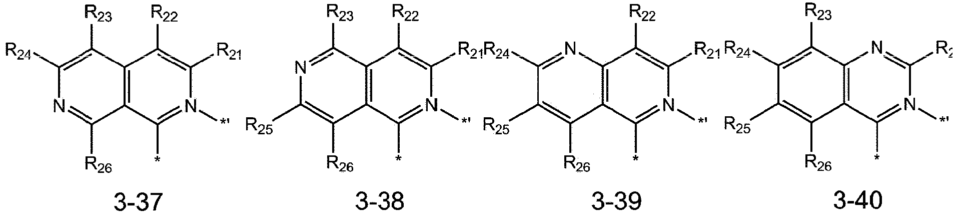 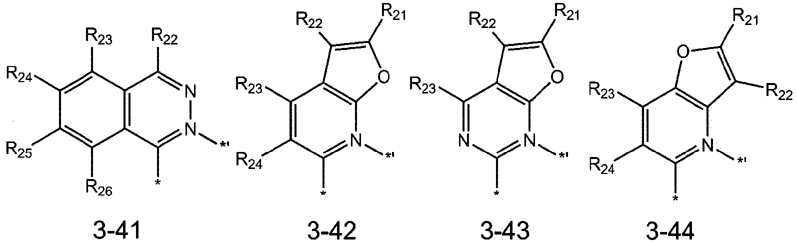 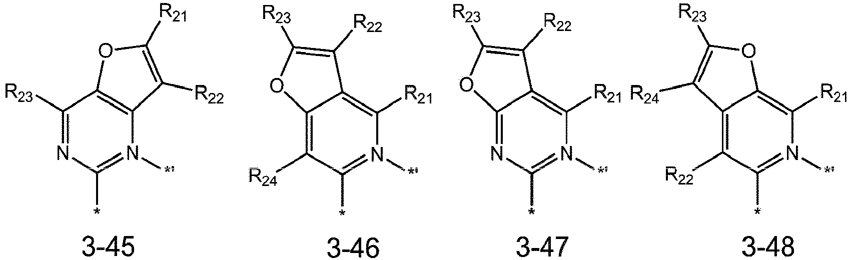 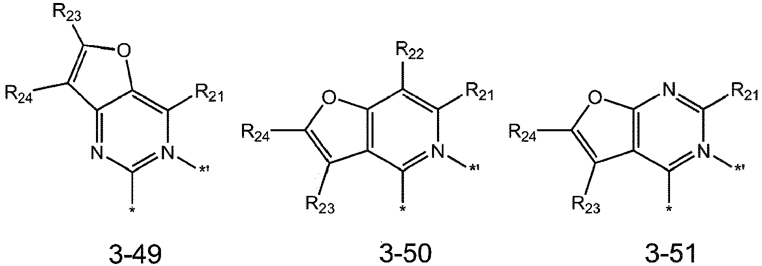 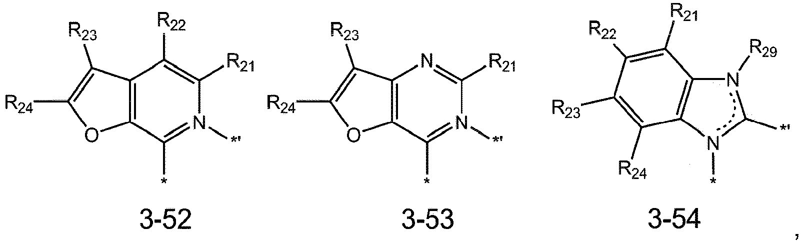 dans les Formules 3-1 à 3-54,
R₂₁ à R₂₆, R₂₉ et R₃₀ étant chacun indépendamment les mêmes que décrits en connexion avec R₁₁ dans la Formule 1 dans la revendication 1,
* indiquant un site de liaison à un atome de carbone, et
*' indiquant un site de liaison à M.

7. Composé organométallique selon l'une quelconque des revendications 1 à 6,
R₁₁ étant :
l'hydrogène, le deutérium, -F, -Cl, -Br, -I, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci,-SF₅, un groupe alkyle en C₁-C₂₀ ou un groupe alcoxy en C₁-C₂₀ ;
un groupe alkyle en C₁-C₂₀ ou un groupe alcoxy en C₁-C₂₀, chacun substitué avec au moins un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₁₀, un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe phényle, un groupe naphtyle, un groupe pyridinyle, un groupe pyrimidinyle ou une combinaison quelconque de ceux-ci ;
un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle ou un groupe imidazopyrimidinyle ;
un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle ou un groupe imidazopyrimidinyle, chacun substitué avec au moins un deutérium, -F, - Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, -Si(Q₃₃)(Q₃₄)(Q₃₅), ou une combinaison quelconque de ceux-ci ; ou
-N(Q₁)(Q₂), -Si(Q₃)(Q₄)(Q₅), -B(Q₆)(Q₇) ou -P(=O)(Q₈)(Q₉), et
Q₁ à Q₉ et Q₃₃ à Q₃₅ étant chacun indépendamment :
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H ou -CD₂CDH₂;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle, chacun substitué avec au moins un deutérium, un groupe alkyle en C₁-C₁₀, un groupe phényle ou une combinaison quelconque de ceux-ci.

8. Composé organométallique selon l'une quelconque des revendications 1 à 7,
R₁₂ et R₁₃ étant chacun indépendamment :
-F, -Cl ou un groupe cyano ; ou
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle ou un groupe tert-décyle, chacun substitué avec au moins un -F, -Cl, un groupe cyano ou une combinaison quelconque de ceux-ci.

9. Composé organométallique selon l'une quelconque des revendications 1 à 8,
R₁₂ et R₁₃ étant chacun indépendamment :
-F ou un groupe cyano ; ou
un groupe méthyle, un groupe éthyle, un groupe n-propyle, un groupe isopropyle, un groupe n-butyle, un groupe isobutyle, un groupe sec-butyle ou un groupe tert-butyle, chacun substitué avec au moins un -F, un groupe cyano ou une combinaison quelconque de ceux-ci,
de préférence
R₁₂ et R₁₃ étant chacun indépendamment -F, un groupe cyano, -CF₃ ou une combinaison quelconque de ceux-ci.

10. Composé organométallique selon l'une quelconque des revendications 1 à 9,
R₁₄ étant :
un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe oxazolyle, un groupe pyridinyle, un groupe pyrazinyle, un groupe pyrimidinyle, un groupe indolyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe benzoxazolyle, un groupe triazolyle, un groupe tétrazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle ou un groupe imidazopyrimidinyle ; ou
un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe oxazolyle, un groupe pyridinyle, un groupe pyrazinyle, un groupe pyrimidinyle, un groupe indolyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe benzoxazolyle, un groupe triazolyle, un groupe tétrazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle ou un groupe imidazopyrimidinyle, chacun substitué avec au moins un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe cyclopentyle, un groupe cyclopentyle substitué avec du deutérium, un groupe cyclohexyle, un groupe cyclohexyle substitué avec du deutérium, un groupe cycloheptyle, un groupe cycloheptyle substitué avec du deutérium, un groupe cyclooctyle, un groupe cyclooctyle substitué avec du deutérium, un groupe bicyclo[2.2.1]heptanyle, un groupe adamantyle, un groupe norbornyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, -Si(Q₃₃)(Q₃₄)(Q₃₅), ou une combinaison quelconque de ceux-ci, et
Q₃₃ à Q₃₅ étant chacun indépendamment :
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H ou -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle, chacun substitué avec au moins un deutérium, un groupe alkyle en C₁-C₁₀, un groupe phényle ou une combinaison quelconque de ceux-ci ; ou
R₁₄ étant :
un groupe phényle, un groupe naphtyle, un groupe fluorényle, un groupe phénanthrényle, un groupe anthracényle, un groupe benzofuranyle, un groupe benzothiophényle, un groupe benzoxazolyle, un groupe dibenzofuranyle, un groupe dibenzothiophényle ou un groupe dibenzosilolyle ; et
un groupe phényle, un groupe naphtyle, un groupe fluorényle, un groupe phénanthrényle, un groupe anthracényle, un groupe benzofuranyle, un groupe benzothiophényle, un groupe benzoxazolyle, un groupe dibenzofuranyle, un groupe dibenzothiophényle ou un groupe dibenzosilolyle, chacun substitué avec au moins un deutérium, -F, -Cl, -Br, -I, -CD₃, -CD₂H, -CDH₂, -CF₃, -CF₂H, -CFH₂, un groupe méthyle, un groupe éthyle, un groupe n-propyle, un groupe isopropyle, un groupe n-butyle, un groupe isobutyle, un groupe sec-butyle, un groupe tert-butyle, un groupe méthoxy, un groupe éthoxy, un groupe propoxy, un groupe butoxy, un groupe cyclopentyle, un groupe cyclohexyle, un groupe phényle, un groupe naphtyle, -Si(Q₃₃)(Q₃₄)(Q₃₅) ou une combinaison quelconque de ceux-ci, et
Q₃₃ à Q₃₅ étant chacun indépendamment :
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H ou -CD₂CDH₂ ;
un groupe n-propyle, un groupe isopropyle, un groupe n-butyle, un groupe isobutyle, un groupe sec-butyle ou un groupe tert-butyle ; ou
un groupe n-propyle, un groupe isopropyle, un groupe n-butyle, un groupe isobutyle, un groupe sec-butyle ou un groupe tert-butyle, chacun substitué avec du deutérium ; ou
R₁₄ étant les Formules 10-17 à 10-100, 10-175 à 10-222, 10-247 et 10-248 : 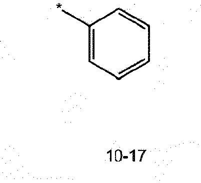 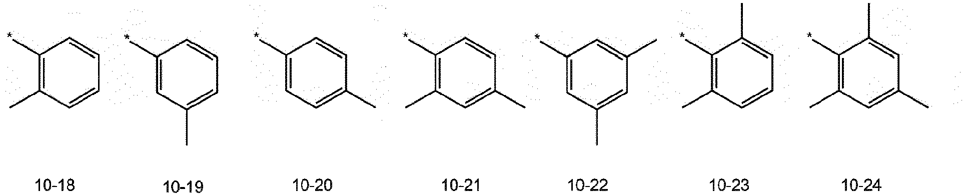 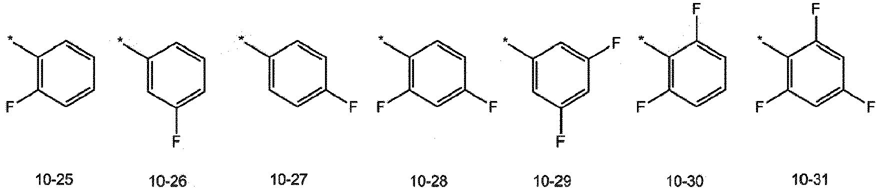 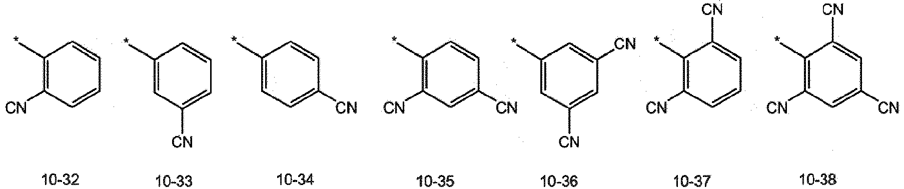 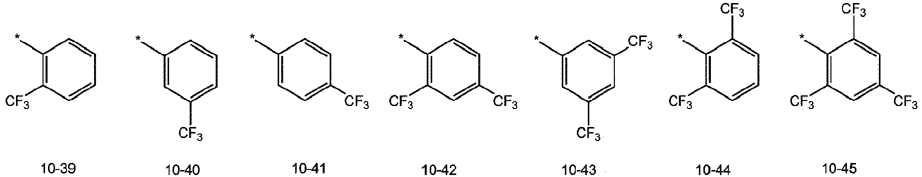 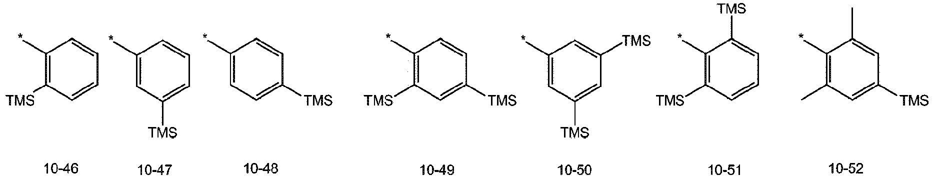 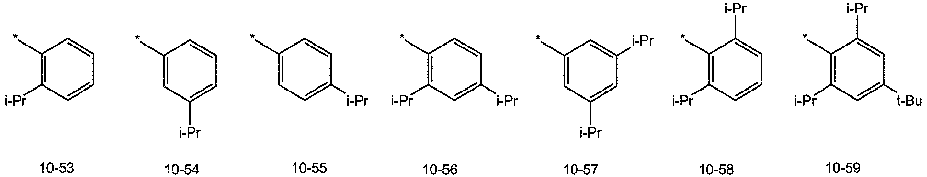 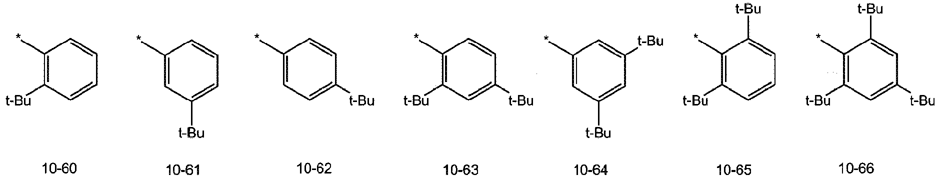 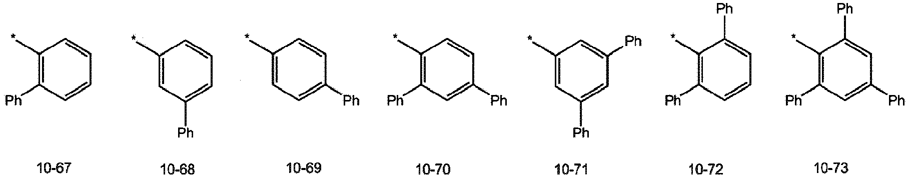 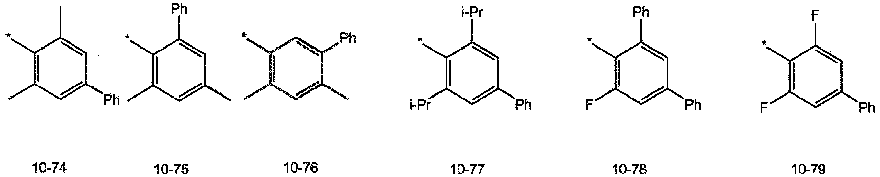 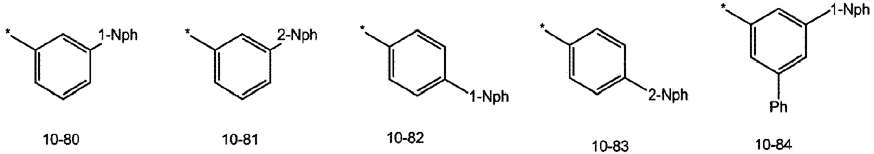 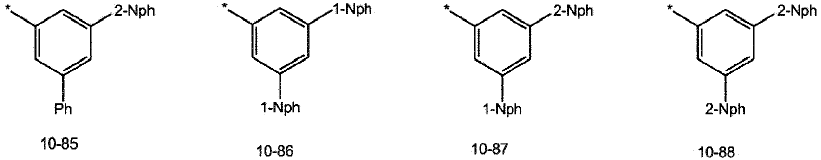 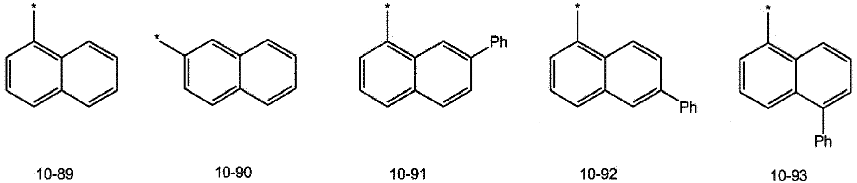 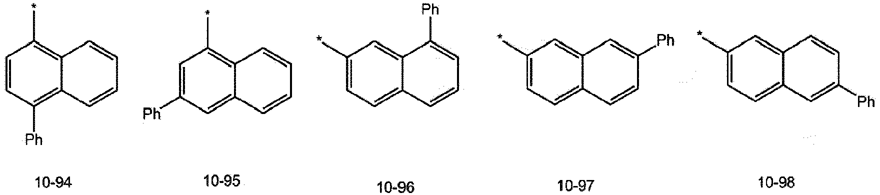 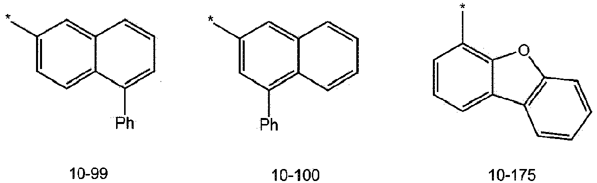 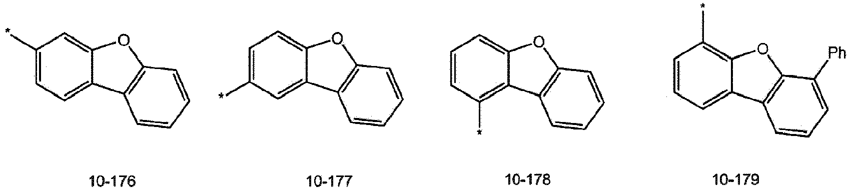 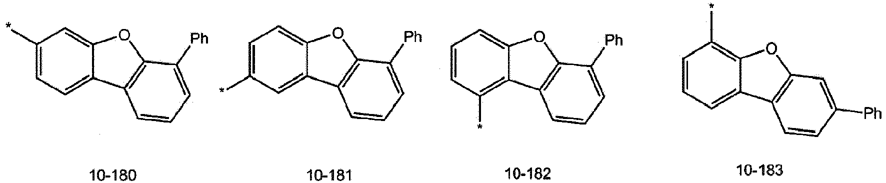 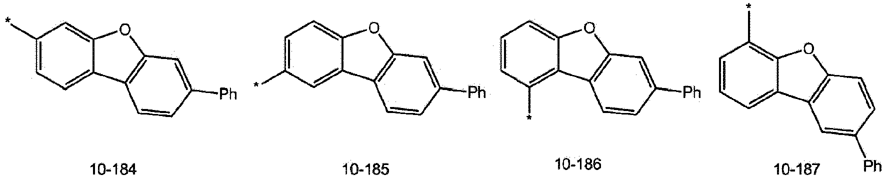 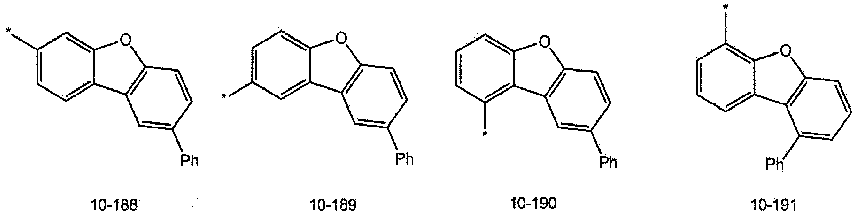 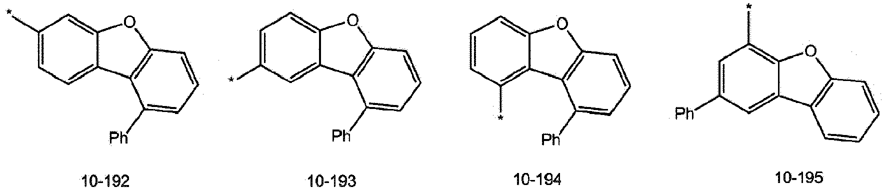 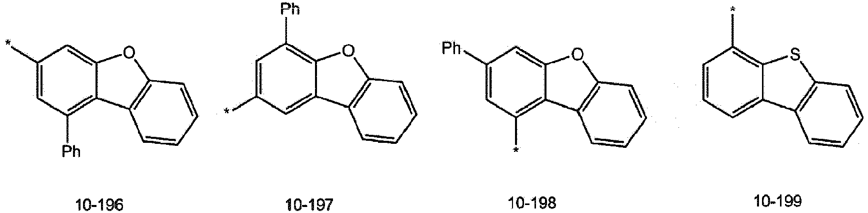 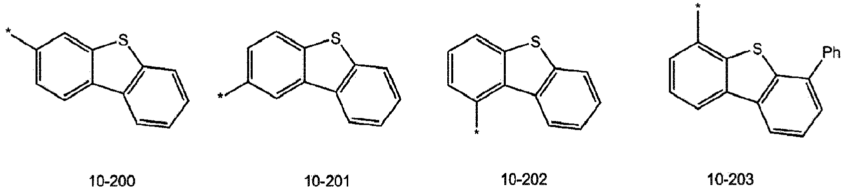 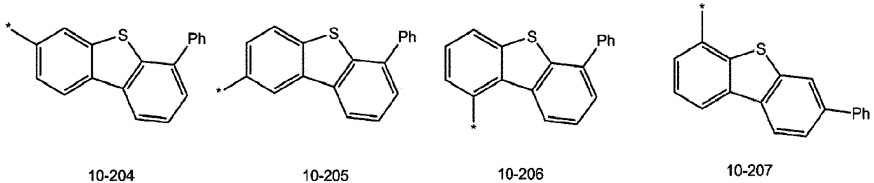 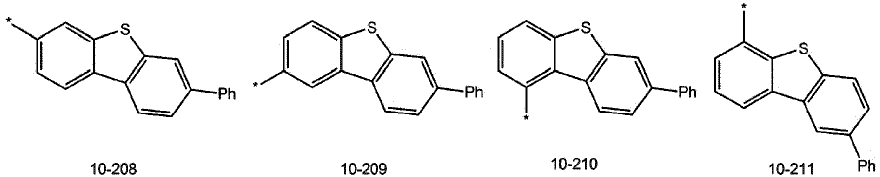 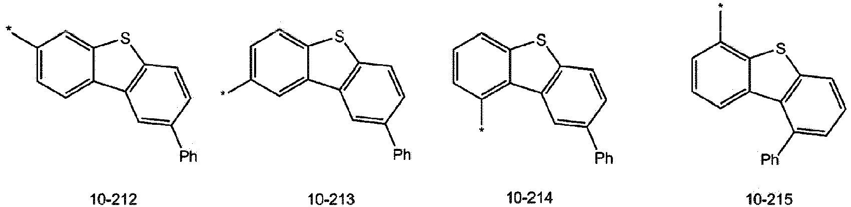 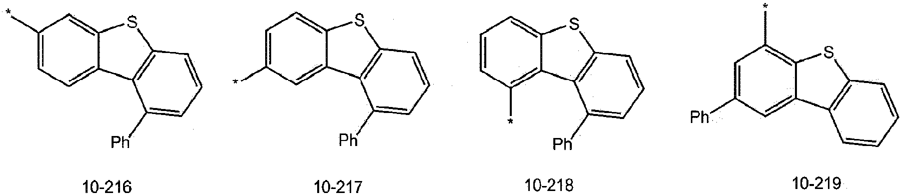 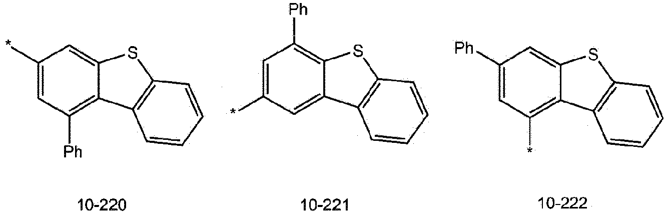 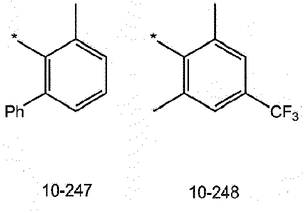 dans les Formules 10-17 à 10-100, 10-175 à 10-222, 10-247 et 10-248,
* indiquant un site de liaison à un atome voisin,
i-Pr indiquant un groupe isopropyle, t-Bu indiquant un groupe t-butyle,
Ph indiquant un groupe phényle,
1-Nph indiquant un groupe 1-naphtyle, 2-Nph indiquant un groupe 2-napthyle, et
TMS indiquant un groupe triméthylsilyle.

11. Composé organométallique selon l'une quelconque des revendications 1 à 10,
le composé organométallique étant représenté par la Formule 1-1 : 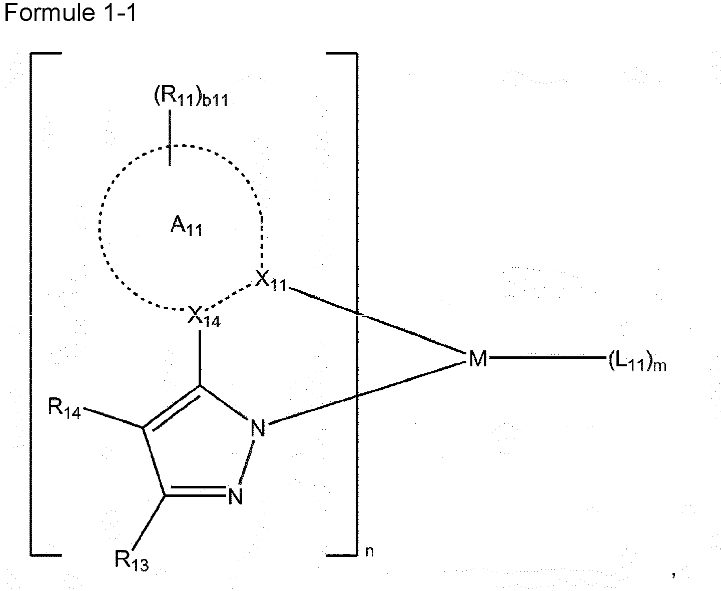 dans la Formule 1-1,
M, A₁₁, X₁₁, X₁₄, R₁₁, R₁₃, R₁₄, b11, L₁₁, n et m étant chacun indépendamment les mêmes que décrits en connexion avec la Formule 1 dans la revendication 1.

12. Composé organométallique selon l'une quelconque des revendications 1 à 11,
le composé organométallique étant représenté par une des Formules 1-11 à 1-24 : 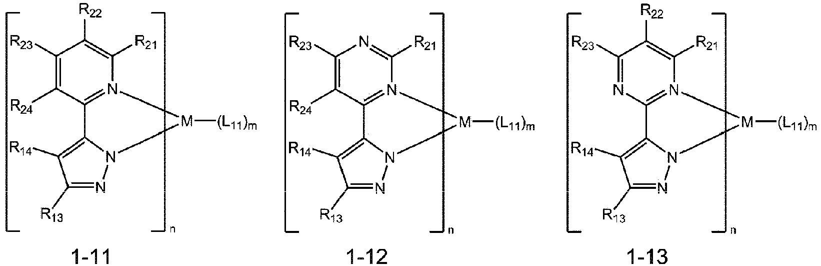 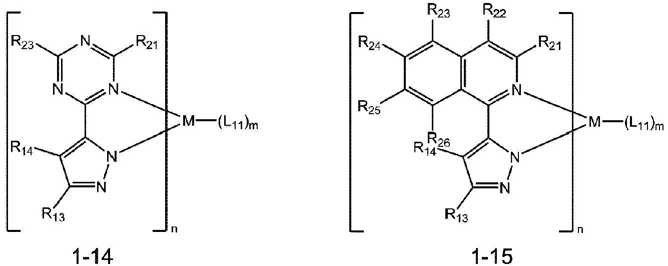 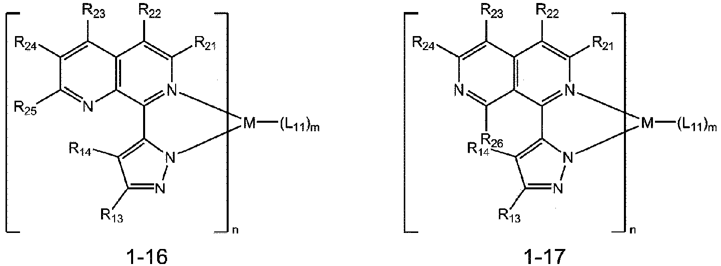 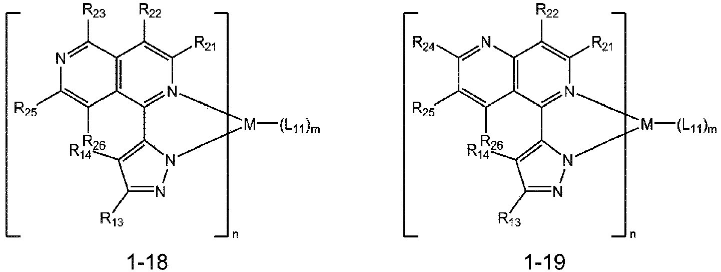 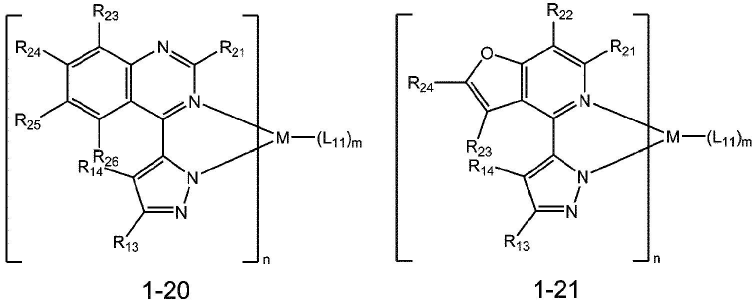 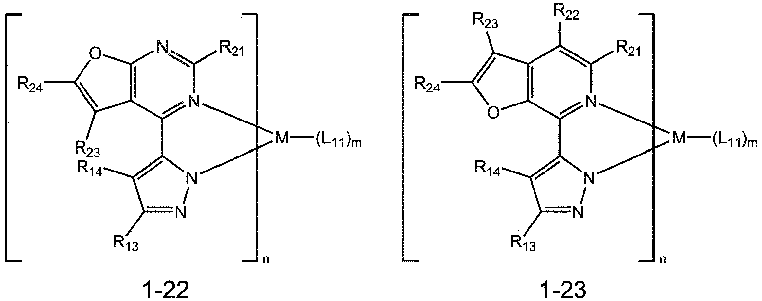 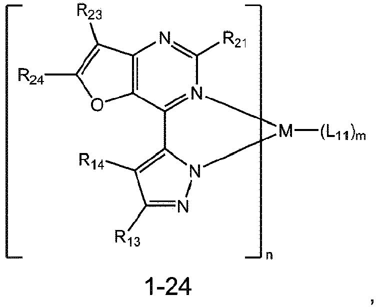 dans les Formules 1-11 à 1-24,
M, A₁₁, X₁₁, X₁₄, R₁₁, R₁₃, R₁₄, b11, L₁₁, n et m étant chacun indépendamment les mêmes que décrits en connexion avec la Formule 1 dans la revendication 1.

13. Composé organométallique selon la revendication 1,
le composé organométallique étant parmi les Composés 1 à 11 : 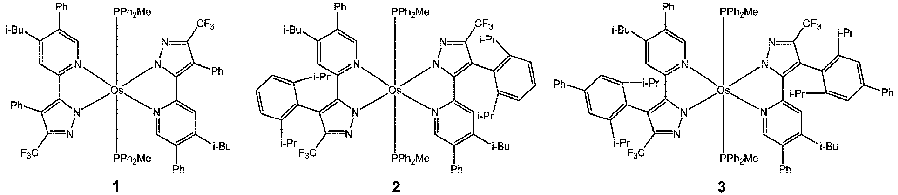 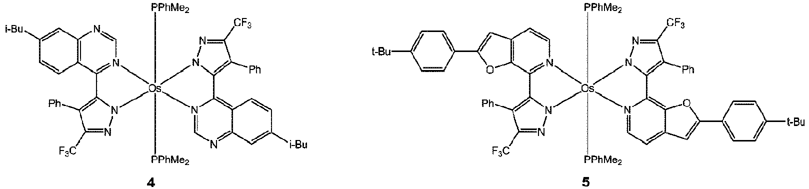 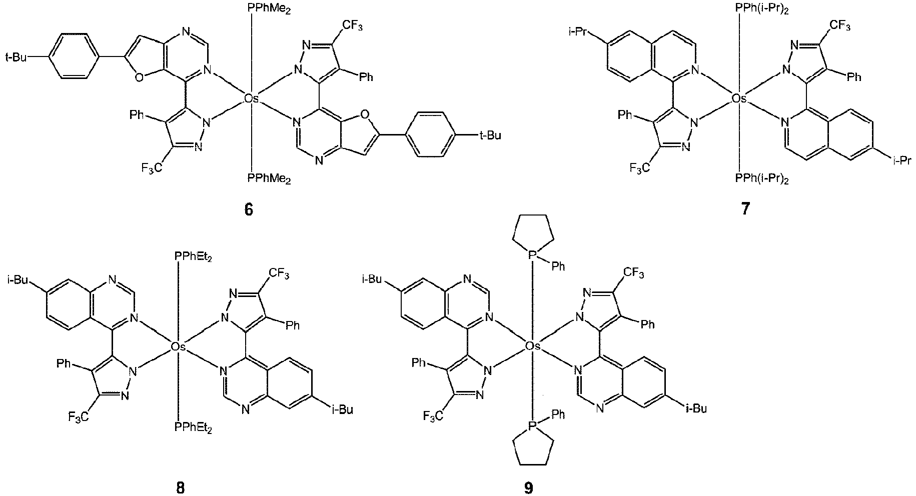 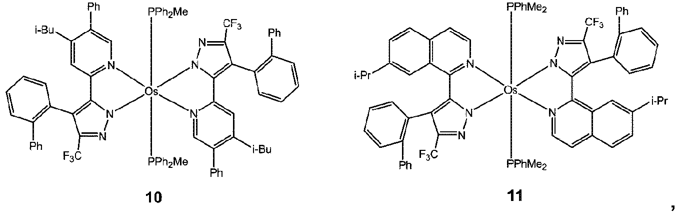 dans les Composés 1 à 11,
Ph indiquant un groupe phényle, i-Pr indiquant un groupe isopropyle, i-Bu indiquant un groupe isobutyle, et t-Bu indiquant un groupe tert-butyle.

14. Dispositif électroluminescent organique comprenant :
une première électrode ;
une deuxième électrode ; et
une couche organique entre la première électrode et la deuxième électrode et comprenant une couche d'émission,
la couche organique comprenant au moins un composé organométallique selon l'une quelconque des revendications 1 à 13.

15. Dispositif électroluminescent organique selon la revendication 14,
le composé organométallique étant compris dans la couche d'émission ;
de préférence
la couche d'émission comprenant en outre un hôte, et une quantité de l'hôte dans la couche d'émission étant supérieure à une quantité du composé organométallique dans la couche d'émission.
